(19) **Europäisches Patentamt**
**European Patent Office**
**Office européen des brevets**

(11) **EP 4 730 969 A1**

(12) **EUROPEAN PATENT APPLICATION**
published in accordance with Art. 153(4) EPC

(43) Date of publication:
**22.04.2026 Bulletin 2026/17**

(51) International Patent Classification (IPC):
*H10K 59/12* (2023.01)    *H10K 59/121* (2023.01)
*H10K 59/131* (2023.01)    *H10K 59/123* (2023.01)

(21) Application number: **24822509.6**

(22) Date of filing: **23.05.2024**

(86) International application number:
**PCT/CN2024/094893**

(87) International publication number:
**WO 2024/255557 (19.12.2024 Gazette 2024/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.06.2023   CN 202310699370**

(71) Applicants:
• **BOE Technology Group Co., Ltd.
Beijing 100015 (CN)**

• **Beijing BOE Technology Development Co., Ltd.
Beijing 100176 (CN)**

(72) Inventors:
• **LONG, Chunping
Beijing 100176 (CN)**
• **XU, Jian
Beijing 100176 (CN)**

(74) Representative: **Brötz, Helmut et al
Rieder & Partner mbB
Patentanwälte - Rechtsanwalt
Yale-Allee 26
42329 Wuppertal (DE)**

(54) **DISPLAY PANEL AND DISPLAY APPARATUS**

(57)    Provided in at least one embodiment of the present invention are a display panel and a display apparatus. The display panel comprises a base substrate; and a pixel circuit, which is provided on the base substrate, the pixel circuit comprising an induction transistor, a drive transistor, a first gate line and a second gate line, wherein a first source-drain electrode of the induction transistor is electrically connected to a first source-drain electrode of the drive transistor by means of a first connecting electrode; the first gate line and the second gate line extend in a first direction; spacing portions are provided between the first connecting electrode and the first gate line and between the first connecting electrode and the second gate line in a second direction that intersects with the first direction; the first connecting electrode, the first gate line, the second gate line and the spacing portions are provided on the same layer; and spacing portions, which are located on a third metal layer, are respectively provided between the induction transistor and the first gate line and the second gate line which are located on the two sides of the induction transistor in the second direction, and the spacing portions can shield the coupling between the first source-drain electrode of the induction transistor and the first gate line or the second gate line.

Fig. 14

**Description**

The application claims priority to the Chinese patent application No. 202310699370.8, filed on June 14, 2023, the entire disclosure of which is incorporated herein by reference as part of the present application.

TECHNICAL FIELD

Embodiments of the present disclosure relate to a display panel and a display device.

BACKGROUND

At present, display devices widely used in the display field include thin film transistor liquid crystal display devices (TFT-LCD) and active matrix organic light-emitting diode (AMOLED) display devices. Active matrix organic light-emitting diode (AMOLED) display device has the advantages of long life, high display brightness, large contrast and wide color gamut.

Organic light-emitting diode display devices with active matrix organic light-emitting diodes as light-emitting elements are thinner and lighter than conventional liquid crystal display devices. Organic light-emitting diode display devices also have the characteristics of fast response speed, wide viewing angle and low voltage driving. Therefore, the organic light-emitting diode display devices can be widely used in cellular phones, portable information terminals, televisions and monitors. The structure of the organic light-emitting diode display device mainly includes a cathode and an anode, and a light-emitting functional layer sandwiched between the cathode and the anode. In the active matrix organic light-emitting diode display device, each sub-pixel has a switching transistor and a driving transistor, and the light-emitting layer in the organic light-emitting diode display device emits light by adjusting the switching transistor and the driving transistor.

SUMMARY

Embodiments of the present disclosure relate to a display panel and a display device, the display panel includes: a pixel circuit arranged on the base substrate, and the pixel circuit includes a sensing transistor, a driving transistor, a first gate line and a second gate line, and a first source-drain electrode of the sensing transistor and a first source-drain electrode of the driving transistor are electrically connected through a first connection electrode; the first gate line and the second gate line extend in a first direction; in a second direction intersecting with the first direction, spacers are arranged between the first connection electrode and the first gate line and between the first connection electrode and the second gate line, and the first connection electrode, the first gate line, the second gate line and the spacers are arranged in a same layer. According to the embodiments of the present disclosure, the spacers are arranged between the first connection electrode and the first gate line, and between the first connection electrode and the second gate line, and the first connection electrode, the first gate line, the second gate line and the spacers are arranged in the same layer, so that the voltage change brought to the first connection electrode when the first gate line or the second gate line generates voltage jump can be reduced, thereby reducing the damage to the light-emitting diode and ensuring the service life of the light-emitting diode.

At least one embodiment of the present disclosure provides a display panel, and the display panel includes: a base substrate; a pixel circuit, arranged on the base substrate, in which the pixel circuit comprises a sensing transistor, a driving transistor, a first gate line and a second gate line, a first source-drain electrode of the sensing transistor and a first source-drain electrode of the driving transistor are electrically connected through a first connection electrode; the first gate line and the second gate line extend in a first direction, in a second direction intersecting with the first direction, spacers are arranged between the first connection electrode and the first gate line and between the first connection electrode and the second gate line, and the first connection electrode, the first gate line, the second gate line and the spacers are arranged in a same layer.

For example, the display panel provided by at least one embodiment of the present disclosure, further comprising a switching transistor and a storage capacitor that are arranged on the base substrate, in which a first source-drain electrode of the switching transistor and a gate electrode of the driving transistor are connected through a second connection electrode, a first electrode plate of the storage capacitor is connected with the second connection electrode, and a second electrode plate of the storage capacitor is connected with the first connection electrode.

For example, the display panel provided by at least one embodiment of the present disclosure, further comprising a first metal layer, an active layer, a second metal layer and a third metal layer that are sequentially stacked on the base substrate, in which the first metal layer comprises an initialization signal line extending in the second direction, a power supply voltage signal line at least partially extending in the second direction, the first electrode plate and a data line; the active layer comprises a channel region of the sensing transistor, a channel region of the driving transistor and a channel region of the switching transistor; the second metal layer comprises a gate electrode of the sensing transistor, the gate electrode of the driving transistor, a gate electrode of the switching transistor and the second electrode plate; the third metal layer comprises the first connection electrode, the spacers, the second gate line and the first gate line that extend in the first direction.

For example, in the display panel provided by at least one embodiment of the present disclosure, the gate electrode of the sensing transistor extends in the second direction to be electrically connected with the first gate line, the gate electrode of the switching transistor extends in a direction opposite to the second direction to be electrically connected with the second gate line, and the first gate line connected with the gate electrode of the sensing transistor and the second gate line connected with the gate electrode of the switching transistor are on different sides of any one of the spacers in the second direction.

For example, in the display panel provided by at least one embodiment of the present disclosure, the third metal layer further comprises a first connection structure, a second connection structure and a third connection structure that extend in the second direction, an orthographic projection of the first connection structure on the base substrate is within an orthographic projection of the initialization signal line on the base substrate, an orthographic projection of the second connection structure on the base substrate is within an orthographic projection of the first electrode plate on the base substrate, and an orthographic projection of the third connection structure on the base substrate is within an orthographic projection of the data line on the base substrate.

For example, the display panel provided by at least one embodiment of the present disclosure, further comprising a buffer layer arranged on a side of the first metal layer away from the base substrate, a gate insulation layer arranged between the active layer and the second metal layer, an interlayer insulation layer arranged between the second metal layer and the third metal layer, and a passivation layer and a planarization layer that are arranged on a side of the third metal layer away from the base substrate.

For example, in the display panel provided by at least one embodiment of the present disclosure, a first via hole structure and a third via hole structure are arranged in the interlayer insulation layer, the third metal layer is electrically connected with the active layer through the first via hole structure, and the third metal layer is electrically connected with the second metal layer through the third via hole structure; a second via hole structure penetrates through the interlayer insulation layer and the buffer layer, and the third metal layer is electrically connected with the first metal layer through the second via hole structure.

For example, in the display panel provided by at least one embodiment of the present disclosure, the first connection structure is electrically connected with the initialization signal line through the second via hole structure, and is electrically connected with a second source-drain electrode of the sensing transistor through the first via hole structure; the second connection structure is electrically connected with the first source-drain electrode of the switching transistor through the first via hole structure, and is electrically connected with the second electrode plate through the third via hole structure; the third connection structure is electrically connected with the data line through the second via hole structure, and is electrically connected with a second source-drain electrode of the switching transistor through the first via hole structure.

For example, in the display panel provided by at least one embodiment of the present disclosure, at least a part of the third metal layer overlaps with both the first metal layer and the second metal layer to form the storage capacitor between the first metal layer and the second metal layer, and form a capacitor structure between the second metal layer and the third metal layer.

For example, in the display panel provided by at least one embodiment of the present disclosure, an orthographic projection of the first source-drain electrode of the sensing transistor on the base substrate overlaps with an orthographic projection of the power supply voltage signal line on the base substrate.

For example, in the display panel provided by at least one embodiment of the present disclosure, the power supply voltage signal line comprises a first power supply voltage signal line extending in the second direction, the first power supply voltage signal line comprises a first part, a second part and a third part that extend in the second direction and are connected in sequence, and a width of the first part in the first direction and a width of the third part in the first direction are equal, a width of the second part in the first direction is smaller than a width of the first part in the first direction, and one end of the second part in the second direction is connected with an edge of the first part close to the third part and away from the initialization signal line, and other one end of the second part in the second direction is connected with an edge of the third part close to the first part and away from the initialization signal line.

For example, in the display panel provided by at least one embodiment of the present disclosure, an orthographic projection of the first source-drain electrode of the sensing transistor on the base substrate is spaced apart from an orthographic projection of the second part of the power voltage signal line on the base substrate.

For example, in the display panel provided by at least one embodiment of the present disclosure, the first electrode plate comprises a first electrode plate sub-block and a second electrode plate sub-block that are connected with each other in the first direction, and the second metal layer comprises a first extension part and a second extension part that extend from a part of the second electrode plate corresponding to the second electrode plate sub-block in the second direction, and two of the second connection electrodes are connected with the first extension part and the second extension part respectively.

For example, the display panel provided by at least one embodiment of the present disclosure, further comprising an organic light-emitting diode, wherein $\frac{W_g \times l_c \times THK_{ILD}}{A_{st} \times d_{gc}} \geq 0.013$, $A_{st}$ is an area of the storage capacitor, $d_{gc}$ is a minimum spacing between the first gate line and the storage capacitor, $L_c$ is a length of an edge of the first electrode sub-block adjacent to the first gate line, $W_g$ is a width of the first gate line in the second direction, and $THK_{ILD}$ is a thickness of the interlayer insulation layer corresponding to the storage capacitor.

For example, in the display panel provided by at least one embodiment of the present disclosure, $\frac{W_g \times l_c \times THK_{ILD} \times (V_{gON} - V_{gOFF})}{A_{st} \times d_{gc}} \times \frac{10^{\gamma}}{V_{oled}} \geq 3.14$, $V_{gON}$ is a turn-on voltage of the second gate line, $V_{gOFF}$ is a turn-off voltage of the second gate line, $V_{oled}$ is a voltage across two ends of the organic light-emitting diode, and $\gamma$ is an optical constant.

For example, in the display panel provided by at least one embodiment of the present disclosure, the storage capacitor is a three-layer structure formed by the first metal layer, the second metal layer and the third metal layer, $\frac{W_g \times l_c}{A_{st} \times d_{gc} \times \left(\frac{1}{THK_{ILD}} + \frac{1}{THK_{BUF}}\right)} \geq 0.006$, $THK_{BUF}$ is a thickness of the buffer layer between the first metal layer and the second metal layer in the storage capacitor.

For example, in the display panel provided by at least one embodiment of the present disclosure, $\frac{W_g \times l_c \times (V_{gON} - V_{gOFF})}{A_{st} \times d_{gc} \times \left(\frac{1}{THK_{ILD}} + \frac{1}{THK_{BUF}}\right)} \times \frac{10^{\gamma}}{V_{oled}} \geq 1.5$.

For example, in the display panel provided by at least one embodiment of the present disclosure, $\frac{d_{gd} + W_{DD} + d_{sd}}{d_{gd}} \leq 8.25$, $W_{DD}$ is a length in the second direction of the spacer between the first gate line and the first connection electrode, $d_{gd}$ is a minimum distance between the first gate line and the spacer between the first gate line and the first connection electrode, and $d_{sd}$ is a minimum distance between the first connection electrode and the spacer which is between the first gate line and the first connection electrode.

For example, in the display panel provided by at least one embodiment of the present disclosure, $R_l = \frac{L_c}{L_p} \leq 0.5$, $L_c$ is a length of an edge of the first electrode plate sub-block adjacent to the first gate line, $L_p$ is a sum of a length of the first electrode plate sub-block in the first direction and a length of the second electrode plate sub-block in the first direction, and $R_l$ is a ratio of the length of the edge of the first electrode plate sub-block adjacent to the first gate line to the sum of the length of the first electrode plate sub-block in the first direction and the length of the second electrode plate sub-block in the first direction.

For example, in the display panel provided by at least one embodiment of the present disclosure, $\frac{W_c \times d_{gc}}{Pitch \times Pitch} \leq 0.005$, $Wc$ is a width of the storage capacitor in the first direction, and $Pitch$ is a width of one sub-pixel in the first direction.

For example, the display panel provided by at least one embodiment of the present disclosure, further comprising a first metal layer, an active layer and a second metal layer that are sequentially stacked on the base substrate, in which the first metal layer comprises an initialization signal line extending in the second direction, a power supply voltage signal line at least partially extending in the second direction, the first electrode plate and a data line; the active layer comprises a channel region of the sensing transistor, a channel region of the driving transistor and a channel region of the switching transistor; the second metal layer comprises a gate electrode of the sensing transistor, the gate electrode of the driving transistor, a gate electrode of the switching transistor, the second electrode plate, the first connection electrode, the spacers, the second gate line and the first gate line that extend in the first direction.

For example, in the display panel provided by at least one embodiment of the present disclosure, the gate electrode of the switching transistor is electrically connected with the second gate line, the gate electrode of the sensing transistor is electrically connected with the first gate line, and the second gate line connected with the gate electrode of the switching transistor and the first gate line connected with the gate electrode of the sensing transistor are located at different sides of the first electrode plate in the second direction, and in the second direction, the second connection electrode is between the first connection electrode and the second gate line connected to the gate electrode of the switching transistor.

For example, the display panel provided by at least one embodiment of the present disclosure, further comprising a switching transistor disposed on the base substrate, in which a first source-drain electrode of the switching transistor and a gate electrode of the driving transistor are connected through a second connection electrode.

For example, the display panel provided by at least one embodiment of the present disclosure, further comprising a first metal layer, an active layer, a second metal layer and a third metal layer that are sequentially stacked on the base substrate, in which the first metal layer comprises an initialization signal line, a power supply voltage signal line and a data line that extend in the second direction, and a light shielding part; the active layer comprises a channel region of the sensing transistor, a channel region of the driving transistor and a channel region of the switching transistor; the second metal layer comprises a gate electrode of the sensing transistor, a gate electrode of the driving transistor and a gate electrode of the switching transistor; the third metal layer comprises the first connection electrode, the spacers, the second gate line and the first gate line that extend in the first direction.

For example, in the display panel provided by at least one embodiment of the present disclosure, the third metal layer further comprises a first connection structure and a second connection structure that extend in the second direction, an orthographic projection of the first connection structure on the base substrate is within an orthographic projection of the initialization signal line on the base substrate, and an orthographic projection of the second connection structure on the base substrate is within an orthographic projection of the data line on the base substrate.

For example, the display panel provided by at least one embodiment of the present disclosure, further comprising a buffer layer arranged on a side of the first metal layer away from the base substrate, a gate insulation layer arranged between the active layer and the second metal layer, an interlayer insulation layer arranged between the second metal layer and the third metal layer, and a passivation layer and a planarization layer that are arranged on a side of the third metal layer away from the base substrate.

For example, in the display panel provided by at least one embodiment of the present disclosure, a first via hole structure is provided in the interlayer insulation layer, and the third metal layer is electrically connected with the active layer through the first via hole structure; a second via hole structure penetrates through the interlayer insulation layer and the buffer layer, and the third metal layer is electrically connected with the power supply voltage signal line through the second via hole structure.

For example, in the display panel provided by at least one embodiment of the present disclosure, a storage capacitor is formed between the third metal layer and the second metal layer.

For example, the display panel provided by at least one embodiment of the present disclosure, further comprising a switching transistor and a storage capacitor arranged on the base substrate, in which a first source-drain electrode of the switching transistor and a first electrode plate of the storage capacitor are connected through a second connection electrode.

For example, the display panel provided by at least one embodiment of the present disclosure, further comprising a first metal layer, an active layer and a second metal layer that are sequentially stacked on the base substrate, in which the first metal layer comprises an initialization signal line, a power supply voltage signal line and a data line that extend in the second direction; the active layer comprises a channel region of the sensing transistor, a channel region of the driving transistor, a channel region of the switching transistor and the first electrode plate; the second metal layer includes a gate electrode of the sensing transistor, a gate electrode of the driving transistor and a gate electrode of the switching transistor, the first connection electrode, the spacers, a second electrode plate of the storage capacitor, the second gate line and the first gate line that extend in the first direction.

For example, in the display panel provided by at least one embodiment of the present disclosure, an edge of the first electrode plate of the storage capacitor close to the second gate line extends in the first direction to right above the power supply voltage signal line.

For example, in the display panel provided by at least one embodiment of the present disclosure, the second metal layer further comprises a first connection structure extending in the second direction, and an orthographic projection of the first connection structure on the base substrate is within an orthographic projection of the initialization signal line on the base substrate.

For example, the display panel provided by at least one embodiment of the present disclosure, further comprising a buffer layer arranged on a side of the first metal layer away from the base substrate, a gate insulation layer and an interlayer insulation layer that are arranged between the active layer and the second metal layer, and a passivation layer and a planarization layer that are arranged on a side of the second metal layer away from the base substrate, in which a first via hole structure is arranged in the interlayer insulation layer, and the second metal layer is electrically connected with the active layer through the first via hole structure; a second via hole structure penetrates through the interlayer insulation layer and the buffer layer, and the second metal layer is electrically connected with the power supply voltage signal line through the second via hole structure.

For example, the display panel provided by at least one embodiment of the present disclosure, further comprising a cathode voltage trace, in which the cathode voltage trace comprises a first cathode voltage trace extending in the first direction and a second cathode voltage trace extending in the second direction, and the first cathode voltage trace intersects the second cathode voltage trace; the power supply voltage signal line further comprises a second power supply voltage signal line extending in the first direction, and the first power supply voltage signal line intersects the second power supply voltage signal line.

For example, in the display panel provided by at least one embodiment of the present disclosure, the second cathode voltage trace comprises a three-layer laminated structure, and the second cathode voltage trace comprises a first sub-layer of the second cathode voltage trace located in the first metal layer, a second sub-layer of the second cathode voltage trace located in the second metal layer, and a third sub-layer of the second cathode voltage trace located in the third metal layer, the first sub-layer of the second cathode voltage trace and the third sub-layer of the second cathode voltage trace are electrically connected through a fourth via hole structure, and the second sub-layer of the second cathode voltage trace and the third sub-layer of the second cathode voltage trace are electrically connected through a fifth via hole structure.

For example, the display panel provided by at least one embodiment of the present disclosure, further comprising an organic light-emitting diode, in which the organic light-emitting diode comprises an anode, and any one selected from a group consisting of the first sub-layer of the second cathode voltage trace, the second sub-layer of the second cathode voltage trace and the third sub-layer of the second cathode voltage trace is electrically connected with the anode through a sixth via hole structure.

For example, in the display panel provided by at least one embodiment of the present disclosure, the third sub-layer of the first cathode voltage trace is electrically connected with the anode through the sixth via hole structure.

For example, the display panel provided by at least one embodiment of the present disclosure, further comprising an encapsulation layer arranged on the organic light-emitting diode and a quantum dot layer arranged on the encapsulation layer, in which the quantum dot layer is configured to process light emitted from the organic light-emitting diode.

At least one embodiment of the present disclosure further provides a display device, and the display device includes any one of the display panels in the above-mentioned embodiments.

BRIEF DESCRIPTION OF DRAWINGS

In order to explain the technical solution of the embodiments of the present disclosure more clearly, the attached drawings of the embodiments will be briefly introduced below. Obviously, the attached drawings in the following description only relate to some embodiments of the present disclosure, and are not limited to the present disclosure.

Fig. 1 is a block diagram of a display panel provided by at least one embodiment of the present disclosure;
Fig. 2 shows a schematic diagram of a 3T1C pixel circuit used for the display panel;
Fig. 3 shows a signal timing diagram of the pixel circuit in Fig. 2 in a display process;
Fig. 4 shows a signal timing diagram of the pixel circuit in Fig. 2 in a detection process;
Fig. 5 shows another signal timing diagram of the pixel circuit in Fig. 2 in a detection process;
Fig. 6 is a layout diagram in which a multi-layer structure of a display panel is stacked;
Fig. 7 is a schematic planar view of a first metal layer included in a display panel provided by at least one embodiment of the present disclosure;
Fig. 8 is a schematic planar view of a laminated layer of a first metal layer and an active layer included in a display panel provided by at least one embodiment of the present disclosure;
Fig. 9 is a schematic planar view of a laminated layer of a first metal layer, an active layer and a second metal layer included in a display panel provided by at least one embodiment of the present disclosure;
Fig. 10 is a schematic planar view of a via hole structure formed in the laminated structure shown in Fig. 9;
Fig. 11 is a schematic planar view of a third metal layer included in a display panel provided by at least one embodiment of the present disclosure;
Fig. 12 is a schematic planar view of a laminated layer of a first metal layer, an active layer, a second metal layer and a third metal layer included in a display panel provided by at least one embodiment of the present disclosure;
Fig. 13 is a schematic cross-sectional view of a display panel provided by at least one embodiment of the present disclosure;
Fig. 14 is a schematic planar view of a laminated layer of a first metal layer, an active layer, a second metal layer and a third metal layer included in another display panel provided by at least one embodiment of the present disclosure;
Fig. 15 is a schematic planar view of a first metal layer included in the display panel in Fig. 14;
Fig. 16 is a schematic planar view of a laminated layer of a first metal layer and an active layer included in the display panel in Fig. 14;
Fig. 17 is a schematic planar view of a laminated layer of a first metal layer, an active layer and a second metal layer included in the display panel in Fig. 14;

Fig. 18 is a schematic planar view of via hole structures formed in the laminated structure shown in Fig. 14;

Fig. 19 is a schematic planar view of a third metal layer included in the display panel in Fig. 14;

Fig. 20 is a schematic planar view of a laminated layer of a first metal layer, an active layer and a second metal layer included in another display panel provided by at least one embodiment of the present disclosure;

Fig. 21 is a schematic planar view of a laminated layer of a first metal layer and an active layer included in the display panel in Fig. 20;

Fig. 22 is a schematic planar view of a second metal layer included in the display panel in Fig. 20;

Fig. 23 is a schematic planar view of a laminated layer of a first metal layer, an active layer, a second metal layer and a third metal layer included in another display panel provided by at least one embodiment of the present disclosure;

Fig. 24 is a schematic planar view of a first metal layer included in the display panel in Fig. 23;

Fig. 25 is a schematic planar view of a laminated layer of a first metal layer and an active layer included in the display panel in Fig. 23;

Fig. 26 is a schematic planar view of a laminated layer of a first metal layer, an active layer and a second metal layer included in the display panel in Fig. 23;

Fig. 27 is a schematic planar view of forming a via hole structure in the stacked structure shown in Fig. 26;

Fig. 28 is a schematic planar view of a third metal layer included in the display panel in Fig. 23;

Fig. 29 is a schematic cross-sectional view of the display panel in Fig. 23;

Fig. 30 is a schematic planar view of a laminated layer of a first metal layer, an active layer and a second metal layer included in another display panel provided by at least one embodiment of the present disclosure;

Fig. 31 is a schematic planar view of a laminated layer of a first metal layer and an active layer included in the display panel in Fig. 30;

Fig. 32 is a schematic planar view of the second metal layer in Fig. 30;

Fig. 33 is a schematic cross-sectional view of the display panel in Fig. 30;

Fig. 34 is a schematic planar view of a laminated layer of a first metal layer, an active layer, a second metal layer and a third metal layer provided by another display panel provided by at least one embodiment of the present disclosure;

Fig. 35 is a schematic planar view of a laminated layer of a first metal layer and a third metal layer included in the display panel in Fig. 34;

Fig. 36 is a schematic planar view of a laminated layer of a first metal layer, an active layer, a second metal layer and a third metal layer included in another display panel provided by at least one embodiment of the present disclosure;

Fig. 37 is a schematic cross-sectional view of the second cathode voltage trace of the display panel shown in Fig. 36 cutting along the second direction;

Fig. 38 is a schematic cross-sectional view of the structure shown in Fig. 37 after adding a cathode and a pixel definition layer;

Fig. 39 is a schematic cross-sectional view of the display panel shown in Fig. 36 after adding an organic light-emitting diode;

Fig. 40 is a schematic planar view of a laminated layer of a first metal layer, an active layer, a second metal layer and a third metal layer included in another display panel provided by at least one embodiment of the present disclosure;

Fig. 41 is a schematic cross-sectional view of the display panel shown in Fig. 40; and

Fig. 42 is a block diagram of a display device provided by at least one embodiment of the present disclosure.

DETAILED DESCRIPTION

In order to make the purpose, technical solution and advantages of the embodiments of the present disclosure clear, the technical solution of the embodiment of the present disclosure will be described clearly and completely with the accompanying drawings of specific embodiments of the present disclosure. It should be noted that the described embodiment is a part of the embodiment of the present disclosure, not the whole embodiment. Based on the described embodiments of the present disclosure, all other embodiments obtained by ordinary people in the field without creative labor belong to the scope of protection of the present disclosure.

Unless otherwise defined, technical terms or scientific terms used in the present disclosure shall have their ordinary meanings as understood by people with ordinary skills in the field to which the present disclosure belongs. The terms "first", "second" and the like used in the present disclosure do not indicate any order, quantity or importance, but are only used to distinguish different components. Similar words such as "including" or "containing" refer to that the elements or objects appearing before the word cover the elements or objects listed after the word and their equivalents, without excluding other elements or objects. Similar words such as "connected" or "connected" are not limited to physical or mechanical connection, but can include electrical connection, whether direct or indirect. "Up", "Down", "Left" and "Right" are only used to indicate the relative positional relationship. When the absolute position of the described object changes, the relative positional relationship may also change accordingly.

Unless otherwise defined, the features such as "parallel", "vertical" and "identical" used in the embodiments of the present disclosure all include cases such as "parallel", "vertical" and "identical" in a strict sense, and cases such as "approximately parallel", "approximately vertical" and "approximately identical" contain certain errors. For example, the above-mentioned "roughly" can refer to that the difference of the compared objects is within 10% or 5% of the average value of the compared objects. When the number of one component or element is not specified in the following of the embodiment of the present disclosure, it refers to that the component or element can be one or more, or can be understood as at least one. "At least one" refers to one or more, and "a plurality of" refers to at least two. "Arranged in the same layer" in the embodiment of the present disclosure refers to the relationship between a plurality of film layers formed by the same material after the same step (for example, one-step patterning process). The "same layer" here does not always mean that the thicknesses of the plurality of film layers are the same or the heights of the plurality of film layers in cross section are the same.

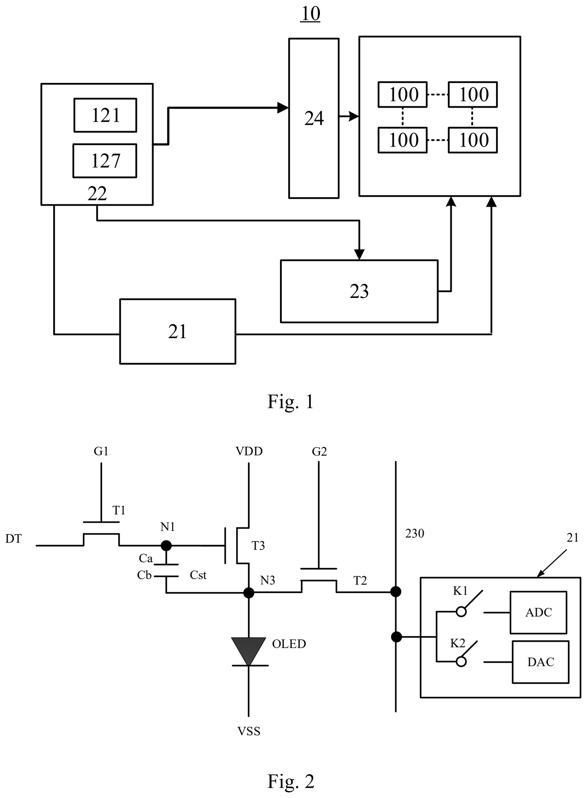

Fig. 1 is a block diagram of a display panel provided by at least one embodiment of the present disclosure. As shown in Fig. 1, the display panel 10 includes a plurality of sub-pixels 100 arranged in an array. For example, each sub-pixel 100 includes a light-emitting element and a pixel circuit for driving the light-emitting element to emit light. For example, the display panel is an organic light-emitting diode (OLED) display panel, and the light-emitting element is an organic light-emitting diode. The display panel may further include a plurality of scanning lines and a plurality of data lines for providing scanning signals (control signals) and data signals for a plurality of sub-pixels, thereby driving the plurality of sub-pixels for display. As required, the display panel may further include a power line, a detection line, and the like.

For example, the pixel circuit includes a driving sub-circuit for driving the light-emitting element to emit light and a detection sub-circuit for detecting the electrical characteristics of the sub-pixel to realize external compensation. The embodiment of the present disclosure does not limit the specific structure of the pixel circuit.

For example, Fig. 2 shows a schematic diagram of a 3T1C pixel circuit for the display panel. According to different application scenarios, the pixel circuit may further include a compensation circuit and a reset circuit, and the embodiment of the present disclosure does not limit to this.

Combined with the above-mentioned Fig. 1 and Fig. 2, the pixel circuit includes a first transistor T1, a second transistor T2, a third transistor T3 and a storage capacitor Cst. The first electrode of the first transistor T1 is electrically connected with the first capacitor electrode of the storage capacitor Cst and the gate electrode of the third transistor T3, the second electrode of the first transistor T1 is configured to receive the data signal GT, and the first transistor T1 is configured to write the data signal DT into the gate electrode of the third transistor T3 and the storage capacitor CST in response to the first control signal G1; the first electrode of the third transistor T3 is electrically connected with the second capacitor electrode of the storage capacitor Cst and configured to be electrically connected with the first electrode of the light-emitting element, the second electrode of the third transistor T3 is configured to receive a first power supply voltage V1 (e.g., a high power supply voltage VDD), and the third transistor T3 is configured to control the current for driving the light-emitting element under the control of the voltage of the gate electrode of the third transistor T3; the first electrode of the second transistor T2 is electrically connected to the first electrode of the third transistor T3 and the second capacitor electrode of the storage capacitor Cst, and the second electrode of the second transistor T2 is configured to be connected to the detection line 230 to be connected to the external detection circuit 21, and the second transistor T2 is configured to detect the electrical characteristics of the sub-pixel in response to the second control signal G2 to realize external compensation; the electrical characteristics include, for example, the threshold voltage and/or carrier mobility of the third transistor T3, or the threshold voltage and driving current of the light-emitting element. The external detection circuit 21 is, for example, a conventional circuit including a digital-to-analog converter (DAC) and an analog-to-digital converter (ADC), which will not be described in detail in the embodiment of the present disclosure.

The transistors used in the embodiments of the present disclosure can all be thin film transistors, field effect transistors or other switching devices with the same characteristics, and the embodiments of the present disclosure are all described by taking thin film transistors as examples. The source electrode and the drain electrode of the transistor used here can be symmetrical in structure, so there can be no difference in a structure between the source electrode and the drain electrode. In the embodiments of the present disclosure, in order to distinguish the two electrodes of a transistor except the gate electrode, one of the two electrodes of the transistor is directly described as the first electrode and the other is described as the second electrode. In addition, transistors can be divided into N-type transistors and P-type transistors according to their characteristics. In the case that the transistor is a P-type transistor, the turn-on voltage is a low-level voltage (for example, 0V, -5V, -10V or other suitable voltage) and the turn-off voltage is a high-level voltage (for example, 5V, 10V or other suitable voltage); in the case that the transistor is an N-type transistor, the turn-on voltage is a high-level voltage (for example, 5V, 10V or other suitable voltage) and the turn-off voltage is a low-level voltage (for example, 0V, -5V, -10V or other suitable voltage). It should be noted that, in the following descriptions, the embodiments are described by taking the case where the transistors in Fig. 2 are N-type transistors as an example, but it is not taken as a limitation to the present disclosure.

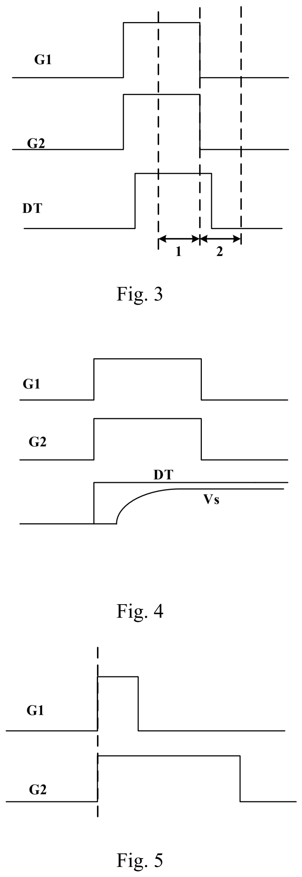

The working principle of the pixel circuit shown in Fig. 2 will be described with reference to the signal timing diagrams shown in Fig. 3 to Fig. 5, in which Fig. 3 shows a signal timing diagram of the pixel circuit in Fig. 2 in a display process, Fig. 4 shows a signal timing diagram of the pixel circuit in Fig. 2 in a detection process, and Fig. 5 shows another signal timing diagram of the pixel circuit in Fig. 2 in a detection process.

For example, as shown in Fig. 3, the display process of each frame image includes a data writing and resetting stage 1 and a light-emitting stage 2. Fig. 3 shows the timing waveforms of each signal in each stage. A working process of the 3T1C pixel circuit includes the follows. In the data writing and resetting stage 1, both the first control signal G1 and the second control signal G2 are on signals, the first transistor T1 and the second transistor T2 are turned on, the data signal DT is transmitted to the gate electrode of the third transistor T3 through the first transistor T1, the first switch K1 is turned off, the analog-to-digital converter writes a reset signal to the first electrode of the light-emitting element (such as an anode of an OLED) through the detection line 130 and the second transistor T2, and the third transistor T3 is turned on and generates a driving current to charge the first electrode of the light emitting element to the working voltage; in the light-emitting stage 2, the first control signal G1 and the second control signal G2 are both off signals, due to the bootstrap effect of the storage capacitor Cst, the voltage across the two ends of the storage capacitor Cst remains unchanged, and the third transistor T3 works in a saturated state with a constant current, and drives the light-emitting element to emit light.

For example, Fig. 4 shows a signal timing diagram of the pixel circuit when detecting the threshold voltage. A working process of the 3T1C pixel circuit includes: the first control signal G1 and the second control signal G2 are both on signals, the first transistor T1 and the second transistor T2 are turned on, and the data signal DT is transmitted to the gate electrode of the third transistor T3 through the first transistor T1; the first switch K1 is turned off, the analog-to-digital converter converter writes a reset signal to the first electrode (node N3) of the light-emitting element through the detection line 230 and the second transistor T2, the third transistor T3 is turned on and charges the node N3 until the third transistor T3 is turned off, and the digital-to-analog converter converter samples the voltage on the detection line 230 to obtain the threshold voltage of the third transistor T3. This process can be performed, for example, when the display device is turned off.

For example, Fig. 5 shows a signal timing diagram of the pixel circuit when the carrier mobility is detected. A working process of the 3T1C pixel circuit includes: in the first stage, both the first control signal G1 and the second control signal G2 are on signals, the first transistor T1 and the second transistor T2 are turned on, and the data signal DT is transmitted to the gate electrode of the third transistor T3 through the first transistor T1; the first switch K1 is turned off, and the analog-to-digital converter writes a reset signal to the first electrode (node N3) of the light-emitting element through the detection line 230 and the second transistor T2; in the second stage, the first control signal G1 is an off signal and the second control signal G1 is an on signal, the first transistor T1 is turned off and the second transistor T2 is turned on, and the first switch K1 and the second switch K2 are turned off to float the detection line 130; due to the bootstrap effect of the storage capacitor Cst, the voltage across the two ends of the storage capacitor Cst remains unchanged, and the third transistor T3 works in a saturated state with a constant current and drives the light-emitting element to emit light. Then, the voltage on the detection line 130 is sampled by the digital-to-analog converter, and the carrier mobility in the third transistor T3 can be calculated by combining the magnitude and duration of the light-emitting current. For example, the process can be carried out in a blanking stage between display stages.

Through the above detection, the electrical characteristics of the third transistor T3 can be obtained and the corresponding compensation algorithm can be realized.

For example, as shown in Fig. 1, the display panel 10 may further include a data driving circuit 23 and a scanning driving circuit 24. The data driving circuit 23 is configured to emit data signals, such as the above-mentioned data signal DT, according to needs (such as image signals input to the display device); the pixel circuit of each sub-pixel is further configured to receive the data signal and apply the data signal to the gate electrode of the first transistor. The scanning driving circuit 24 is configured to output various scanning signals, including, for example, the above-mentioned first control signal G1 and second control signal G2, and the scanning driving circuit 24, for example, is an integrated circuit chip (IC) or a gate driving circuit (GOA) directly prepared on a display substrate.

For example, with reference to Fig. 1, the display panel 10 further includes a control circuit 22. For example, the control circuit 22 is configured to control the data driving circuit 23 to apply the data signal and control the gate driving circuit to apply the scanning signal. An example of the control circuit 22 is a timing control circuit (T-con). The control circuit 22 may be in various forms, for example, including a processor 121 and a memory 127, the memory 121 includes an executable code, and the processor 121 runs the executable code to perform the above detection method.

For example, the processor 121 may be a central processing unit (CPU) or other processing devices with data processing capability and/or instruction execution capability, and may include, for example, a microprocessor, a programmable logic controller (PLC) and the like.

For example, the memory 127 may include one or more computer program products, which may include various forms of computer-readable storage media, such as volatile memory and/or nonvolatile memory. The volatile memory may include, for example, random access memory (RAM) and/or cache, etc. The nonvolatile memory may include, for example, a read-only memory (ROM), a hard disk, a flash memory, and the like. One or more computer program instructions may be stored on a computer-readable storage medium, and the processor 121 may execute the desired functions of the program instructions. The computer-readable storage medium can also store various applications and various data, such as the electrical characteristic parameters obtained in the above detection method.

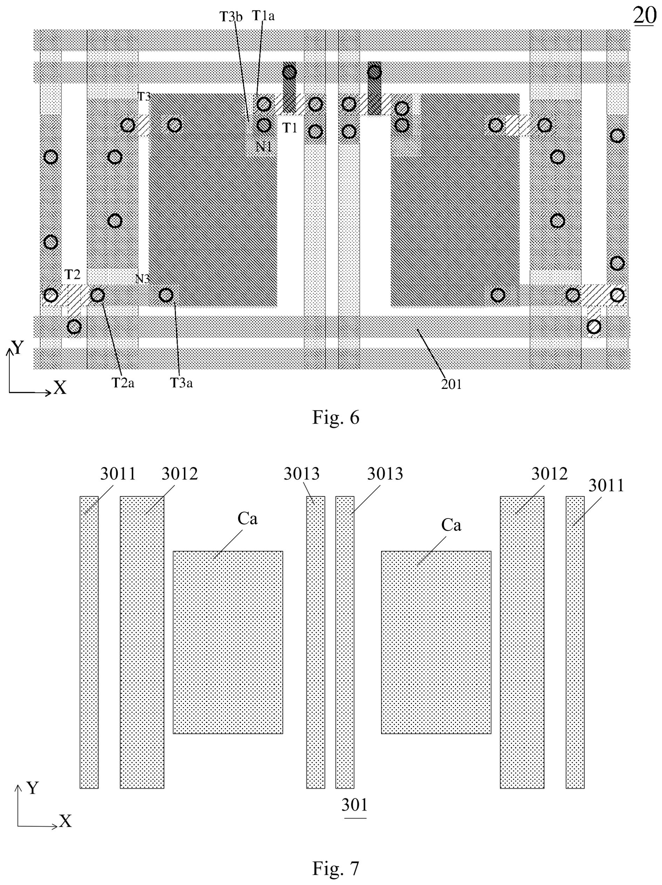

For example, Fig. 6 is a layout diagram in which a multi-layer structure of a display panel is stacked, as shown in Fig. 6, the first source-drain electrode T2a of the sensing transistor T2 and the first source-drain electrode T3a of the driving transistor T3 are electrically connected through the connection electrode corresponding to the node N3, the connection electrode corresponding to the node N3 is adjacent to the sensing gate line 201 in the second direction Y, and the first source-drain electrode T1a of the switching transistor T1 and the second source-drain electrode T3b of the driving transistor T3 are electrically connected through the connection electrode corresponding to the node N1. The inventor of the present disclosure noticed that because the distance between the sensing gate line 201 and the connection electrode corresponding to the node N3 is relatively short in the second direction Y, when the sensing gate line 201 generates voltage jump, it will cause voltage jump at the node N3, so that a great instantaneous current will be generated at the node N3 to impact the organic light-emitting diode, which will damage the organic light-emitting diode and reduce its service life, and the voltage jump at the node N3 will also cause voltage change at the node N1. Because the voltage variation at the node N3 is larger than that at the node N1, the voltage variation at the node N3 is more harmful to the organic light-emitting diode device than that at the node N1. Therefore, it can be considered to set a spacer between the connection electrode corresponding to the node N3 and the sensing gate line to reduce the voltage variation at the node N3 when the sensing gate line generates the voltage jump.

At least one embodiment of the present disclosure provides a display panel, which includes: a substrate; a pixel circuit arranged on the substrate, the pixel circuit comprises a sensing transistor, a driving transistor, a first gate line and a second gate line; a first source-drain electrode of the sensing transistor and a first source-drain electrode of the driving transistor are electrically connected through a first connection electrode; the first gate line and the second gate line extend in a first direction, in a second direction intersecting with the first direction, spacers are arranged between the first connection electrode and the first gate line and between the first connection electrode and the second gate line, and the first connection electrode, the first gate line, the second gate line and the spacers are arranged in a same layer. According to the embodiments of the present disclosure, the spacers are arranged between the first connection electrode and the first gate line, and between the first connection electrode and the second gate line, and the first connection electrode, the first gate line, the second gate line and the spacers are arranged in the same layer, so that the voltage change brought to the first connection electrode when the first gate line or the second gate line generates voltage jump can be reduced, thereby reducing the damage to the light-emitting diode and ensuring the service life of the light-emitting diode.

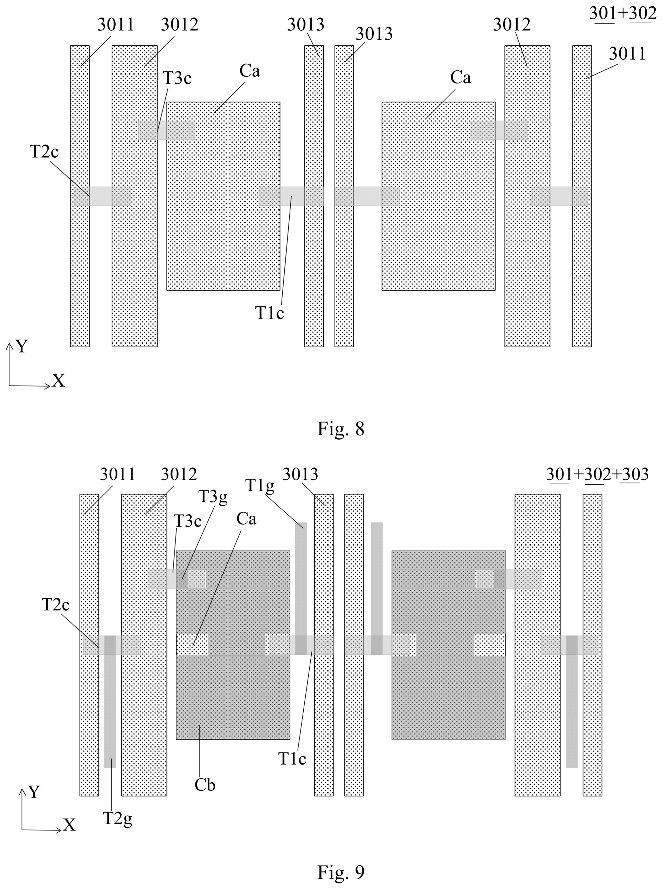

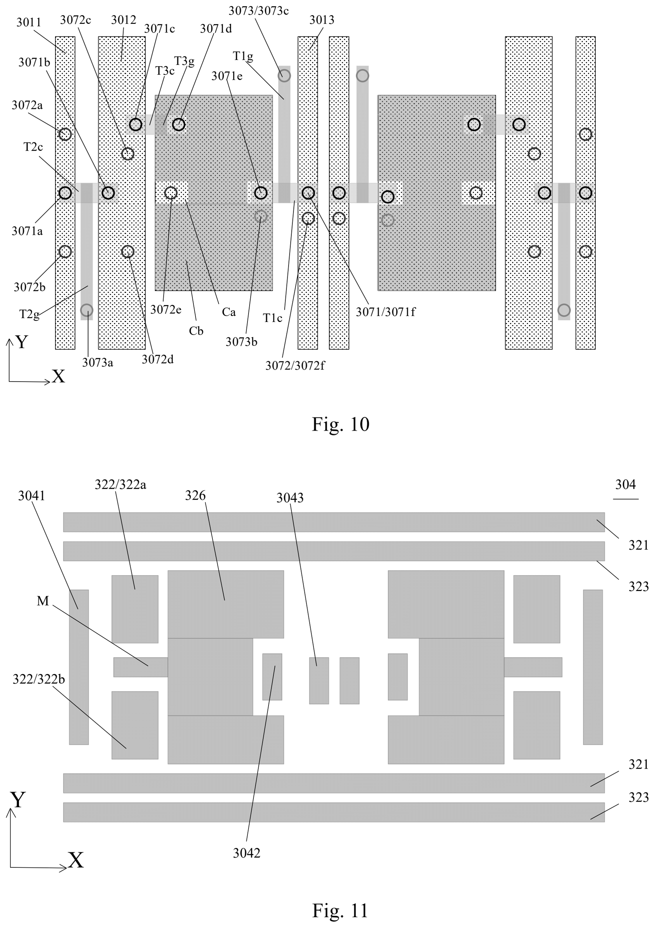

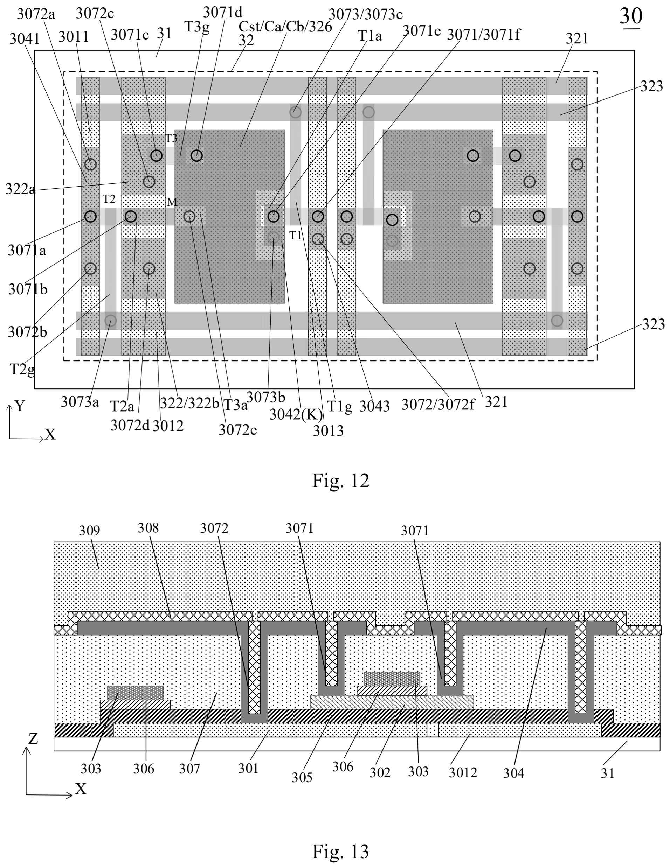

For example, Fig. 7 is a schematic planar view of a first metal layer included in a display panel provided by at least one embodiment of the present disclosure, Fig. 8 is a schematic planar view of a laminated layer of a first metal layer and an active layer included in a display panel provided by at least one embodiment of the present disclosure, Fig. 9 is a schematic planar view of a laminated layer of a first metal layer, an active layer and a second metal layer included in a display panel provided by at least one embodiment of the present disclosure, Fig. 10 is a schematic planar view of a via hole structure formed in the laminated structure shown in Fig. 9, Fig. 11 is a schematic planar view of a third metal layer included in a display panel provided by at least one embodiment of the present disclosure, and Fig. 12 is a schematic planar view of a laminated layer of a first metal layer, an active layer, a second metal layer and a third metal layer included in a display panel provided by at least one embodiment of the present disclosure.

For example, as shown in Fig. 2 and Fig. 12, the display panel 30 includes a base substrate 31, and a pixel circuit 32 arranged on the base substrate 31, the pixel circuit 32 includes a sensing transistor T2, a driving transistor T3, a first gate line 321 and a second gate line 323, and the first source-drain electrode T2a of the sensing transistor T2 and the first source-drain electrode T3a of the driving transistor T3 are electrically connected through a first connection electrode M; the first gate line 321 and the second gate line 323 extend in the first direction X, in the second direction Y intersecting with the first direction X, spacers 322 are arranged between the first connection electrode M and the first gate line 321, and between the first connection electrode M and the second gate line 323, and the first connection electrode M, the first gate line 321, the second gate line 323 and the spacers 322 are arranged in the same layer. The spacers 322 are arranged between the first connection electrode M and the first gate line 321, and between the first connection electrode M and the second gate line 323, and the first connection electrode M, the first gate line 321, the second gate line 323 and the spacers 322 are arranged in the same layer, so that the voltage change brought to the first connection electrode M when the first gate line 321 or the second gate line 323 generates voltage jump can be reduced, further, the damage to the light emitting diode caused by the voltage change that occurs on the first connection electrode M can be reduced, so as to ensure the service life of the light emitting diode.

For example, in one example, the first gate line 321 is a sensing gate line and the second gate line 323 is a switching gate line, but the embodiments of the present disclosure are not limited to this case, and the first gate line 321 and the second gate line 323 may be other gate lines.

For example, the embodiment of the present disclosure is described by taking the first direction X as the row direction and the second direction Y as the column direction as an example. In other embodiments, the first direction X may be the column direction and the second direction Y may be the row direction, which is not limited by the embodiments of the present disclosure.

For example, as shown in Fig. 2 and Fig. 12, the display panel 30 further includes a switching transistor T1 and a storage capacitor Cst which are arranged on a base substrate 31, the first source-drain electrode T1a of the switching transistor T1 and the gate electrode T3g of the driving transistor T3 are connected through a second connection electrode K, and the first electrode plate Ca of the storage capacitor Cst is also connected to the second connection electrode K, and the second electrode plate Cb of the storage capacitor Cst is connected to the first connection electrode M.

It should be noted that, in the embodiment shown in Fig. 12, the first connection electrode M and the second connection electrode K are both in a shape of a long strip arranged in the third metal layer. In the following embodiments, the first connection electrode M and the second connection electrode K are arranged in different positions from those in the previous embodiment, but they are both in a shape of a long strip.

For example, referring to Fig. 7 to Fig. 12, the display panel 30 includes a first metal layer 301, an active layer 302, a second metal layer 303 and a third metal layer 304 which are sequentially stacked on a base substrate 31. Although the insulation layers are not directly shown in the planar views shown in Fig. 7 to Fig. 12, only the via hole structures are used to represent the insulation layers, there is also an insulation layer structure between the adjacent conductive layers, and the via hole structures are arranged in the insulation layer structure, and the layer structures that need to be connected are connected through the via hole structures.

For example, in Fig. 7 and Fig. 12, the embodiment is described by taking pixel circuits corresponding to two sub-pixels arranged in the first direction X as an example. As shown in Fig. 7 and Fig. 12, the first metal layer 301 includes an initialization signal line 3011, a power supply voltage signal line 3012, a first electrode plate Ca and a data line 3013 that are extended in the second direction Y. In a pixel circuit, the length of the initialization signal line 3011, the length of the power supply voltage signal line 3012 and the length of the data line 3013 in the second direction Y are equal or approximately equal, and the length of the first electrode plate Ca in the second direction Y is smaller than the length of the initialization signal line 3011 in the second direction Y, smaller than the length of the power supply voltage signal line 3012 in the second direction Y and smaller than the lengths of the data line 3013 in the second direction Y. The widths of the initialization signal line 3011 and the data line 3013 in the first direction X are equal or approximately equal, and both the width of the initialization signal line 3011 in the first direction X and the width of the data line 3013 in the first direction X are smaller than the width of the power supply voltage signal line 3012 in the first direction X. The width of the power supply voltage signal line 3012 in the first direction X is smaller than the width of the first electrode plate Ca in the first direction X. A minimum distance between the first electrode plate Ca and the power voltage signal line 3012 adjacent thereto in the first direction X is smaller than that between the initialization signal line 3011 and the power voltage signal line 3012 in the first direction X, and smaller than that between the first electrode plate Ca and the data line 3013 adjacent thereto in the first direction X.

It should be noted that, although it is shown in Fig. 7 and Fig. 12 that the power supply voltage signal line 3012 includes a portion extending in the second direction Y, in other embodiments, the power supply voltage signal line 3012 may also include a portion extending in the first direction X.

For example, as shown in Fig. 8, the first metal layer 301 and the active layer 302 are stacked, and the active layer 302 includes a channel region T2c of the sensing transistor T2, a channel region T3c of the driving transistor T3, and a channel region T1c of the switching transistor T1. For example, in combination with Fig. 8 and Fig. 12, an orthographic projection of the channel region T2c of the sensing transistor T2 on the base substrate 31 overlaps with both an orthographic projection of the initialization signal line 3011 on the base substrate 31 and an orthographic projection of the power supply voltage signal line 3012 on the base substrate 31. An orthographic projection of the channel region T3c of the driving transistor T3 on the base substrate 31 overlaps with both the orthographic projection of the power supply voltage signal line 3012 on the base substrate 31 and an orthographic projection of the first electrode plate Ca on the base substrate 31. An orthographic projection of the channel region T1c of the switching transistor T1 on the base substrate 31 overlaps with both the orthographic projection of the first electrode plate Ca on the base substrate 31 and an orthographic projection of the data line 3013 on the base substrate 31.

For example, as shown in Fig. 9, the first metal layer 301, the active layer 302 and the second metal layer 303 are stacked in sequence, and the second metal layer 303 includes a gate electrode T2g of the sensing transistor T2, a gate electrode T3g of the driving transistor T3, a gate electrode T1g of the switching transistor T1 and a second electrode plate Cb. The gate electrode T2g of the sensing transistor T2 and the gate electrode T1g of the switching transistor T1 are both in a shape of a strip extending in a direction parallel to the second direction Y, and the gate electrode T2g of the sensing transistor T2 extends from the channel region T2c of the sensing transistor T2 in a direction opposite to the second direction Y, and the gate electrode T1g of the switching transistor T1 extends from the channel region T1c of the switching transistor T1 in the second direction Y. The gate electrode T3g of the driving transistor T3 and the second electrode plate Cb constitute an integral structure. With reference to Fig. 9 and Fig. 12, an area of the orthographic projection of the second electrode plate Cb on the base substrate 31 is smaller than an area of the orthographic projection of the first electrode plate Ca on the base substrate 31.

For example, in Fig. 10, it is shown that the via hole structure includes first via hole structures 3071, second via hole structures 3072 and third via hole structures 3073, and the corresponding connection relationships of the first via hole structures 3071, the second via hole structures 3072 and the third via hole structures 3073 are described below. For example, six first via hole structures 3071 (3071a, 3071b, 3071c, 3071d, 3071e and 3071f), six second via hole structures 3072 (3072a, 3072b, 3072c, 3072d, 3072e and 3072f), and three third via hole structures 3073 (3073a, 3073b and 3073c) are shown at the position corresponding to one sub-pixel in Fig. 10.

For example, in combination with Fig. 10 and Fig. 12, the six first via hole structures 3071 correspond to the positions of two ends of the channel region T2c of the sensing transistor T2, two ends of the channel region T3c of the driving transistor T3 and two ends of the channel region T1c of the switching transistor T1, specifically, the first via hole structure 3071a and the first via hole structure 3071b respectively correspond to the positions of two ends of the channel region T2c of the sensing transistor T2; the first via hole structure 3071c and the first via hole structure 3071d respectively correspond to the positions of two ends of the channel region T3c of the driving transistor T3; the first via hole structure 3071e and the first via hole structure 3071f respectively correspond to the positions of two ends of the channel region T1c of the switching transistor T1. An orthographic projection of the second via hole structure 3072a and an orthographic projection of the second via hole structure 3072b on the base substrate 31 are located in an orthographic projection of the initialization signal line 3011 on the base substrate 31, and are respectively located on two sides of the orthographic projection of the channel region T2c of the sensing transistor T2 on the base substrate 31 in the second direction Y; an orthographic projection of the second via hole structure 3072c and an orthographic projection of the second via hole structure 3072d on the base substrate 31 are located within an orthographic projection of the power supply voltage signal line 3012 on the base substrate 31, and are respectively located on two sides of the channel region T2c of the sensing transistor T2 in the second direction Y; an orthographic projection of the second via hole structure 3072e on the base substrate 31 is within the orthographic projection of the first electrode plate Ca on the base substrate 31 and not within the orthographic projection of the second electrode plate Cb on the base substrate 31; an orthographic projection of the second via hole structure 3072f on the base substrate 31 is within the orthographic projection of the data line 3013 on the base substrate 31. An orthographic projection of the third via hole structure 3073a on the base substrate 31 is within the orthographic projection of the gate electrode T2g of the sensing transistor T2 on the base substrate 31; an orthographic projection of the third via hole structure 3073b on the base substrate 31 is within the orthographic projection of the first electrode plate Ca, and within the second electrode plate Cb on the base substrate 31; an orthographic projection of the third via hole structure 3073c on the base substrate 31 is within the orthographic projection of the gate electrode T1g of the switching transistor T1 on the base substrate 31.

For example, as shown in Fig. 11, the third metal layer 304 includes the first connection electrode M, the spacers 322, the second gate line 323 and the first gate line 321 that are extending in the first direction X, and the first connection structure 3041, the second connection structure 3042 and the third connection structure 3043 that extend in the second direction Y. The second gate line 323 and the first gate line 321 are both in a shape of a long strip and extend in the first direction X. The first connection electrode M is also in a shape of a long strip and extends in the first direction X. The first connection structure 3041, the second connection structure 3042 and the third connection structure 3043 are used to realize the connection between the third metal layer 304 and other layer structures. In the second direction Y, the spacer 322b is located between the first connection electrode M and the first gate line 321, so that the voltage change to the first connection electrode M caused by voltage jump generated by the first gate line 321 can be reduced, and the spacer 322a is located between the first connection electrode M and the second gate line 323, so that the voltage change to the first connection electrode M caused by voltage jump generated by the second gate line 323 can be reduced, and further, the damage to the light-emitting diode caused by the voltage change that occurs on the first connection electrode M can be reduced, so as to ensure the service life of the light-emitting diode.

For example, with reference to Fig. 7 to Fig. 12, in the display panel 30, the channel region T2c of the sensing transistor T2 is electrically connected with the first connection structure 3041 through the first via hole structure 3071a, and electrically connected with the first connection electrode M through the first via hole structure 3071b; the channel region T3c of the driving transistor T3 is electrically connected with the spacer 322a through the first via hole structure 3071c, and electrically connected with the main body 326 through the first via hole structure 3071d; the channel region T1c of the switching transistor T1 is electrically connected with the second connection structure 3042 through the first via hole structure 3071e, and is electrically connected with the third connection structure 3043 through the first via hole structure 3071f.

For example, in combination with Fig. 7 to Fig. 12, in the display panel 30, the first connection structure 3041 is electrically connected with the initialization signal line 3011 located in the first metal layer 301 through the second via hole structure 3072a and the second via hole structure 3072b. The spacer 322a is electrically connected to the power supply voltage signal line 3012 through the second via hole structure 3072c, and the spacer 322b is electrically connected to the power supply voltage signal line 3012 through the second via hole structure 3072d. The first connection electrode M is electrically connected to the first electrode plate Ca through the second via hole structure 3072e. The third connection structure 3043 is electrically connected to the data line 3013 through the second via hole structure 3072f.

For example, in combination with Fig. 7 to Fig. 12, in the display panel 30, the gate electrode T2g of the sensing transistor T2 extends in the second direction Y to be electrically connected with the first gate line 321, and the gate electrode T2g of the sensing transistor T2 and the first gate line 321 are electrically connected through the third via hole structure 3073a. The gate electrode T1g of the switching transistor T1 extends in the direction opposite to the second direction Y to be electrically connected with the second gate line 323, and the first gate line 321 connected with the gate electrode T2g of the sensing transistor T2 and the second gate line 323 connected with the gate electrode T1g of the switching transistor T1 are respectively located at different sides of the spacers 322 in the second direction Y. The gate electrode T1g of the switching transistor T1 and the second gate line 323 are electrically connected through the third via hole structure 3073c. The gate electrode T3g of the driving transistor T3 and the second electrode plate Cb constitute an integral structure, and the second electrode plate Cb is electrically connected with the second connection structure 3042 through the third via hole structure 3073b.

It should be noted that in the structure shown in Fig. 12, the second connection structure 3042 also serves as the second connection electrode K.

For example, in combination with Fig. 7 to Fig. 12, the orthographic projection of the first connection structure 3041 on the base substrate 31 is within the orthographic projection of the initialization signal line 3011 on the base substrate 31, the orthographic projection of the second connection structure 3042 on the base substrate 31 is within the orthographic projection of the first electrode plate Ca on the base substrate 31, and the orthographic projection of the third connection structure 3043 on the base substrate 31 is within the orthographic projection of the data line 3013 on the base substrate 31. The orthographic projections of both the spacer 322a and the spacer 322b on the base substrate 31 are within the orthographic projection of the power supply voltage signal line 3012 on the base substrate 31.

For example, in Fig. 12, the spacer 322a and the spacer 322b that are located in the third metal layer 304 are respectively between the sensing transistor T2 and the first gate line 321, and between the sensing transistor T2 and the second gate line 323, the first gate line 321 and the second gate line 323 are respectively located on two sides of the sensing transistor T2 in the second direction Y, the spacer 322b can shield the coupling between the first source-drain electrode T2a of the sensing transistor T2 and the first gate line 321 connected to the sensing transistor T2. The first source-drain electrode T2a of the sensing transistor T2 is located in a third metal layer 304, and the power supply voltage signal line 3012 is located in the first metal layer 301. The spacer 322b located in the third metal layer 304 and between the first gate line 321 and the sensing transistor T2 is electrically connected with the power supply voltage signal line 3012 located in the first metal layer 301 through the second via hole structure 3072d; the spacer 322a located in the third metal layer 304 and between the second gate line 323 and the sensing transistor T2 is electrically connected with the power supply voltage signal line 3012 located in the first metal layer 301 through the second via hole structure 3072c. The switching transistor T1 can reduce the coupling between the second connection electrode K and the gate line (the first gate line 321 or the second gate line 323). The storage capacitor Cst is a double-layer capacitor which is respectively between the third metal layer 304 and the second metal layer 303, and between the first metal layer 301 and the second metal layer 303.

It should be noted that the voltage change of the first connection electrode M will cause the voltage change of the second connection electrode K. In the data writing stage, it is hoped that the voltage of the first connection electrode M is more stable, but in the lighting stage, the voltage rise of the first connection electrode M is normal. In the lighting stage, the voltage rise of the second connection electrode K is caused by the voltage rise coupling of the first connection electrode M, at this time, it is regarded that a capacitor is between the gate electrode of the driving transistor T3 and the power supply voltage signal line 3012, and the storage capacitor Cst is also another capacitor, during the coupling process, there is a capacitor voltage division, so the voltage rise of the second connection electrode K is not as high as that of the first connection electrode M. In the data writing stage, the voltage of the first connection electrode M is expected to be more stable, so the first connection electrode M is shielded by the spacers 322 to reduce the jump voltage. With the above design, the spacers 322 are arranged between the first connection electrode M and the first gate line 321, and the first connection electrode M is formed in the third metal layer 304, which is arranged in the same layer as the first gate line 321. Through the shielding effect of the spacer 322, the life of the organic light-emitting diode display device can be prolonged. The spacers 322 are arranged on both the two sides of the sensing transistor T2 and the first connection electrode M connected to the sensing transistor T2 in the second direction Y, which respectively shield the influence caused by the first gate line 321 and the second gate line 323 on the voltage change of the first connection electrode M, that is, the parasitic capacitance between the first connection electrode M and the first gate line 321 or between the first connection electrode M and the second gate line 323 cannot be formed due to the existence of the spacers 322.

For example, Fig. 13 is a schematic cross-sectional structure of a display panel provided by at least one embodiment of the present disclosure. As shown in Fig. 13, the display panel 30 further includes a buffer layer 305 arranged on the side of the first metal layer 301 away from the base substrate 31, and the buffer layer 305 is integrally formed on the base substrate 31, and a power supply voltage signal line 3012 is shown in the first metal layer 301. A gate insulation layer 306 is provided between the active layer 302 and the second metal layer 303, and an interlayer insulation layer 307 is provided between the second metal layer 303 and the third metal layer 304. A passivation layer 308 and a planarization layer 309 are sequentially arranged on the side of the third metal layer 304 away from the base substrate 31. The interlayer insulation layer 307, the passivation layer 308 and the planarization layer 309 are all integrally formed.

For example, in combination with Fig. 12 and Fig. 13, the first via hole structures 3071 are provided in the interlayer insulation layer 307, the third metal layer 304 is electrically connected with the active layer 302 through the first via hole structures 3071, and the second via hole structures 3072 penetrating through the interlayer insulation layer 307 and the buffer layer 305, and the third metal layer 304 is electrically connected with the first metal layer 301 through the second via hole structures 3072. Although not shown in Fig. 13, combined with Fig. 12, third via hole structures 3073 are provided in the interlayer insulation layer 307, and the third metal layer 304 is electrically connected with the second metal layer 303 through the third via hole structure 3073.

For example, on the left side of Fig. 13, a double-layer capacitor structure is shown, that is, a first capacitor structure is formed between the third metal layer 304 and the second metal layer 303, and a second capacitor structure is formed between the second metal layer 303 and the first metal layer 301, and both the orthographic projection of the third metal layer 304 on the base substrate 31 and the orthographic projection of the second metal layer 303 on the base substrate 31 overlaps with the orthographic projection of the first metal layer 301 on the base substrate 31.

For example, with reference to Fig. 12, in the display panel 30, the first connection structure 3041 is electrically connected with the second source-drain electrode T2b of the sensing transistor T2 through the first via hole structure 3071a. The second connection structure 3042 is electrically connected with the first source-drain electrode T1a of the switching transistor T1 through the first via hole structure 3071e, and is electrically connected with the second electrode plate Cb through the third via hole structure 3073b; the third connection structure 3043 is electrically connected to the data line 3013 through the second via hole structure 3072f, and is electrically connected to the second source-drain electrode T1b of the switching transistor T1 through the first via hole structure 3071f.

For example, in combination with Fig. 12, both at least a part of the third metal layer 304 and the first metal layer 301 have an overlapping region with the second metal layer 303, so as to form a storage capacitor Cst between the first metal layer 301 and the second metal layer 303, and form a capacitor structure between the second metal layer 303 and the third metal layer 304, so that a double capacitor structure can be formed.

For example, in combination with Fig. 12, the orthographic projection of the first source-drain electrode T2a of the sensing transistor T2 on the base substrate 31 overlaps with the orthographic projection of the power supply voltage signal line 3012 on the base substrate 31.

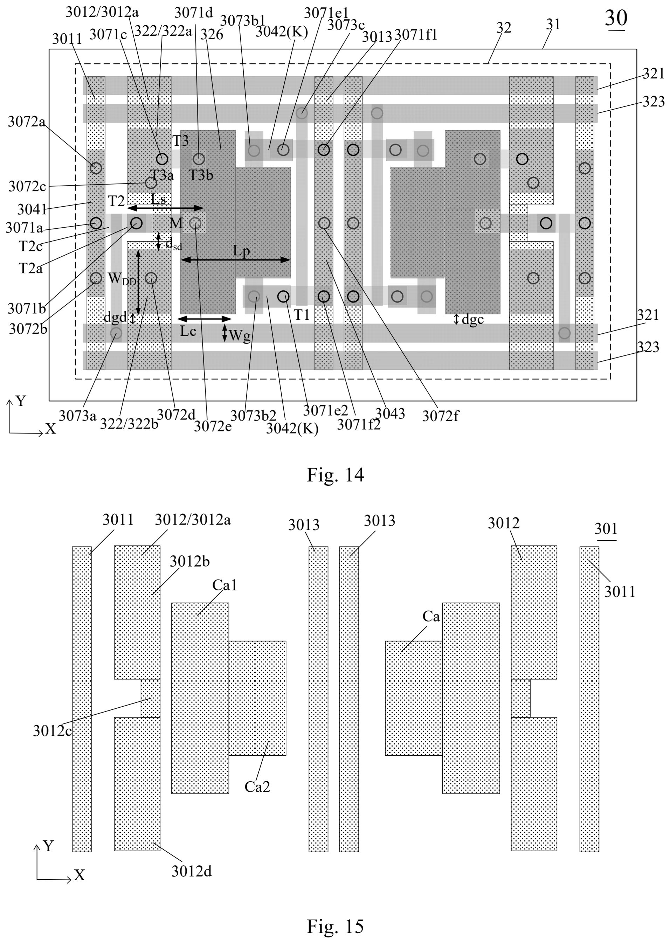

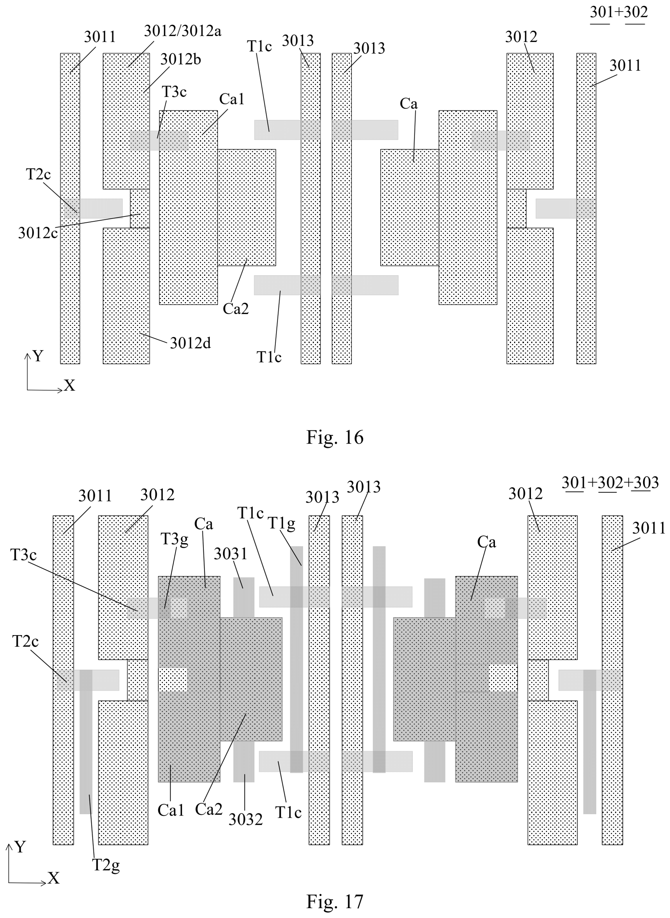

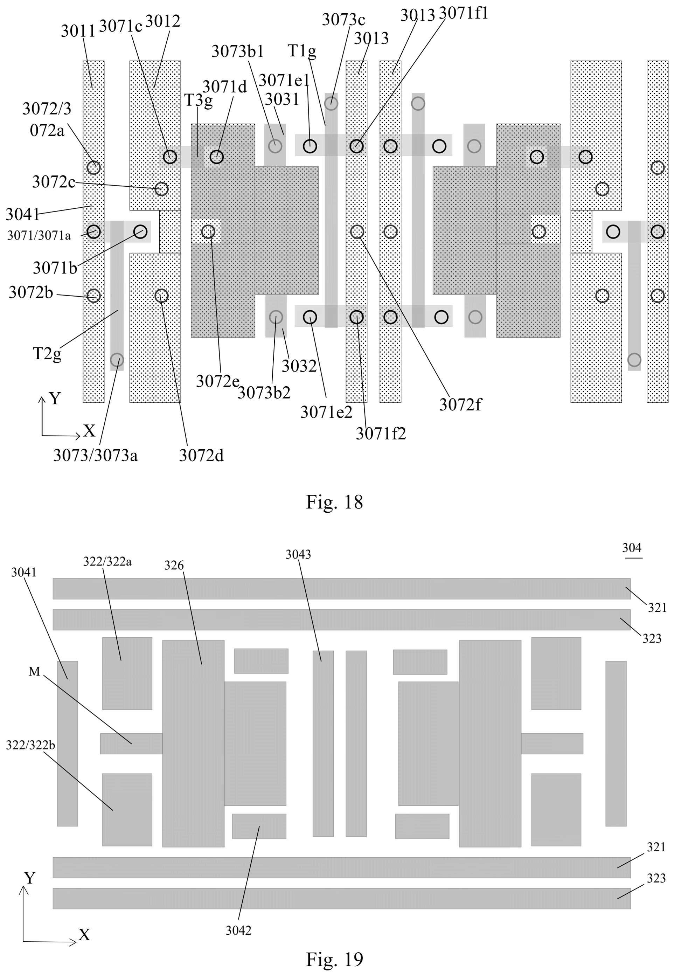

For example, Fig. 14 is a schematic planar view of a laminated layer of a first metal layer, an active layer, a second metal layer and a third metal layer included in another display panel provided by at least one embodiment of the present disclosure, Fig. 15 is a schematic planar view of a first metal layer included in the display panel in Fig. 14, Fig. 16 is a schematic planar view of a laminated layer of a first metal layer and an active layer included in the display panel in Fig. 14, Fig. 17 is a schematic planar view of a laminated layer of a first metal layer, an active layer and a second metal layer included in the display panel in Fig. 14, Fig. 18 is a schematic planar view of via hole structures formed in the laminated structure shown in Fig. 14, Fig. 19 is a schematic planar view of a third metal layer included in the display panel in Fig. 14.

For example, in combination with Fig. 2 and Fig. 14, the display panel 30 includes a base substrate 31, and a pixel circuit 32 arranged on the base substrate 31, the pixel circuit 32 includes a sensing transistor T2, a driving transistor T3, a switching transistor T1, a first gate line 321, a second gate line 323 and a storage capacitor Cst, and the first source-drain electrode T2a of the sensing transistor T2 and the first source-drain electrode T3a of the driving transistor T3 are electrically connected through a first connection electrode M; the first gate line 321 and the second gate line 323 extend in the first direction X, in a second direction Y intersecting with the first direction X, the spacers 322 are respectively arranged between the first connection electrode M and the first gate line 321, and between the first connection electrode M and the second gate line 323, and the first connection electrode M, the first gate line 321, the second gate line 323 and the spacers 322 are arranged in the same layer. The spacers 322 are respectively arranged between the first connection electrode M and the first gate line 321, and between the first connection electrode M and the second gate line 323, and the first connection electrode M, the first gate line 321, the second gate line 323 and the spacers 322 are arranged in the same layer, so that the voltage change brought to the first connection electrode M when the first gate line 321 or the second gate line 323 generates voltage jump can be reduced, and so that the voltage change brought to the first connection electrode M when the first gate line 321 or the second gate line 323 generates voltage jump can be reduced, further, the damage to the light emitting diode caused by the voltage change that occurs on the first connection electrode M can be reduced, so as to ensure the service life of the light emitting diode. The first source-drain electrode T1a of the switching transistor T1 and the gate electrode T3g of the driving transistor T3 are connected through the second connection electrode K, the first electrode plate Ca of the storage capacitor Cst is connected with the second connection electrode K, and the second electrode plate Cb of the storage capacitor Cst is connected with the first connection electrode M to form a whole pixel circuit.

For example, in Fig. 14, the spacer 322a and the spacer 322b that are located in the third metal layer 304 are respectively between the sensing transistor T2 and the first gate line 321, and between the sensing transistor T2 and the second gate line 323, the first gate line 321 and the second gate line 323 are respectively located on two sides of the sensing transistor T2 in the second direction Y, the spacer 322b can shield the coupling between the first source-drain electrode T2a of the sensing transistor T2 and the first gate line 321. The first source-drain electrode T2a of the sensing transistor T2 is located in the third metal layer 304, and the power supply voltage signal line 3012 is located in the first metal layer 301, the spacer 322b located in the third metal layer 304 and between the first gate line 321 and the sensing transistor T2 is electrically connected with the power supply voltage signal line 3012 located in the first metal layer 301 through the second via hole structure 3072d. The spacer 322a located in the third metal layer 304 between the second gate line 323 and the sensing transistor T2 is electrically connected with the power supply voltage signal line 3012 located in the first metal layer 301 through the second via hole structure 3072c. The switching transistor T1 may reduce the coupling between the second connection electrode K and the gate line (the first gate line 321 or the second gate line 323). The storage capacitor Cst is a double-layer capacitor which is respectively between the third metal layer 304 and the second metal layer 303, and between the first metal layer 301 and the second metal layer 303.

For example, in the display panel shown in Fig. 14, a part of the first metal layer 301 under the first source-drain electrode T2a of the sensing transistor T2 is removed, so that the parasitic capacitance can be reduced, that is, the power supply voltage signal line 3012 is narrowed at the positions corresponding to the first source-drain electrode T2a and the first connection electrode M of the sensing transistor T2, so that the overlapping area and the parasitic capacitance between the power supply voltage signal line 3012 and the first source-drain electrode T2a of the sensing transistor T2 can be reduced.

For example, in the display panel shown in Fig. 14, the switching transistor T1 is implemented as two thin film transistors connected in parallel, one of the two thin film transistors is located close to the upper second gate line 323, and the other is located close to the lower first gate line 321, that is, the two thin film transistors are respectively arranged on two sides of the first connection electrode M in the second direction, and the length of a part of the first electrode plate Ca of the storage capacitor Cst in the second direction Y is reduced. The above design can increase the width-length ratio of the channel of the switching transistor T1 and the driving current of the switching transistor T1, thus facilitating the driving of the high-resolution display panel and reducing the charging time, in addition, the distance between a part of the third metal layer corresponding to a part of the storage capacitor and the first gate line 321 or the second gate line 323 that are respectively located on two sides thereof in the second direction Y can be increased, so as to reduce the distance between the first electrode plate Ca of the storage capacitor Cst connected to the first connection electrode M and the first gate line 321 or the second gate line 323, and reduce the length of the parasitic capacitance coupling between the first connection electrode M and the gate line.

For example, in the display panel shown in Fig. 14, a part of the first metal layer 301 under the first source-drain electrode T2a of the sensing transistor T2 is removed, which can prevent the first connection electrode M from coupling with the bottom gate electrode of the sensing transistor T2 to generate leakage current.

For example, in the display panel shown in Fig. 14, other structures of the switching transistor T1 except the first source-drain electrode T1a are not covered by the third metal layer, so that the coupling effect between the switching transistor T1 and the first connection electrode M can be reduced.

For example, in combination with reference to Fig. 14 to Fig. 19, in the display panel 30, the display panel 30 includes a first metal layer 301, an active layer 302, a second metal layer 303 and a third metal layer 304 which are sequentially stacked on the base substrate 31. Although the insulation layer is not directly shown in the planar views shown in Fig. 14 to Fig. 19, only the via hole structures represent the insulation layers, there is also an insulation layer structure between the adjacent conductive layers, and the via hole structures are arranged in the insulation layer structure, and the layer structures that need to be connected are connected through the via hole structures.

For example, in Fig. 14 and Fig. 15, the embodiment is described by taking pixel circuits corresponding to two sub-pixels arranged in the first direction X as an example. As shown in Fig. 14 and Fig. 15, the first metal layer 301 includes an initialization signal line 3011, a power supply voltage signal line 3012, a first electrode plate Ca and a data line 3013 that extend in the second direction Y. Both the initialization signal line 3011 and the data line 3013 are straight lines extending in the second direction Y. The power supply voltage signal line 3012 includes a first power supply voltage signal line 3012a extending in the second direction Y. The first power supply voltage signal line 3012a includes a first part 3012b, a second part 3012c and a third part 3012d that extend in the second direction Y and are connected in sequence, and a width of the first part 3012b and a width of the third part 3012d in the first direction X are equal, a width of the second part 3012c in the first direction X is smaller than the width of the first part 3012b in the first direction X, and one end of the second part 3012c in the second direction Y is connected with the edge of the first part 3012b close to the third part 3012d and away from the initialization signal line, and the other end of the second part 3012c in the second direction Y is connected with the edge of the third part 3012d close to the first part 3012b and away from the initialization signal line 3011. The edge of the second part 3012c farthest from the initialization signal line 3011, the edge of the first part 3012b farthest from the initialization signal line 3011 and the edge of the third part 3012d farthest from the initialization signal line 3011 are all aligned and on a straight line, so that a notch is formed between the second part 3012c and the initialization signal line 3011. The first electrode plate Ca includes a first electrode plate sub-block Ca1 and a second electrode plate sub-block Ca2 that are connected with each other in the first direction X, the second electrode plate sub-block Ca2 is closer to the data line 3013 relative to the first electrode plate sub-block Ca1, and a length of the second electrode plate sub-block Ca2 in the second direction Y is smaller than a length of the first electrode plate sub-block Ca1 in the second direction Y, and in Fig. 15, an upper edge of the second electrode plate sub-block Ca2 is lower than an upper edge of the first electrode plate sub-block Ca1, and a lower edge of the second electrode plate sub-block Ca2 is higher than a lower edge of the first electrode plate sub-block Ca1.

For example, as shown in Fig. 14 and Fig. 16, the first metal layer 301 and the active layer 302 are laminated, and the active layer 302 includes a channel region T2c of the sensing transistor T2, a channel region T3c of the driving transistor T3, and channel regions T1c of two switching transistors T1. For example, in combination with Fig. 14 and Fig. 16, the orthographic projection of the channel region T2c of the sensing transistor T2 on the base substrate 31 and the orthographic projection of the initialization signal line 3011 on the base substrate 31 overlap with each other. The orthographic projection of the channel region T3c of the driving transistor T3 on the base substrate 31 overlap with both the orthographic projection of the power supply voltage signal line 3012 on the base substrate 31 and the orthographic projection of the first electrode plate Ca on the base substrate 31. The orthographic projections of the channel regions T1c of the two switching transistors T1 on the base substrate 31 overlap with the orthographic projection of the data line 3013 on the base substrate 31.

For example, as shown in Fig. 17, the first metal layer 301, the active layer 302 and the second metal layer 303 are stacked in sequence, the second metal layer 303 includes the gate electrode T2g of the sensing transistor T2, the gate electrode T3g of the driving transistor T3, the gate electrode T1g of the switching transistor T1 and the second electrode plate Cb; and the gate electrodes of the two switching transistors T1 constitute an integral structure. The gate electrode T2g of the sensing transistor T2 and the gate electrode T1g of the switching transistor T1 are both in a shape of a long strip extending in a direction parallel to the second direction Y, and the gate electrode T2g of the sensing transistor T2 extends from the channel region T2c of the sensing transistor T2 in a direction opposite to the second direction Y, and the gate electrode T1g of the switching transistor T1 extends from the channel region T1c of the switching transistor T1 below along the second direction Y. The gate electrode T3g of the driving transistor T3 and the second electrode plate Cb constitute an integral structure. Referring to Fig. 17 and Fig. 14, the second metal layer 303 includes a first extension part 3031 and a second extension part 3032 that extend from the part of the second electrode plate Cb corresponding to the second electrode plate sub-block Ca2 in the second direction Y, the two second connection structures 3042 are connected with the first extension part 3031 and the second extension part 3032 respectively. Both the orthographic projections of the first extension part 3031 and the second extension part 3032 on the base substrate 31 do not overlap with the orthographic projection of the first electrode plate Ca on the base substrate 31.

For example, in one example, the first extension part 3031 and the second extension part 3032 are both in a shape of a long strip, of course, the embodiments of the present disclosure are not limited to this, and the first extension part 3031 and the second extension part 3032 may also have other shapes such as blocks.

For example, the first via hole structures 3071, the second via hole structures 3072 and the third via hole structures 3073 are shown in Fig. 18, and the corresponding connection relationships among the first via hole structures 3071, the second via hole structures 3072 and the third via hole structures 3073 are described below. For example, eight first via hole structures 3071 (3071a, 3071b, 3073c, 3073d, 3071e1, 3071e2, 3071f1 and 3071f2) and six second via hole structures 3072 (3072a, 3072b, 3072c, 3072d, 3072e and 3072f) and four third via hole structures 3073 (3073a, 3073b, 3073c and 3073d) are shown in the position corresponding to one sub-pixel in Fig. 18.

For example, in combination with Fig. 18 and Fig. 14, the eight first via hole structures 3071 respectively correspond to the positions of two ends of the channel region T2c of the sensing transistor T2, the positions of two ends of the channel region T3c of the driving transistor T3 and the positions of two ends of the channel region T1c of the two switching transistors T1. Specifically, the first via hole structure 3071a and the first via hole structure 3071b respectively correspond to the positions of two ends of the channel region T2c of the sensing transistor T2; the first via hole structure 3071c and the first via hole structure 3071d respectively correspond to the positions of two ends of the channel region T3c of the driving transistor T3; the first via hole structure 3071e1 and the first via hole structure 3071f1 respectively correspond to the positions of two ends of the channel region T1c of one of two the switching transistors T1; the first via hole structure 3071e2 and the first via hole structure 3071f2 respectively correspond to the positions of two ends of the channel region T1c of the other switching transistor T1. The orthographic projection of the second via hole structure 3072a on the base substrate 31 and the orthographic projection of the second via hole structure 3072b on the base substrate 31 are located within the orthographic projection of the initialization signal line 3011 on the base substrate 31, and are respectively located on two sides of the orthographic projection of the channel region T2c of the sensing transistor T2 on the base substrate 31 in the second direction Y; the orthographic projection of the second via hole structure 3072c on the base substrate 31 and the orthographic projection of the second via hole structure 3072d on the base substrate 31 are located within the orthographic projection of the power supply voltage signal line 3012 on the base substrate 31, and are respectively located on two sides of the channel region T2c of the sensing transistor T2 in the second direction Y, that is, respectively corresponding to the first part 3012b and the third part 3012d that are included in the first power supply voltage signal line 3012a; the orthographic projection of the second via hole structure 3072e on the base substrate 31 is within the orthographic projection of the first electrode plate Ca on the base substrate 31 and not within the orthographic projection of the second electrode plate Cb on the base substrate 31. The orthographic projection of the second via hole structure 3072f on the base substrate 31 is within the orthographic projection of the data line 3013 on the base substrate 31. The orthographic projection of the third via hole structure 3073a on the base substrate 31 is within the orthographic projection of the gate electrode T2g of the sensing transistor T2 on the base substrate 31; the orthographic projection of the third via hole structure 3073b1 on the base substrate 31 and the orthographic projection of the third via hole structure 3073b2 on the base substrate 31 are respectively within the orthographic projection of the first extension part 3031 on the base substrate 31 and the orthographic projection of the second extension part 3032 on the base substrate 31; the orthographic projection of the third via hole structure 3073c on the base substrate 31 is within the orthographic projection of the gate electrode T1g of the switching transistor T1 on the base substrate 31.

For example, as shown in Fig. 19, the third metal layer 304 includes the first connection electrode M, the spacers 322, the second gate line 323 and the first gate line 321 that both extend in the first direction X, the first connection structure 3041 and the third connection structure 3043 that both extend in the second direction Y, and two second connection structures 3042 extending in the first direction X. The second gate line 323 and the first gate line 321 are both in a shape of a long strip and extend in the first direction X. The first connection electrode M is also in a shape of a long strip and extends in the first direction X. The first connection structure 3041, the second connection structure 3042 and the third connection structure 3043 are used to realize the connection between the third metal layer 304 and other layer structures. In the second direction Y, the spacer 322b is located between the first connection electrode M and the first gate line 321, so that the voltage change to the first connection electrode M caused by voltage jump of the first gate line 321 can be reduced, and the spacer 322a is located between the first connection electrode M and the second gate line 323, so that the voltage change to the first connection electrode M caused by voltage jump of the second gate line 323 can be reduced, and further, the damage to the light-emitting diode caused by the voltage change that occurs on the first connection electrode M can be reduced, so as to ensure the service life of the light-emitting diode.

It should be noted that in the embodiment shown in Fig. 14, the second connection electrode K also serves as the second connection structure 3042.

For example, in combination with Fig. 14 to Fig. 19, in the display panel 30, the channel region T2c of the sensing transistor T2 is electrically connected with the first connection structure 3041 through the first via hole structure 3071a, and is electrically connected with the first connection electrode M through the first via hole structure 3071b; the channel region T3c of the driving transistor T3 is electrically connected with the spacer 322a through the first via hole structure 3071c, and is electrically connected with the main body 326 through the first via hole structure 3071d; the channel region T1c of the switching transistor T1 located at the upper side is electrically connected with the second connection structure 3042 located at the upper side through the first via hole structure 3071e1, and is electrically connected with the third connection structure 3043 through the first via hole structure 3071f; the channel region T1c of the switching transistor T1 located at the lower side is electrically connected with the second connection structure 3042 located at the lower side through the first via hole structure 3071e2, and is electrically connected with the third connection structure 3043 through the first via hole structure 3071f2.

For example, in combination with Fig. 14 to Fig. 19, in the display panel 30, the first connection structure 3041 is electrically connected with the initialization signal line 3011 located in the first metal layer 301 through the second via hole structure 3072a and the second via hole structure 3072b. The spacer 322a is electrically connected with the first part 3012b of the first power supply voltage signal line 3012a through the second via hole structure 3072c, and the spacer 322b is electrically connected with the third part 3012d of the first power supply voltage signal line 3012a through the second via hole structure 3072d. The first connection electrode M is electrically connected to the first electrode plate Ca through the second via hole structure 3072e. The third connection structure 3043 is electrically connected to the data line 3013 through the second via hole structure 3072f.

For example, in combination with Fig. 14 to Fig. 19, in the display panel 30, the gate electrode T2g of the sensing transistor T2 extends in the second direction Y to be electrically connected with the first gate line 321, and the gate electrode T2g of the sensing transistor T2 and the first gate line 321 are electrically connected through the third via hole structure 3073a. The gate electrode T1g of the switching transistor T1 extends in the direction opposite to the second direction Y to be electrically connected with the second gate line 323, and the first gate line 321 connected with the gate electrode T2g of the sensing transistor T2 and the second gate line 323 connected with the gate electrode T1g of the switching transistor T1 are respectively located at different sides of the spacers 322 in the second direction Y. The gate electrode T1g of the switching transistor T1 and the second gate line 323 are electrically connected through the third via hole structure 3073c. The first extension part 3031 is electrically connected with the second connection structure 3042 located at the upper side through the third via hole structure 3073b1, and the second extension part 3032 is electrically connected with the second connection structure 3042 located at the lower side through the third via hole structure 3073b2.

For example, in combination with Fig. 14 to Fig. 19, the orthographic projection of the first connection structure 3041 on the base substrate 31 is within the orthographic projection of the initialization signal line 3011 on the base substrate 31, and the orthographic projection of the third connection structure 3043 on the base substrate 31 is within the orthographic projection of the data line 3013 on the base substrate 31. The orthographic projection of the spacer 322a on the base substrate 31 and the orthographic projection of the spacer 322b on the base substrate 31 are both within the orthographic projection of the power supply voltage signal line 3012 on the base substrate 31.

For example, in Fig. 14, the spacer 322a and the spacer 322b that are located in the third metal layer 304 are respectively between the sensing transistor T2 and the first gate line 321, and between the sensing transistor T2 and the second gate line 323, the first gate line 321 and the second gate line 323 are respectively located on two sides of the sensing transistor T2 in the second direction Y, the spacer 322b can shield the coupling between the first source-drain electrode T2a of the sensing transistor T2 and the first gate line 321 connected to the sensing transistor T. The first source-drain electrode T2a of the sensing transistor T2 is located in the third metal layer 304, and the power supply voltage signal line 3012 is located in the first metal layer 301. The spacer 322b located in the third metal layer 304 and between the first gate line 321 and the sensing transistor T2 is electrically connected with the power supply voltage signal line 3012 located in the first metal layer 301 through the second via hole structure 3072d; the spacer 322a located in the third metal layer 304 and between the second gate line 323 and the sensing transistor T2 is electrically connected with the power supply voltage signal line 3012 located in the first metal layer 301 through the second via hole structure 3072c. The switching transistor T1 can reduce the coupling between the second connection electrode K and the gate line (the first gate line 321 or the second gate line 323). The storage capacitor Cst is a double-layer capacitor which is respectively between the third metal layer 304 and the second metal layer 303, and between the first metal layer 301 and the second metal layer 303.

It should be noted that the voltage change of the first connection electrode M will cause the voltage change of the second connection electrode K. In the data writing stage, it is hoped that the voltage of the first connection electrode M is more stable, but in the lighting stage, the voltage rise of the first connection electrode M is normal. In the lighting stage, the voltage rise of the second connection electrode K is caused by the voltage rise coupling of the first connection electrode M, at this time, it is regarded that a capacitor is between the second connection electrode K and the power supply voltage signal line 3012, and the storage capacitor Cst is also another capacitor. During the coupling process, there is a capacitor voltage division, so the voltage rise of the second connection electrode K is not as high as that of the first connection electrode M. In the data writing stage, the voltage of the first connection electrode M is expected to be more stable, so the first connection electrode M is shielded by the spacers 322 to reduce the jump voltage. With the above design, the spacers 322 are arranged between the first connection electrode M and the first gate line 321, and the first connection electrode M is formed in the third metal layer 304, which is arranged in the same layer as the first gate line 321. Through the shielding effect of the spacers 322, the life of the organic light-emitting diode display device can be prolonged. The spacers 322 are arranged on both the two sides of the sensing transistor T2 and the first connection electrode M connected to the sensing transistor T2 in the second direction Y, which respectively shield the influence caused by the first gate line 321 and the second gate line 323 on the voltage change of the first connection electrode M, that is, the parasitic capacitance between the first gate line 321 and the first connection electrode M or the second gate line 323 and the first connection electrode M cannot be formed due to the existence of the spacers 322.

For example, in combination with Fig. 14, the orthographic projection of the first source-drain electrode T2a of the sensing transistor T2 on the base substrate 31 is spaced apart from the orthographic projection of the power supply voltage signal line 3012 on the base substrate 31, that is, the first source-drain electrode T2a of the sensing transistor T2 is at the notch between the second part 3012c and the initialization signal line 3011.

For example, in combination with Fig. 2, and Fig. 14 to Fig. 19, the data line 3013 is configured to provide the data signal (data voltage) to the pixel circuit, the second gate line 323 is configured to provide a first scanning signal to the pixel circuit, the first gate line 321 is configured to provide a second scanning signal to the pixel circuit, the initialization signal line 3011 is configured to provide an initialization signal to the pixel circuit, and the power supply voltage signal line 3012 is configured to provide a first power supply voltage VDD to the pixel circuit.

For example, the cross-sectional structure corresponding to the embodiment shown in the planar view of Fig. 14 to Fig. 19 can be referred to the above-mentioned description about Fig. 13, and will not be repeated herein.

For example, with reference to Fig. 14, the driving current $I_D$ of the driving transistor T3 satisfies

$$I_D = \frac{W}{L}\mu_n C_{GI}\left[(V_{GS} - V_{TH})V_{DS} - \frac{1}{2}V_{DS}^2\right]$$, where $W$ is the width (the width in the second direction) of the channel of the driving transistor T3, L is the length (length in the first direction) of the channel of the driving transistor T3, $\mu_n$ is the carrier mobility of the driving transistor T3, $V_{TH}$ is the threshold voltage of the driving transistor T3, and $C_{GI}$ is the capacitance of the gate insulation layer, $V_{GS}$ is the voltage difference between the gate electrode T3g and the first source-drain electrode T3a of the driving transistor T3, and $V_{DS}$ is the voltage difference between the first source-drain electrode T3a and the second source-drain electrode T3b of the driving transistor T3.

For example, in combination with Fig. 2 and Fig. 14, the display panel 30 further includes an organic light-emitting diode, and the display panel 30 includes a storage capacitor Cst, it is satisfied that

$$\frac{\Delta V_{dr}}{\Delta V_g} = \frac{C_{gc}}{C_{st}} = \frac{\varepsilon \times \frac{A_{gc}}{d_{gc}}}{\varepsilon \times \frac{A_{st}}{d_{st}}} = \frac{A_{gc} \times d_{st}}{A_{st} \times d_{gc}} = \frac{W_g \times l_c \times THK_{ILD}}{A_{st} \times d_{gc}}$$ and the value of $\frac{\Delta V_{dr}}{\Delta V_g}$ is greater than or equal to

0.013, $\Delta V_{dr}$ is the jump voltage in the case that the first connection electrode M is not shielded, $\Delta V_g$ is the jump voltage of the first gate line 321, $C_{gc}$ is the parasitic capacitance between the first gate line 321 and the storage capacitor $C_{st}$, $C_{st}$ is the capacitance value of the storage capacitor $C_{st}$, and $A_{st}$ is the area of the storage capacitor $C_{st}$, $d_{gc}$ is the minimum distance between the first gate line 321 and the storage capacitor Cst (the minimum distance in the second direction Y), $L_c$ is the length of the part of the first electrode plate closest to the first gate line 321 in the first direction (that is, the length of the side of the first electrode plate Ca closest to the first gate line 321), $W_g$ is the width of the first gate line 321, and $d_{st}$ is the thickness of a insulation medium corresponding to the storage capacitor Cst, that is, the thickness $THK_{ILD}$ of the interlayer insulation layer between the first electrode plate Ca and the second electrode plate Cb, $\varepsilon$ is the dielectric coefficient of the organic material for forming the interlayer insulation layer, and $A_{gc}$ is the area where parasitic capacitance is formed between the first gate line and the storage electrode.

For example, in one example, it is satisfied that

$$\frac{\Delta V_{dr}}{\Delta V_{gray}} = \frac{W_g \times l_c \times THK_{ILD} \times (V_{gON} - V_{gOFF})}{A_{st} \times d_{gc}} \times \frac{10^\gamma}{V_{oled}} \geq 3.14$$, $V_{gON}$ is the turn-on voltage of the second gate line,

$V_{gOFF}$ is the turn-off voltage of the second gate line, $V_{oled}$ is the voltage across two ends of the organic light-emitting diode, $\gamma$ is the optical constant, and $\Delta V_{gray}$ is the change of the gray-scale voltage.

For example, in one example, the storage capacitor has a three-layer structure formed by the first metal layer, the second metal layer and the third metal layer, and it is satisfied that

$$\frac{\Delta V_{dr}}{\Delta V_g} = \frac{C_{gc}}{C_{st}} = \frac{\varepsilon \times \frac{A_{gc}}{d_{gc}}}{\varepsilon \times \frac{A_{st}}{d_{stu}} + \varepsilon \times \frac{A_{st}}{d_{std}}} = \frac{W_g \times l_c}{A_{st} \times d_{gc} \times \left(\frac{1}{THK_{ILD}} + \frac{1}{THK_{BUF}}\right)}$$, and the value of $\frac{\Delta V_{dr}}{\Delta V_g}$ is greater than or equal to 0.006, $\Delta V_{dr}$ is the jump voltage of the first connection electrode M, $\Delta V_g$ is the jump voltage of the first gate line 321, $C_{gc}$ is the parasitic capacitance between the first gate line 321 and the storage capacitor $C_{st}$, $C_{st}$ is the size of the storage capacitor, $A_{st}$ is the area of the storage capacitor, $d_{gc}$ is the minimum distance between the first gate line 321 and the storage capacitor (the minimum distance in the second direction Y), $d_{stu}$ is the thickness of the insulation medium corresponding to the upper capacitor in the storage capacitor, that is, the thickness $THK_{ILD}$ of the interlayer insulation layer between the first electrode plate Ca and the second electrode plate Cb, $d_{std}$ is the thickness of the insulation medium of the lower capacitor in the storage capacitor, that is, the thickness of the insulation medium between the first metal layer and the second metal layer, that is, the thickness $THK_{BUF}$ of the buffer layer, $Lc$ is the length of the edge of the first electrode plate sub-block adjacent to the first gate line 321 (that is, the length of the edge of the first electrode plate Ca closest to the first gate line 321), $Wg$ is the width of the first gate line, $d_{st}$ is the thickness of the insulation medium corresponding to the storage capacitor, that is, the thickness $THK_{ILD}$ of the interlayer insulation layer between the first electrode plate Ca and the second electrode plate Cb, $\varepsilon$ is the dielectric coefficient of the organic material for forming the interlayer insulation layer, and $A_{gc}$ is the area where the parasitic capacitance is formed between the first gate line and the storage electrode.

For example, in one example, it is satisfied that $\frac{\Delta V_{dr}}{\Delta V_{gray}} = \frac{W_g \times l_c \times (V_{gON} - V_{gOFF})}{A_{st} \times d_{gc} \times \left(\frac{1}{THK_{ILD}} + \frac{1}{THK_{BUF}}\right)} \times \frac{10^\gamma}{V_{oled}} \geq 1.5$,

$V_{gON}$ is the turn-on voltage of the first gate line 321, $V_{gOFF}$ is the turn-off voltage of the first gate line 321, $V_{oled}$ is the voltage across two ends of the organic light-emitting diode, $\gamma$ is the optical constant, and $\Delta V_{gray}$ is the change of gray-scale voltage.

For example, in one example, it is satisfied that

$$\frac{\Delta V_{dr}}{\Delta V_g} = \frac{C_{gc}}{C_{st}} = \frac{\varepsilon \times \frac{A_{gc}}{d_{gc}}}{\varepsilon \times \frac{A_{st}}{d_{st}}} = \frac{A_{gc} \times d_{st}}{A_{st} \times d_{gc}} = \frac{W_g \times l_c \times THK_{ILD}}{A_{st} \times d_{gc}} = 0.013,$$

$$\frac{\Delta V_{dr}}{\Delta V_{gray}} = \frac{W_g \times l_c \times THK_{ILD} \times (V_{gON} - V_{gOFF})}{A_{st} \times d_{gc}} \times \frac{10^\gamma}{V_{oled}} = 3.14,$$

$$\frac{\Delta V_{dr}}{\Delta V_{gray}} = \frac{W_g \times l_c \times THK_{ILD} \times (V_{gON} - V_{gOFF})}{A_{st} \times d_{gc}} \times \frac{10^\gamma}{V_{oled}} \geq 3.14, \frac{W_g \times l_c \times THK_{ILD}}{A_{st} \times d_{gc}} \geq 0.013.$$

For example, in one example, it is satisfied that $R_l = \frac{L_c}{L_p} \leq 0.5$, $W_{DD}$ is the length in the second direction Y of the spacer 322b between the first gate line 321 and the first connection electrode M, $d_{gd}$ is the minimum distance between the first gate line 321 and the spacer 322b, and $d_{sd}$ is the minimum distance between the first connection electrode M and the spacer 322b.

For example, in one example, it is satisfied that $R_l = \dfrac{L_c}{L_p} \leq 0.5$, $L_c$ is the length of the edge of the first electrode plate sub-block adjacent to the first gate line 321, that is, the length of the part of the first electrode plate sub-block closest to the first gate line 321 in the first direction, that is, the length of the edge of the first electrode plate Ca closest to the first gate line 321, $L_p$ is the sum of the length of the first electrode plate sub-block in the first direction X and the length of the second electrode plate sub-block in the first direction X, and $R_l$ is the ratio of the length of the edge of the first electrode plate sub-block adjacent to the first gate line 321 to the sum of the length of the first electrode plate sub-block in the first direction X and the length of the second electrode plate sub-block in the first direction X.

For example, in one example, it is satisfied that $R_c = \dfrac{W_c \times d_{gc}}{Pitch \times Pitch} \leq 0.005$, $W_c$ is the width of the storage capacitor in the first direction, $d_{gc}$ is the minimum distance between the first gate line 321 and the storage capacitor, and $Pitch$ is the width of one sub-pixel.

For example, with reference to Fig. 14, in one example, $d_{gc}$=10.2 μm, $d_{gd}$=7.9 μm, $ds_d$=10.2 μm, $d_{cld}$=9.03 μm, $A_{st}$=5605 μm2, the length of $C_{st}$=90.3 μm, the width of $C_{st}$=62.07 μm, $THK_{ILD}$=0.5 μm, and $THK_{ILD}$= 0.5 μm, $THK_{BUF}$=0.3 μm, $THK_{GI}$=0.15 μm, and $Pitch$=231 μm. It is satisfied that

$$\frac{\Delta V_{dr}}{\Delta V_g} = \frac{C_{gc}}{C_{st}} = \frac{\varepsilon \times \frac{A_{gc}}{d_{gc}}}{\varepsilon \frac{A_{st}}{d_{stu}} + \varepsilon \times \frac{A_{st}}{d_{std}}} = \frac{W_g \times l_c}{A_{st} \times d_{gc} \times \left(\frac{1}{THK_{ILD}} + \frac{1}{THK_{BUF}}\right)} = 0.004 \quad \frac{\Delta V_{dr}}{\Delta V_g} = \frac{C_{gc}}{C_{st}} = $$

$$\frac{\varepsilon \times \frac{A_{gc}}{d_{gc}}}{\varepsilon \times \frac{A_{st}}{d_{stu}} + \varepsilon \times \frac{A_{st}}{d_{std}}} = \frac{W_g \times l_c}{A_{st} \times d_{gc} \times \left(\frac{1}{THK_{ILD}} + \frac{1}{THK_{BUF}}\right)} \leq 0.004 \quad \frac{\Delta V_{dr}}{\Delta V_{gray}} = $$

$$\frac{W_g \times l_c \times (V_{gON} - V_{gOFF})}{A_{st} \times d_{gc} \times \left(\frac{1}{THK_{ILD}} + \frac{1}{THK_{BUF}}\right)} \times \frac{10^Y}{V_{oled}} \leq 1.5,$$

And it is satisfied that

$$\frac{\Delta V_{dr}}{\Delta V_g} = \frac{C_{gc}}{C_{st}} = \frac{\varepsilon \times \frac{A_{gc}}{d_{gc}}}{\varepsilon \times \frac{A_{st}}{d_{st}}} = \frac{A_{gc} \times d_{st}}{A_{st} \times d_{gc}} = \frac{W_g \times l_c \times THK_{ILD}}{A_{st} \times d_{gc}} = 0.011 \quad \frac{\Delta V_{dr}}{\Delta V_g} = \frac{C_{gc}}{C_{st}} = $$

$$\frac{\varepsilon \times \frac{A_{gc}}{d_{gc}}}{\varepsilon \times \frac{A_{st}}{d_{stu}} + \varepsilon \times \frac{A_{st}}{d_{std}}} = \frac{W_g \times l_c}{A_{st} \times d_{gc} \times \left(\frac{1}{THK_{ILD}} + \frac{1}{THK_{BUF}}\right)} \leq 0.011 \quad \frac{\Delta V_{dr}}{\Delta V_{gray}} = $$

$$\frac{W_g \times l_c \times (V_{gON} - V_{gOFF})}{A_{st} \times d_{gc} \times \left(\frac{1}{THK_{ILD}} + \frac{1}{THK_{BUF}}\right)} \times \frac{10^Y}{V_{oled}} \leq 3.1$$

For example, in the display panel shown in the above embodiment, the proportional relationship between the capacitance value $C_{st}$ of the storage capacitor and the capacitance value $C_{gc}$ of the parasitic capacitance formed by the second electrode plate Cb of the storage capacitor and the first gate line 321 is:

$$\frac{C_{st}}{C_{gc}} = \frac{\varepsilon \times \frac{A_{st}}{d_{st}}}{\varepsilon \times \frac{A_{gc}}{d_{gc}}} = \frac{A_{st} \times d_{gc}}{A_{gc} \times d_{st}} = \frac{W_c \times l_c \times d_{gc}}{A_{gc} \times THK_{ILD}} = P \times W_c \times d_{gc} \quad P = \frac{l_c}{A_{gc} \times THK_{ILD}},$$

In which $C_{gc}$ is the capacitance value of the parasitic capacitance formed by the second electrode plate Cb of the storage capacitor and the first gate line, $C_{st}$ is the capacitance value of the storage capacitor, $A_{st}$ is the area of the storage capacitor, $d_{gc}$ is the minimum distance between the first gate line and the storage capacitor, $L_c$ is the length of the edge of the first electrode sub-block adjacent to the first gate line, $W_c$ is the width of the storage capacitor, $d_{st}$ is the thickness of the insulation medium corresponding to the storage capacitor, that is, the thickness $THK_{ILD}$ of the interlayer insulation layer between the first electrode plate and the second electrode plate, $\varepsilon$ is the dielectric coefficient of the organic material for forming the interlayer insulation layer, and $A_{gc}$ is the area where parasitic capacitance is formed between the first gate line and the second electrode plate.

For example, the value of P relates to the thickness of the interlayer insulation layer between the first electrode plate and the second electrode plate, as well as the parameters in the horizontal direction of the pixel, and it is assumed that P is a constant independent of the vertical direction of the pixel ($W_c$ and $d_{gc}$) during calculation. Because $W_c$ and $d_{gc}$ are related to the pixel size and the aperture ratio, their values are positively related to the width of the sub-pixel which is a pixel characteristic value, and are positively related to the ratio of the capacitance value $C_{st}$ of the storage capacitor to the capacitance value $C_{gc}$ of the parasitic capacitance formed by the second electrode plate Cb and the first gate line 321, the greater the ratio, the less the voltage of the first connection electrode M is affected by the parasitic capacitance generated by the first gate line or the second gate line, and the more stable the voltage of the first connection electrode M is.

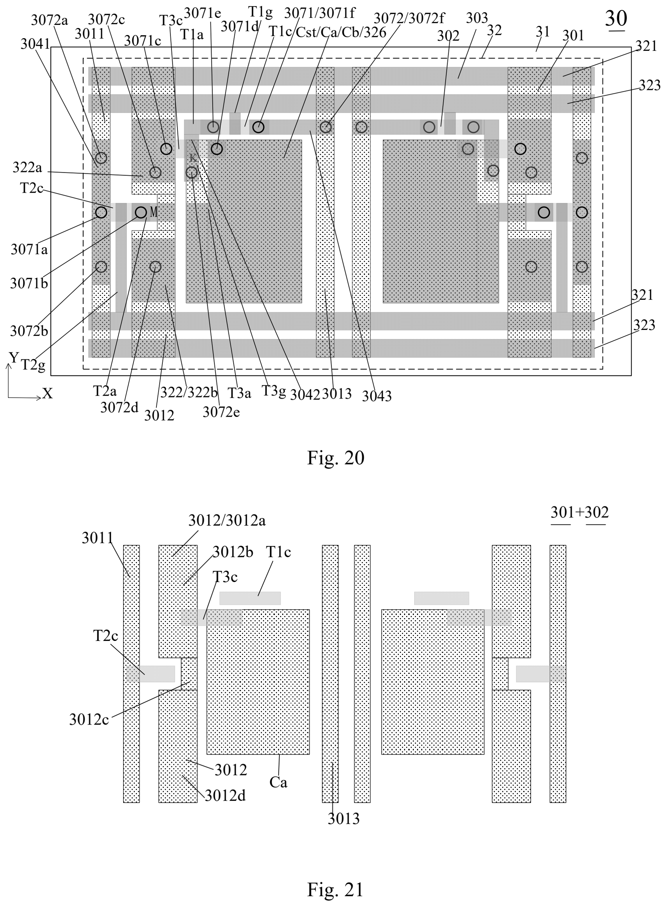

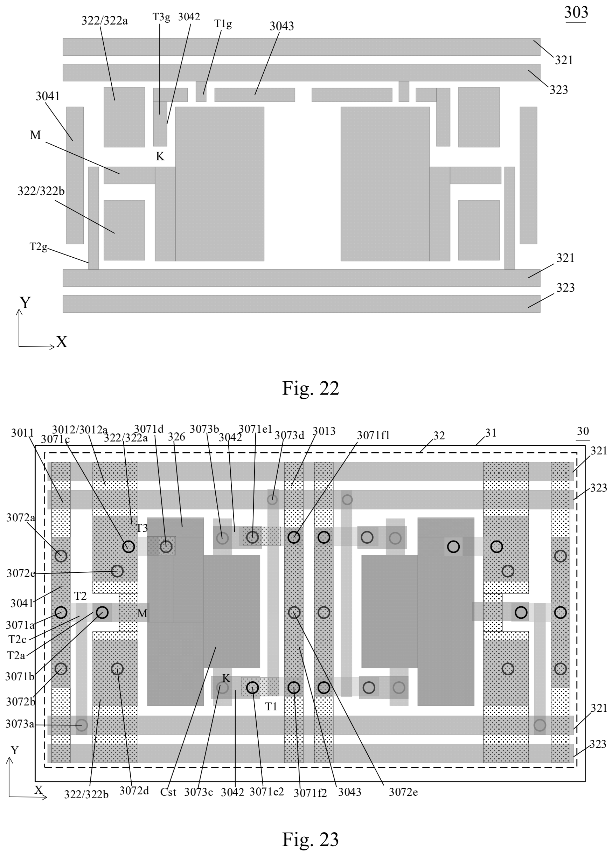

For example, Fig. 20 is a schematic planar view of a laminated layer of a first metal layer, an active layer and a second metal layer included in another display panel provided by at least one embodiment of the present disclosure, Fig. 21 is a schematic planar view of a laminated layer of a first metal layer and an active layer included in the display panel in Fig. 20, and Fig. 22 is a schematic planar view of a second metal layer included in the display panel in Fig. 20.

For example, as shown in Fig. 2 and Fig. 20, the display panel 30 includes a base substrate 31, and a pixel circuit 32 arranged on the base substrate 31, the pixel circuit 32 includes a sensing transistor T2, a driving transistor T3, a switching transistor T1, a first gate line 321, a second gate line 323 and a storage capacitor Cst, and the first source-drain electrode T2a of the sensing transistor T2 and the first source-drain electrode T3a of the driving transistor T3 are electrically connected through a first connection electrode M; the first gate line 321 and the second gate line 323 both extend in the first direction X, in the second direction Y intersecting with the first direction X, spacers 322 are respectively arranged between the first connection electrode M and the first gate line 321, and between the first connection electrode M and the second gate line 323, and the first connection electrode M, the first gate line 321, the second gate line 323 and the spacers 322 are arranged in the same layer. The spacers 322 are respectively arranged between the first connection electrode M and the first gate line 321, and between the first connection electrode M and the second gate line 323, and the first connection electrode M, the first gate line 321, the second gate line 323 and the spacers 322 are arranged in the same layer, so that the voltage change brought to the first connection electrode M when the first gate line 321 or the second gate line 323 generates voltage jump can be reduced, further, the damage to the light emitting diode caused by the voltage change that occurs on the first connection electrode M can be reduced, so as to ensure the service life of the light emitting diode.

For example, as shown in Fig. 20, the display panel 30 further includes a first metal layer 301, an active layer 302 and a second metal layer 303 which are sequentially stacked on the base substrate 31. The first metal layer 301 includes an initialization signal line 3011 extending in the second direction Y, a power supply voltage signal line 3012 at least partially extending in the second direction Y, a first electrode plate Ca and a data line 3013 extending in the second direction Y. The active layer 302 includes a channel region T2c of the sensing transistor T2, a channel region T3c of the driving transistor T3 and a channel region T1c of the switching transistor T1, the channel region T1c of the switching transistor T1, the channel region T3c of the driving transistor T3 and the channel region T2c of the sensing transistor T2 are sequentially arranged in the second direction Y. The second metal layer 303 includes the gate electrode T2g of the sensing transistor T2, the gate electrode T3g of the driving transistor T3, the gate electrode T1g of the switching transistor T1, the second electrode plate Cb, the first connection electrode M, the second connection electrode K, the spacers 322, the second gate line 323 and the first gate line 321 both extending in the first direction X and spaced apart from each other.

For example, in combination with Fig. 20 and Fig. 21, in the second direction Y, the second connection electrode K is between the first connection electrode M and the second gate line 323 located at the upper side, the gate electrode T1g of the switching transistor T1 is electrically connected with the second gate line 323 located at the upper side, the gate electrode T2g of the sensing transistor T2 is electrically connected with the first gate line 321 located at the lower side, and the second gate line 323 connected with the gate electrode T1g of the switching transistor T1 and located at the upper side and the first gate line 321 connected to the gate electrode T2g of the sensing transistor T2 and located at the lower side are respectively on different sides of the first electrode plate Ca in the second direction Y.

For example, in combination with Fig. 20 and Fig. 21, the first source-drain electrode T1a of the switching transistor T1 is connected to the second connection electrode K, and the second connection electrode K also serves as the gate electrode T3g of the driving transistor T3. The first electrode plate Ca of the storage capacitor Cst is connected with the second connection electrode K, and the second electrode plate Cb of the storage capacitor Cst is connected with the first connection electrode M to form a whole pixel circuit.

For example, as shown in Fig. 20, a part of the first metal layer 301 under the first source-drain electrode T2a of the sensing transistor T2 is removed, so that the parasitic capacitance can be reduced, that is, the power supply voltage signal line 3012 is narrowed at the positions corresponding to the first source-drain electrode T2a of the sensing transistor T2 and the first connection electrode M, so that the overlapping area and the parasitic capacitance between the power supply voltage signal line 3012 and the first source-drain electrode T2a of the sensing transistor T2 can be reduced.

For example, in combination with Fig. 20 and Fig. 21, both the initialization signal line 3011 and the data line 3013 are straight lines extending in the second direction Y. The power supply voltage signal line 3012 includes a first power supply voltage signal line 3012a extending in the second direction Y, the first power supply voltage signal line 3012a includes a first part 3012b, a second part 3012c and a third part 3012d that extend in the second direction Y and are connected in sequence, and the width of the first part 3012b in the first direction X and the width of the third part 3012d in the first direction X are equal, the width of the second part 3012c in the first direction X is smaller than that of the first part 3012b in the first direction X, and one end of the second part 3012c in the second direction Y is connected with the edge of the first part 3012b close to the third part 3012d and away from the initialization signal line, and the other end of the second part 3012c in the second direction Y is connected with the edge of the third part 3012d close to the first part 3012b and away from the initialization signal line 3011. The edge of the second part 3012c farthest from the initialization signal line 3011, the edge of the first part 3012b farthest from the initialization signal line 3011 and the edge of the third part 3012d farthest from the initialization signal line 3011 are all aligned and on a straight line, so a notch is formed between the second part 3012c and the initialization signal line 3011. The planar shape of the first electrode plate Ca is rectangular.

For example, as shown in Fig. 21, the first metal layer 301 and the active layer 302 are stacked. For example, in combination with Fig. 20 and Fig. 21, the orthographic projection of the channel region T2c of the sensing transistor T2 on the base substrate 31 and the orthographic projection of the initialization signal line 3011 on the base substrate 31 overlap with each other. The orthographic projection of the channel region T3c of the driving transistor T3 on the base substrate 31 overlap with both the orthographic projection of the power supply voltage signal line 3012 on the base substrate 31 and the orthographic projection of the first electrode plate Ca on the base substrate 31. The orthographic projection of the channel region T1c of the switching transistor T1 on the base substrate 31 and the structure on the first metal layer 301 do not overlap.

For example, as shown in Fig. 20 and Fig. 22, the gate electrode T1g of the driving transistor T3, the gate electrode T2g of the sensing transistor T2, and the gate electrode T1g of the switching transistor T1 are all in a shape of a long strip extending in a direction parallel to the second direction Y. The gate electrode T2g of the sensing transistor T2 extends from the channel region T2c of the sensing transistor T2 in a direction opposite to the second direction Y, and the gate electrode T1g of the switching transistor T1 extends from the channel region T1c of the switching transistor T1 in the second direction Y. The gate electrode T3g of the driving transistor T3 and the second connection electrode K constitute an integral structure. The first connection electrode M and the second electrode plate Cb constitute an integral structure.

For example, as shown in Fig. 20 and Fig. 22, the second metal layer 303 further includes a first connection structure 3041 and a second connection structure 3042 both extending in the second direction Y, and a third connection structure 3042 extending in the first direction X. The second connection electrode K also serves as the second connection structure 3042. The second gate line 323 and the first gate line 321 are both in a shape of a long strip and extend in the first direction X. The first connection electrode M is also in a shape of a long strip and extends in the first direction X. The first connection structure 3041, the second connection structure 3042 and the third connection structure 3043 are used to realize the connection between the third metal layer 304 and other layer structures.

For example, the first via hole structures 3071 and the second via hole structures 3072 are shown in Fig. 20, and the corresponding connection relationship between the first via hole structures 3071 and the second via hole structures 3072 is described below. For example, six first via hole structures 3071 (3071a, 3071b, 3071c, 3071d, 3071e, and 3071f) and six second via hole structures 3072 (3072a, 3072b, 3072c, 3072d, and 3072f) are shown at the position corresponding to one sub-pixel in Fig. 20.

For example, in combination with Fig. 20 and Fig. 21, the six first via hole structures 3071 respectively correspond to the positions of two ends of the channel region T2c of the sensing transistor T2, two ends of the channel region T3c of the driving transistor T3 and two ends of the channel region T1c of the switching transistor T1. Specifically, the first via hole structures 3071a and the first via hole structures 3071b respectively correspond to the positions of two ends of the channel region T2c of the sensing transistor T2; the first via hole structure 3071c and the first via hole structure 3071d respectively correspond to the positions of two ends of the channel region T3c of the driving transistor T3; the first via hole structure 3071e and the first via hole structure 3071f respectively correspond to the positions of two ends of the channel region T1c of the switching transistor T1. The orthographic projection of the second via hole structure 3072a on the base substrate 31 and the orthographic projection of the second via hole structure 3072b on the base substrate 31 are both within the orthographic projection of the initialization signal line 3011 on the base substrate 31, and are respectively located on two sides of the orthographic projection of the channel region T2c of the sensing transistor T2 on the base substrate 31 in the second direction Y; the orthographic projection of the second via hole structure 3072c on the base substrate 31 and the orthographic projection of the second via hole structure 3072d on the base substrate 31 are both within the orthographic projection of the power supply voltage signal line 3012 on the base substrate 31, and are respectively located on two sides of the channel region T2c of the sensing transistor T2 in the second direction Y, that is, respectively corresponding to the first part 3012b and the third part 3012d that are included in the first power supply voltage signal line 3012a; the orthographic projection of the second via hole structure 3072e on the base substrate 31 is within both the orthographic projection of the second connection electrode K on the base substrate 31 and the orthographic projection of the first electrode plate Ca on the base substrate 31, but not within the orthographic projection of the second electrode plate Cb on the base substrate 31; the orthographic projection of the second via hole structure 3072f on the base substrate 31 is within the orthographic projection of the data line 3013 on the base substrate 31.

For example, with reference to Fig. 20 to Fig. 22, in the display panel 30, the channel region T2c of the sensing transistor T2 is electrically connected with the first connection structure 3041 through the first via hole structure 3071a, and is electrically connected with the first connection electrode M through the first via hole structure 3071b; the channel region T3c of the driving transistor T3 is electrically connected with the spacer 322a through the first via hole structure 3071c, and is electrically connected with the second electrode plate Cb through the first via hole structure 3071d; the channel region T1c of the switching transistor T1 is electrically connected with the second connection structure 3042 through the first via hole structure 3071e, and is electrically connected with the third connection structure 3043 through the first via hole structure 3071f.

For example, with reference to Fig. 20 to Fig. 22, in the display panel 30, the first connection structure 3041 is electrically connected with the initialization signal line 3011 located in the first metal layer 301 through the second via hole structure 3072a and the second via hole structure 3072b. The spacer 322a is electrically connected with the first part 3012b of the first power supply voltage signal line 3012a through the second via hole structure 3072c, and the spacer 322b is electrically connected with the third part 3012d of the first power supply voltage signal line 3012a through the second via hole structure 3072d. The second connection electrode K is electrically connected to the first electrode plate Ca through the second via hole structure 3072e. The third connection structure 3043 is electrically connected to the data line 3013 through the second via hole structure 3072f.

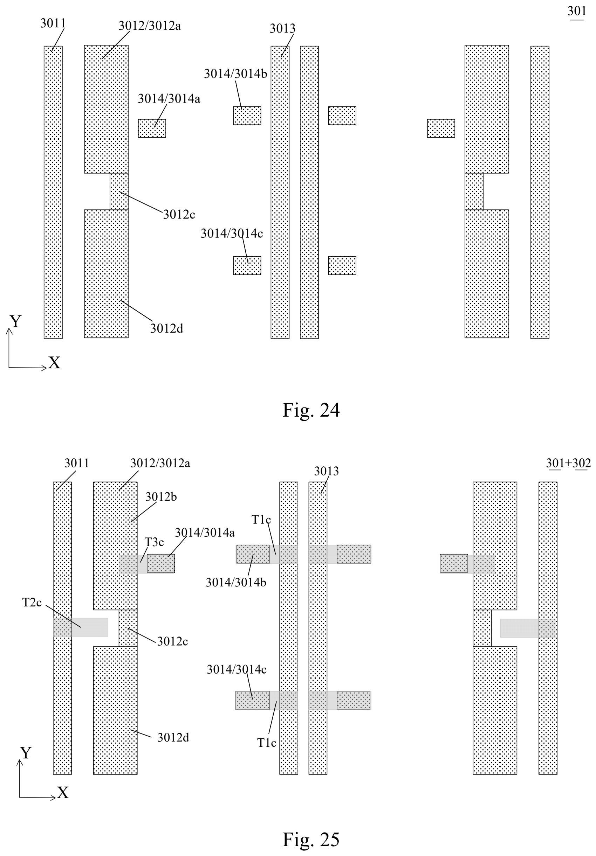

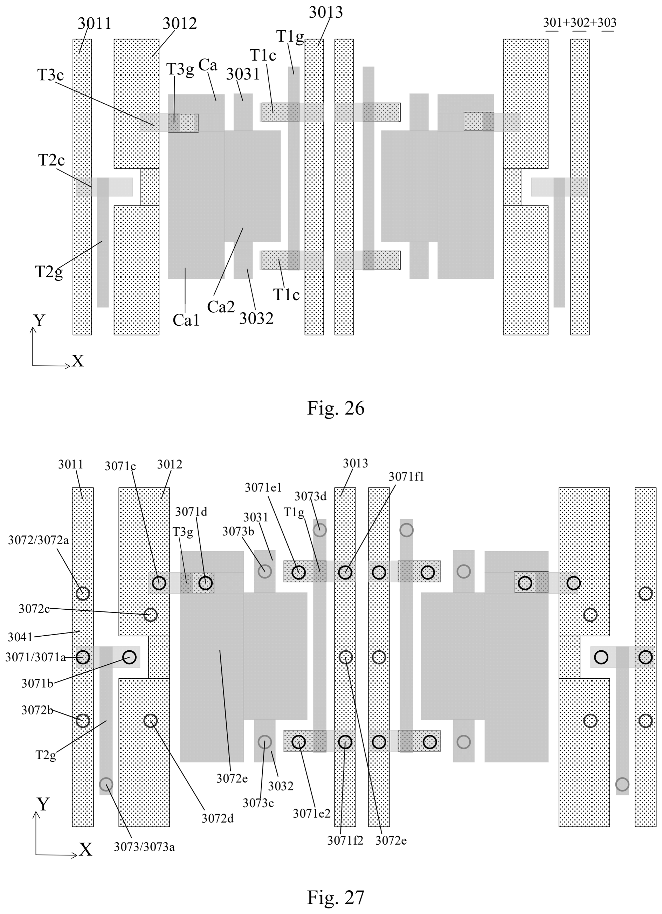

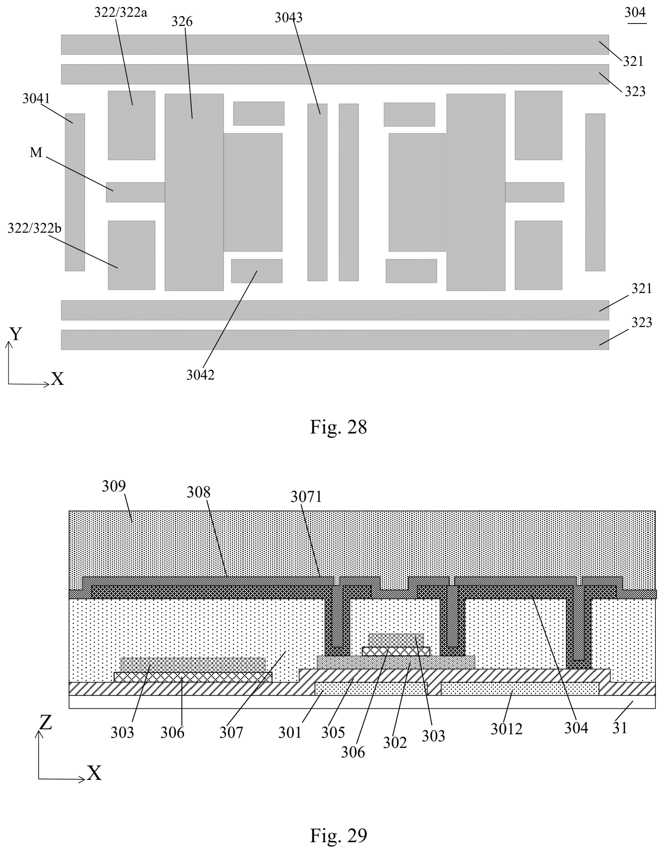

For example, Fig. 23 is a schematic planar view of a laminated layer of a first metal layer, an active layer, a second metal layer and a third metal layer included in another display panel provided by at least one embodiment of the present disclosure, Fig. 24 is a schematic planar view of a first metal layer included in the display panel in Fig. 23, Fig. 25 is a schematic planar view of a laminated layer of a first metal layer and an active layer included in the display panel in Fig. 23, Fig. 26 is a schematic planar view of a laminated layer of a first metal layer, an active layer and a second metal layer included in the display panel in Fig. 23, Fig. 27 is a schematic planar view of forming a via hole structure in the stacked structure shown in Fig. 26, and Fig. 28 is a schematic planar view of a third metal layer included in the display panel in Fig. 23.

For example, as shown in Fig. 23, the display panel 30 includes a base substrate 31 and a pixel circuit 32 arranged on the base substrate 31, the pixel circuit 32 includes a sensing transistor T2, a driving transistor T3, a switching transistor T1, a first gate line 321, a second gate line 323 and a storage capacitor Cst, and the first source-drain electrode T2a of the sensing transistor T2 and the first source-drain electrode T3a of the driving transistor T3 are electrically connected through a first connection electrode M; the first gate line 321 and the second gate line 323 both extend in the first direction X, in the second direction Y intersecting with the first direction X, spacers 322 are respectively arranged between the first connection electrode M and the first gate line 321, and between the first connection electrode M and the second gate line 323, and the first connection electrode M, the first gate line 321, the second gate line 323 and the spacers 322 are arranged in the same layer. The spacers 322 are arranged between the first connection electrode M and the first gate line 321, and between the first connection electrode M and the second gate line 323, and the first connection electrode M, the first gate line 321, the second gate line 323 and the spacers 322 are arranged in the same layer, so that the voltage change brought to the first connection electrode M when the first gate line 321 or the second gate line 323 generates voltage jump can be reduced, and further, the damage to the light emitting diode caused by the voltage change that occurs on the first connection electrode M can be reduced, so as to ensure the service life of the light emitting diode. The first source-drain electrode T1a of the switching transistor T1 and the gate electrode T3g of the driving transistor T3 are connected through the second connection electrode K, the first electrode plate Ca of the storage capacitor Cst is connected with the second connection electrode K, and the second electrode plate Cb of the storage capacitor Cst is connected with the first connection electrode M to form a whole pixel circuit.

For example, in Fig. 23, the spacer 322a and the spacer 322b that are located in the third metal layer 304 are respectively between the sensing transistor T2 and the first gate line 321, and between the sensing transistor T2 and the second gate line 323, the first gate line 321 and the second gate line 323 are respectively located on two sides of the sensing transistor T2 in the second direction Y, the spacer 322b can shield the coupling between the first source-drain electrode T2a of the sensing transistor T2 and the first gate line 321. The first source-drain electrode T2a of the sensing transistor T2 is located in the third metal layer 304, and the power supply voltage signal line 3012 is located in the first metal layer 301, the spacer 322b located in the third metal layer 304 and between the first gate line 321 and the sensing transistor T2 is electrically connected with the power supply voltage signal line 3012 located in the first metal layer 301 through the second via hole structure 3072d; the spacer 322a located in the third metal layer 304 and between the second gate line 323 and the sensing transistor T2 is electrically connected with the power supply voltage signal line 3012 located in the first metal layer 301 through the second via hole structure 3072c. The switching transistor T1 may reduce the coupling between the second connection electrode K and the first gate line 321 or the second gate line 323.

For example, in Fig. 23 and Fig. 24, the embodiment is described by taking pixel circuits corresponding to two sub-pixels arranged in the first direction X as an example. As shown in Fig. 23 and Fig. 24, the first metal layer 301 includes an initialization signal line 3011 and a power supply voltage signal line 3012, a first electrode plate Ca, a data line 3013 that extend in the second direction Y, and a light shielding part 3014. Both the initialization signal line 3011 and the data line 3013 are straight lines extending in the second direction Y. The power supply voltage signal line 3012 includes a first power supply voltage signal line 3012a extending in the second direction Y, the first power supply voltage signal line 3012a includes a first part 3012b, a second part 3012c and a third part 3012d that extend in the second direction Y and are connected in sequence, and the width of the first part 3012b and the width of the third part 3012d in the first direction X are equal, the width of the second part 3012c in the first direction X is smaller than that of the first part 3012b in the first direction X, and one end of the second part 3012c in the second direction Y is connected with the edge of the first part 3012b close to the third part 3012d and away from the initialization signal line, and the other end of the second part 3012c in the second direction Y is connected with the edge of the third part 3012d close to the first part 3012b and away from the initialization signal line 3011. The edge of the second part 3012c farthest from the initialization signal line 3011, the edge of the first part 3012b farthest from the initialization signal line 3011, and the edge of the third part 3012d farthest from the initialization signal line 3011 are all aligned and on a straight line, so a notch is formed between the second part 3012c and the initialization signal line 3011.

For example, in combination with Fig. 23 and Fig. 24, in the display panel shown in Fig. 23, a part of the first metal layer 301 below the first source-drain electrode T2a of the sensing transistor T2 is removed, so that parasitic capacitance can be reduced, that is, the power supply voltage signal line 3012 is narrowed at the positions corresponding to the first source-drain electrode T2a and the first connection electrode M of the sensing transistor T2, so that the overlapping area of the power supply voltage signal line 3012 and the first source-drain electrode T2a of the sensing transistor T2 can be reduced.

For example, with reference to Fig. 26, the first metal layer 301, the active layer 302 and the second metal layer 303 are stacked in sequence. The second metal layer 303 includes the gate electrode T2g of the sensing transistor T2, the gate electrode T3g of the driving transistor T3, the gate electrode T1g of the switching transistor T1 and the first electrode plate Ca, and the gate electrodes of the two switching transistors T1 constitute an integral structure. The gate electrode T2g of the sensing transistor T2 and the gate electrode T1g of the switching transistor T1 are both in a shape of a long strip extending in a direction parallel to the second direction Y, and the gate electrode T2g of the sensing transistor T2 extends from the channel region T2c of the sensing transistor T2 in a direction opposite to the second direction Y, and the gate electrode T1g of the switching transistor T1 extends from the channel region T1c of the switching transistor T1 below along the second direction Y. The gate electrode T3g of the driving transistor T3 and the first electrode plate Ca are formed as an integral structure. Referring to Fig. 23 and Fig. 26, the first electrode plate Ca includes a first electrode plate sub-block Ca1 and a second electrode plate sub-block Ca2 that are connected with each other, the second electrode plate sub-block Ca2 includes a first extension part 3031 and a second extension part 3032 that extend in the second direction Y, and the two second connection structures 3042 are respectively connected with the first extension part 3031 and the second extension part 3032. The orthographic projection of the first extension part 3031 on the base substrate 31 and the orthographic projection of the second extension part 3032 on the base substrate 31 both do not overlap with the orthographic projection of the first metal layer 301 on the base substrate 31.

For example, in Fig. 23, the first via hole structures 3071, the second via hole structures 3072 and the third via hole structures 3073 are shown, and the corresponding connection relationships of the first via hole structures 3071, the second via hole structures 3072 and the third via hole structures 3073 are described below. For example, eight first via hole structures 3071 (3071a, 3071b, 3073c, 3073d, 3071e1, 3071e2, 3071f1 and 3071f2), five second via hole structures 3072 (3072a, 3072b, 3072c, 3072d and 3072e) and four third via hole structures 3073 (3073a, 3073b, 3073c and 3073d) are shown in the position corresponding to one sub-pixel in Fig. 23.

For example, in combination with Fig. 23, Fig. 26 and Fig. 27, the eight first via hole structures 3071 correspond to the positions of two ends of the channel region T2c of the sensing transistor T2, two ends of the channel region T3c of the driving transistor T3 and two ends of the channel region T1c of the switching transistor T1, specifically, the first via hole structure 3071a and the first via hole structure 3071b respectively correspond to the positions of two ends of the channel region T2c of the sensing transistor T2; the first via hole structure 3071c and the first via hole structure 3071d respectively correspond to the positions of two ends of the channel region T3c of the driving transistor T3; the first via hole structure 3071e1 and the first via hole structure 3071f1 respectively correspond to the positions of two ends of the channel region T1c of one of the two switching transistors T1; the first via hole structure 3071e2 and the first via hole structure 3071f2 respectively correspond to the positions of two ends of the channel region T1c of the other switching transistor T1. The orthographic projection of the second via hole structure 3072a on the base substrate 31 and the orthographic projection of the second via hole structure 3072b on the base substrate 31 are located in the orthographic projection of the initialization signal line 3011 on the base substrate 31, and are respectively located on two sides of the orthographic projection of the channel region T2c of the sensing transistor T2 on the base substrate 31 in the second direction Y; the orthographic projection of the second via hole structure 3072c on the base substrate 31 and the orthographic projection of the second via hole structure 3072d on the base substrate 31 are located within the orthographic projection of the power supply voltage signal line 3012 on the base substrate 31, and are respectively located on two sides of the channel region T2c of the sensing transistor T2 in the second direction Y, that is, respectively corresponding to the first part 3012b and the third part 3012d included in the first power supply voltage signal line 3012a; the orthographic projection of the second via hole structure 3072e on the base substrate 31 is within the orthographic projection of the data line 3013 on the base substrate 31. The orthographic projection of the third via hole structure 3073a on the base substrate 31 is within the orthographic projection of the gate electrode T2g of the sensing transistor T2 on the base substrate 31; the orthographic projection of the third via hole structure 3073b on the base substrate 31 and the orthographic projection of the third via hole structure 3073c on the base substrate 31 are respectively within the orthographic projection of the first extension part 3031 on the base substrate 31 and the orthographic projection of the second extension part 3032 on the base substrate 31. The orthographic projection of the third via hole structure 3073d on the base substrate 31 is within the orthographic projection of the gate electrode T1g of the switching transistor T1 on the base substrate 31.

For example, with reference to Fig. 26 and Fig. 27, in the display panel shown in Fig. 23, the switching transistor T1 is implemented as two thin film transistors connected in parallel, one of the two thin film transistors is located close to the upper second gate line 323, and the other is located close to the lower first gate line 321, that is, the two thin film transistors are respectively arranged on two sides of the first connection electrode M in the second direction Y, and the length of a part of the second electrode plate sub-block Ca2 in the second direction Y is reduced, the above design can increase the channel width-length ratio and the driving current of the switching transistor T1, thus facilitating the driving of the high-resolution display panel and reducing the charging time.

For example, in the display panel shown in Fig. 23, a part of the first metal layer 301 under the first source-drain electrodes T1a of the two switching transistors T1 is removed, so that leakage current generated by coupling the first connection electrode M and the bottom gate electrode of the switching transistor T1can be prevented.

For example, in combination with Fig. 24 and Fig. 25, in the display panel shown in Fig. 23, there is no other structure except the light shielding portion 3014 between the power supply voltage signal line 3012 and the data line 3013. The light shielding part 3014 includes a light shielding part 3014a located below the channel region T3c of the driving transistor T3, a light shielding part 3014b located below the channel region T1c of the upper switching transistor T1, and a light shielding part 3014c located below the channel region T1c of the lower switching transistor T1.

For example, in the display panel shown in Fig. 23, other structures of the switching transistor T1 except the first source-drain electrode T1a are not covered by the third metal layer, so that the coupling effect between the switching transistor T1 and the first connection electrode M can be reduced.

For example, in combination with Fig. 23 to Fig. 28, in the display panel 30, the display panel 30 includes a first metal layer 301, an active layer 302, a second metal layer 303, and a third metal layer 304 which are sequentially stacked on a base substrate 31. Although the insulation layers are not directly shown in the planar view shown in Fig. 23 to Fig. 28, only the via hole structures represent the insulation layers, there is also an insulation layer structure between the adjacent conductive layers, and the via hole structures are arranged in the insulation layer structure, and the layer structures that need to be connected are connected through the via hole structures.

For example, as shown in Fig. 23 and Fig. 25, the first metal layer 301 and the active layer 302 are laminated, and the active layer 302 includes a channel region T2c of the sensing transistor T2, a channel region T3c of the driving transistor T3, and channel regions T1c of the two switching transistors T1. For example, in combination with Fig. 23 and Fig. 25, the orthographic projection of the channel region T2c of the sensing transistor T2 on the base substrate 31 and the orthographic projection of the initialization signal line 3011 on the base substrate 31 overlap with each other. The orthographic projection of the channel region T3c of the driving transistor T3 on the base substrate 31 overlaps with both the orthographic projection of the power supply voltage signal line 3012 on the base substrate 31 and the orthographic projection of the light shielding part 3014a on the base substrate 31. The orthographic projections of the channel regions T1c of the two switching transistors T1 on the base substrate 31 both overlap with the orthographic projection of the data line 3013 on the base substrate 31, and overlap with the orthographic projections of the light shielding part 3014b and the light shielding part 3014c on the base substrate 31, respectively.

For example, in combination with Fig. 28, in the display panel shown in Fig. 23, the third metal layer 304 includes the first connection electrode M, the spacers 322, the second gate line 323 and the first gate line 321 that are both in a shape of a long strip and extend in the first direction X, a first connection structure 3041 and a third connection structure 3043 both extending in the second direction Y, and two second connection structures 3042 extending in the first direction X. The orthographic projection of the first connection structure 3041 on the base substrate 31 is within the orthographic projection of the initialization signal line 3011 on the base substrate 31, and the orthographic projection of the third connection structure 3043 on the base substrate 31 is within the orthographic projection of the data line 3013 on the base substrate 31. The first connection electrode M is also in a shape of a long strip and extends in the first direction X. The first connection structure 3041, the second connection structure 3042 and the third connection structure 3043 are used to realize the connection between the third metal layer 304 and other layer structures. In the second direction Y, the spacer 322b is located between the first connection electrode M and the first gate line 321, so that the voltage change to the first connection electrode M caused by voltage jump of the first gate line 321 can be reduced, and the spacer 322a is located between the first connection electrode M and the second gate line 323, so that the voltage change to the first connection electrode M caused by voltage jump of the second gate line 323 can be reduced, and further the damage to the light emitting diode caused by the voltage change that occurs on the first connection electrode M can be reduced, so as to ensure the service life of the light emitting diode..

For example, Fig. 29 is a schematic view of the cross-sectional structure of the display panel in Fig. 23. As shown in Fig. 29, the display panel 30 further includes a buffer layer 305 disposed on the side of the first metal layer 301 away from the base substrate 31, a gate insulation layer 306 disposed between the active layer 302 and the second metal layer 303, an interlayer insulation layer 307 disposed between the second metal layer 303 and the third metal layer 304, and a passivation layer 308 and a planarization layer 309 that are disposed on a side of the third metal layer 304 away from the base substrate 31.

For example, in combination with Fig. 29, first via hole structures 3071 are provided in the interlayer insulation layer 307, and the third metal layer 304 is electrically connected with the active layer 302 through the first via hole structures 3071.

For example, as shown in Fig. 29, a storage capacitor is formed between the third metal layer 304 and the second metal layer 303. With reference to Fig. 23 and Fig. 29, the first source-drain electrode T1a of the switching transistor T1 and the first electrode plate Ca of the storage capacitor Cst are connected through the second connection electrode K, that is, the first source-drain electrodes T1a of the two switching transistors T1 are respectively connected with the first extension part 3031 and the second extension part 3032 that are included in the second electrode plate sub-block Ca2.

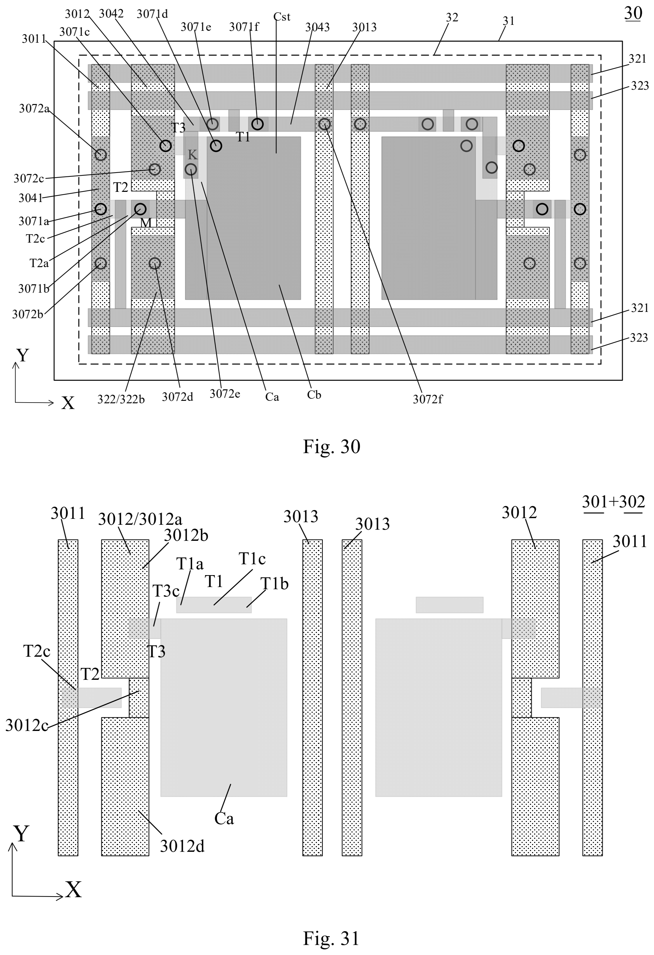

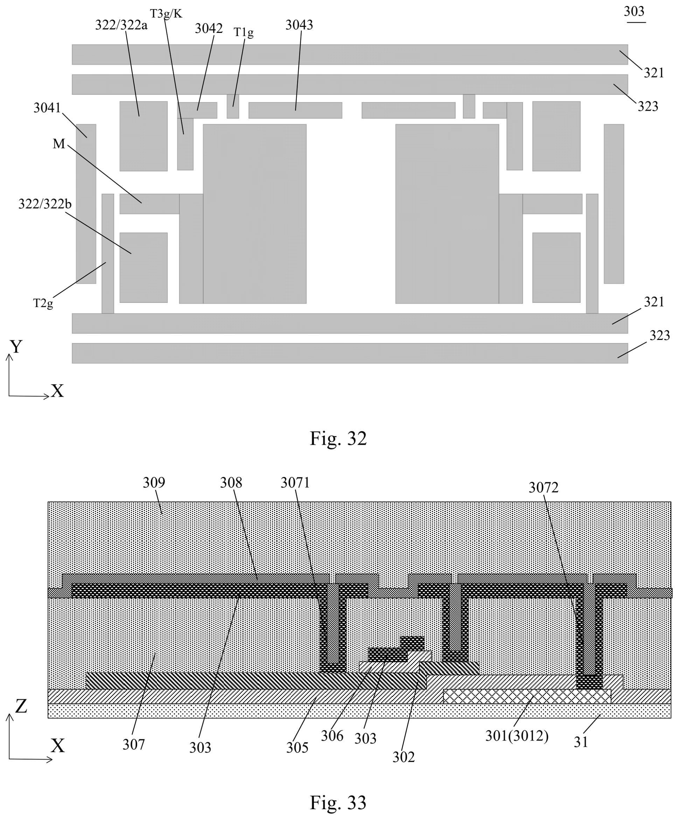

For example, Fig. 30 is a schematic planar view of a laminated layer of a first metal layer, an active layer and a second metal layer included in another display panel provided by at least one embodiment of the present disclosure, Fig. 31 is a schematic planar view of a laminated layer of a first metal layer and an active layer included in the display panel in Fig. 30, Fig. 32 is a schematic planar view of the second metal layer in Fig. 30, and Fig. 33 is a schematic cross-sectional view of the display panel in Fig. 30.

For example, as shown in Fig. 2 and Fig. 30, the display panel 30 includes a base substrate 31 and a pixel circuit 32 arranged on the base substrate 31. The pixel circuit 32 includes a sensing transistor T2, a driving transistor T3, a switching transistor T1, a first gate line 321, a second gate line 323 and a storage capacitor Cst, and the first source-drain electrode T2a of the sensing transistor T2 and the first source-drain electrode T3a of the driving transistor T3 are electrically connected through a first connection electrode M. The first gate line 321 and the second gate line 323 extend in the first direction X. In the second direction Y intersecting with the first direction X, the spacers 322 are respectively arranged between the first connection electrode M and the first gate line 321, and between the first connection electrode M and the second gate line 323, and the first connection electrode M, the first gate line 321, the second gate line 323 and the spacers 322 are arranged in the same layer. The spacers 322 are respectively arranged between the first connection electrode M and the first gate line 321, and between the first connection electrode M and the second gate line 323, and the first connection electrode M, the first gate line 321, the second gate line 323 and the spacers 322 are arranged in the same layer, so that the voltage change brought to the first connection electrode M when the first gate line 321 or the second gate line 323 generates voltage jump can be reduced, and further, the damage to the light emitting diode caused by the voltage change that occurs on the first connection electrode M can be reduced, so as to ensure the service life of the light emitting diode. The first source-drain electrode T1a of the switching transistor T1 and the gate electrode T3g of the driving transistor T3 are connected through the second connection electrode K, the first electrode plate Ca of the storage capacitor Cst is connected with the second connection electrode K, and the second electrode plate Cb of the storage capacitor Cst is connected with the first connection electrode M, to form a whole pixel circuit.

For example, in Fig. 30, the spacer 322a and the spacer 322b that are located in the third metal layer 304 are respectively between the sensing transistor T2 and the first gate line 321, and between the sensing transistor T2 and the second gate line 323, the first gate line 321 and the second gate line 323 are respectively located on two sides of the sensing transistor T2 in the second direction Y, the spacer 322b can shield the coupling between the first source-drain electrode T2a of the sensing transistor T2 and the first gate line 321. The first source-drain electrode T2a of the sensing transistor T2 is located in the second metal layer 303, and the power supply voltage signal line 3012 is located in the first metal layer 301, the spacer 322b located in the second metal layer 303 and between the first gate line 321 and the sensing transistor T2 is electrically connected with the power supply voltage signal line 3012 located in the first metal layer 301 through the second via hole structure 3072d; the spacer 322a located in the second metal layer 303 and between the second gate line 323 and the sensing transistor T2 is electrically connected to the power supply voltage signal line 3012 located in the first metal layer 301 through the second via hole structure 3072c. The switching transistor T1 may reduce the coupling between the second connection electrode K and the gate line (the first gate line 321 or the second gate line 323).

The storage capacitor Cst includes a first electrode plate Ca located in the active layer 302 and a second electrode plate Cb located in the second metal layer 303.

For example, in the display panel shown in Fig. 30, a part of the first metal layer 301 below the first source-drain electrode T2a of the sensing transistor T2 is removed, so that the parasitic capacitance can be reduced, that is, the power supply voltage signal line 3012 is narrowed at the positions corresponding to the first source-drain electrode T2a and the first connection electrode M of the sensing transistor T2, so that the overlapping area and the parasitic capacitance between the power supply voltage signal line 3012 and the first source-drain electrode T2a of the sensing transistor T2 can be reduced.

For example, in the display panel shown in Fig. 30, a part of the first metal layer 301 under the first source-drain electrode T1a, the channel region T1c and the second source-drain electrode T1b of the switching transistor T1 is removed, so that leakage current generated by coupling the first connection electrode M and the bottom gate electrode of the switching transistor T1 can be prevented.

For example, referring to Fig. 30 to Fig. 32, in the display panel 30, the display panel 30 includes a first metal layer 301, an active layer 302, and a second metal layer 303 which are sequentially stacked on a base substrate 31. Although the insulation layer is not directly shown in the planar view shown in Fig. 30 to Fig. 32, only the via hole structures represent the insulation layers, but there is also a layer structure that plays an insulating role between the above-mentioned adjacent conductive layers, and the layer structure that plays an insulating role is provided with the via hole structures, and the layer structures that need to be connected are connected through the via hole structures.

For example, in Fig. 30 and Fig. 31, the embodiment is described by taking pixel circuits corresponding to two sub-pixels arranged in the first direction X as an example. As shown in Fig. 30 and Fig. 31, the first metal layer 301 includes an initialization signal line 3011, a power supply voltage signal line 3012 and a data line 3013 that extend in the second direction Y. Both the initialization signal line 3011 and the data line 3013 are straight lines extending in the second direction Y. The power supply voltage signal line 3012 includes a first power supply voltage signal line 3012a extending in the second direction Y, the first power supply voltage signal line 3012a includes a first part 3012b, a second part 3012c and a third part 3012d that extend in the second direction Y and are connected in sequence, and the width of the first part 3012b in the first direction X and the width of the third part 3012d in the first direction X are equal, the width of the second part 3012c in the first direction X is smaller than the width of the first part 3012b in the first direction X, and one end of the second part 3012c in the second direction Y is connected with the edge of the first part 3012b close to the third part 3012d and away from the initialization signal line, and the other end of the second part 3012c in the second direction Y is connected with the edge of the third part 3012d close to the first part 3012b and away from the initialization signal line 3011. The edge of the second part 3012c farthest from the initialization signal line 3011, the edge of the first part 3012b farthest from the initialization signal line 3011 and the edge of the third part 3012d farthest from the initialization signal line 3011 are all aligned and on a straight line, so a notch is formed between the second part 3012c and the initialization signal line 3011.

For example, as shown in Fig. 30 and Fig. 31, the first metal layer 301 and the active layer 302 are stacked. The active layer 302 includes a channel region T2c of the sensing transistor T2, a channel region T3c of the driving transistor T3, a channel region T1c of the switching transistor T1 and a first electrode plate Ca of the storage capacitor Cst, and the channel region T3c of the driving transistor T3 and the first electrode plate Ca of the storage capacitor Cst constitute an integral structure. For example, in combination with Fig. 30 and Fig. 31, the orthographic projection of the channel region T2c of the sensing transistor T2 on the base substrate 31 and the orthographic projection of the initialization signal line 3011 on the base substrate 31 overlap with each other. The orthographic projection of the channel region T3c of the driving transistor T3 on the base substrate 31 and the orthographic projection of the power supply voltage signal line 3012 on the base substrate 31 overlap each other. For example, the edge of the first electrode plate Ca of the storage capacitor Cst close to the second gate line 321 extends in the first direction X to right above the power supply voltage signal line 3012.

For example, as shown in Fig. 32, the second metal layer 303 includes the gate electrode T2g of the sensing transistor T2, the gate electrode T3g of the driving transistor T3, the gate electrode T1g of the switching transistor T1, the second electrode plate Cb, the first connection electrode M, the spacers 322, the second gate line 323, the first gate line 321, the first connection structure 3041, the second connection structure 3042 and the third connection structure 3043. With reference to Fig. 30 and Fig. 32, the gate electrode T2g of the sensing transistor T2, the gate electrode T3g of the driving transistor T3 and the gate electrode T1g of the switching transistor T1 are all in a shape of a long strip extending in a direction parallel to the second direction Y, and the gate electrode T2g of the sensing transistor T2 extends from the channel region T2c of the sensing transistor T2 in a direction opposite to the second direction Y, and the gate electrode T1g of the switching transistor T1 extends from the channel region T1c of the switching transistor T1 in the second direction Y. The orthographic projection of the second electrode plate Cb on the base substrate 31 is within the orthographic projection of the first electrode plate Ca on the base substrate 31. The second gate line 323 and the first gate line 321 are both in a shape of a long strip and extend in the first direction X. The first connection electrode M is also in a shape of a long strip and extends in the first direction X. The first connection structure 3041 extends in the second direction Y, the second connection structure 3042 and the third connection structure 3043 both extend in the first direction X; the first connection structure 3041, the second connection structure 3042 and the third connection structure 3043 are used to realize the connection between the third metal layer 304 and other layer structures. In the second direction Y, the spacer 322b is located between the first connection electrode M and the first gate line 321, so that the voltage change to the first connection electrode M caused by voltage jump of the first gate line 321 can be reduced, and the spacer 322a is located between the first connection electrode M and the second gate line 323, so that the voltage change to the first connection electrode M caused by voltage jump of the second gate line 323 can be reduced, and further, the damage to the light emitting diode caused by the voltage change that occurs on the first connection electrode M can be reduced, so as to ensure the service life of the light emitting diode.

For example, in Fig. 30, the first via hole structures 3071 and the second via hole structures 3072 are shown, and the corresponding connection relationship between the first via hole structures 3071 and the second via hole structures 3072 is described below. For example, six first via hole structures 3071 (3071a, 3071b, 3071c, 3071d, 3071e, and 3071f) and six second via hole structures 3072 (3072a, 3072b, 3072c, 3072d, 3072e, and 3072f) are shown at the position corresponding to one sub-pixel in Fig. 30.

For example, in combination with Fig. 30 and Fig. 31, the six first via hole structures 3071 respectively correspond to the positions of two ends of the channel region T2c of the sensing transistor T2, the positions of two ends of the channel region T3c of the driving transistor T3, and the positions of two ends of the channel region T1c of the switching transistor T1, specifically, the first via hole structure 3071a and the first via hole structure 3071b respectively correspond to the positions of two ends of the channel region T2c of the sensing transistor T2; the first via hole structure 3071c and the first via hole structure 3071d respectively correspond to the positions of two ends of the channel region T3c of the driving transistor T3; the first via hole structure 3071e and the first via hole structure 3071f respectively correspond to the positions of two ends of the channel region T1c of the switching transistor T1. The orthographic projection of the second via hole structure 3072a on the base substrate 31 and the orthographic projection of the second via hole structure 3072b on the base substrate 31 are located in the orthographic projection of the initialization signal line 3011 on the base substrate 31, and are respectively located on two sides of the orthographic projection of the channel region T2c of the sensing transistor T2 on the base substrate 31 in the second direction Y; the orthographic projections of the second via hole structure 3072c and the second via hole structure 3072d on the base substrate 31 both are located within the orthographic projection of the power supply voltage signal line 3012 on the base substrate 31, and are respectively located on two sides of the channel region T2c of the sensing transistor T2 in the second direction Y, that is, respectively corresponding to the first part 3012b and the third part 3012d that are included in the first power supply voltage signal line 3012a; the orthographic projection of the second via hole structure 3072e on the base substrate 31 is within the orthographic projection of the first electrode plate Ca on the base substrate 31 and not within the orthographic projection of the second electrode plate Cb on the base substrate 31; the orthographic projection of the second via hole structure 3072f on the base substrate 31 is within the orthographic projection of the data line 3013 on the base substrate 31.

For example, with reference to Fig. 30 to Fig. 32, in the display panel 30, the channel region T2c of the sensing transistor T2 is electrically connected with the first connection structure 3041 through the first via hole structure 3071a, and is electrically connected with the first connection electrode M through the first via hole structure 3071b; the channel region T3c of the driving transistor T3 is electrically connected with the spacer 322a through the first via hole structure 3071c, and is electrically connected with the second electrode plate Cb through the first via hole structure 3071d. The channel region T1c of the switching transistor T1 is electrically connected with the second connection structure 3042 through the first via hole structure 3071e, and is electrically connected with the third connection structure 3043 through the first via hole structure 3071f.

For example, with reference to Fig. 30 to Fig. 32, in the display panel 30, the first connection structure 3041 is electrically connected with the initialization signal line 3011 located in the first metal layer 301 through the second via hole structure 3072a and the second via hole structure 3072b. The spacer 322a is electrically connected with the first part 3012b of the first power supply voltage signal line 3012a through the second via hole structure 3072c, and the spacer 322b is electrically connected with the third part 3012d of the first power supply voltage signal line 3012a through the second via hole structure 3072d. The second connection electrode K is electrically connected to the first electrode plate Ca through the second via hole structure 3072e. The third connection structure 3043 is electrically connected to the data line 3013 through the second via hole structure 3072f.

For example, with reference to Fig. 30 to Fig. 32, in this display panel 30, the gate electrode T2g of the sensing transistor T2 extends in the second direction Y to be directly electrically connected with the first gate line 321, or is integrally formed. The gate electrode T1g of the switching transistor T1 extends in the direction opposite to the second direction Y to be directly electrically connected with the second gate line 323, or integrally formed, and the first gate line 321 connected with the gate electrode T2g of the sensing transistor T2 and the second gate line 323 connected with the gate electrode T1g of the switching transistor T1 are located at different sides of the spacer 322 in the second direction Y.

For example, in combination with Fig. 30 to Fig. 32, the orthographic projection of the first connection structure 3041 on the base substrate 31 is within the orthographic projection of the initialization signal line 3011 on the base substrate 31, and both the orthographic projection of the third connection structure 3043 on the base substrate 31 and the orthographic projection of the second connection structure 3042 on the base substrate 31 do not overlap with the orthographic projection of the first metal layer 301 on the base substrate 31. The orthographic projections of the spacer 322a and the spacer 322b on the base substrate 31 are both within the orthographic projection of the power supply voltage signal line 3012 on the base substrate 31.

For example, in Fig. 30, the spacer 322a and the spacer 322b that are located in the third metal layer 304 are respectively between the sensing transistor T2 and the first gate line 321, and between the sensing transistor T2 and the second gate line 323, the first gate line 321 and the second gate line 323 are respectively located on two sides of the sensing transistor T2 in the second direction Y, the spacer 322b can shield the coupling between the first source-drain electrode T2a of the sensing transistor T2 and the first gate line 321, the first source-drain electrode T2a of the sensing transistor T2 is located in the second metal layer 303, and the power supply voltage signal line 3012 is located in the first metal layer 301, the spacer 322b located in the second metal layer 304 and between the first gate line 321 and the sensing transistor T2 is electrically connected with the power supply voltage signal line 3012 located in the first metal layer 301 through the second via hole structure 3072d; the spacer 322a located in the second metal layer 303 and between the second gate line 323 and the sensing transistor T2 is electrically connected to the power supply voltage signal line 3012 located in the first metal layer 301 through the second via hole structure 3072c.

It should be noted that the voltage change of the first connection electrode M will cause the voltage change of the second connection electrode K. In the data writing stage, it is hoped that the voltage of the first connection electrode M is more stable, but in the lighting stage, the voltage rise of the first connection electrode M is normal. In the lighting stage, the voltage rise of the second connection electrode K is caused by the voltage rise coupling of the first connection electrode M, at this time, it is regarded that a capacitor is between the second connection electrode K and the power supply voltage signal line 3012, and the storage capacitor Cst is also another capacitor. During the coupling process, there will be a capacitor voltage division, so the voltage rise of the second connection electrode K is not as high as that of the first connection electrode M. In the data writing stage, the voltage of the first connection electrode M is expected to be more stable, so the first connection electrode M is shielded by the spacers 322 to reduce the jump voltage. With the above design, the spacers 322 are arranged between the first connection electrode M and the first gate line 321, and the first connection electrode M is formed in the second metal layer 303, which is arranged in the same layer as the first gate line 321. Through the shielding effect of the spacers 322, the life of the organic light-emitting diode display device can be prolonged. The spacers 322 are arranged on both the two sides of the sensing transistor T2 and the first connection electrode M connected to the sensing transistor T2 in the second direction Y, which respectively shield the influence caused by the first gate line 321 and the second gate line 323 on the voltage change of the first connection electrode M, that is, the parasitic capacitance between the first gate line 321 and the first connection electrode M or the second gate line 323 and the first connection electrode M cannot be formed due to the existence of the spacers 322.

For example, in combination with Fig. 30, the orthographic projection of the first source-drain electrode T2a of the sensing transistor T2 on the base substrate 31 is spaced apart from the orthographic projection of the power supply voltage signal line 3012 on the base substrate 31, that is, the first source-drain electrode T2a of the sensing transistor T2 is at the notch between the second part 3012c and the initialization signal line 3011.

For example, in the schematic cross-sectional structure shown in Fig. 33, the display panel 30 further includes a buffer layer 305 arranged on the side of the first metal layer 301 away from the base substrate 31, a gate insulation layer 306 and an interlayer insulation layer 307 that are arranged between the active layer 302 and the second metal layer 303, and a passivation layer 308 and a planarization layer 309 that are arranged on the side of the second metal layer 303 away from the base substrate 31, the first via hole structures 3071 are arranged in the interlayer insulating layer 307, and the second metal layer 303 is electrically connected with the active layer 302 through the first via hole structures 3071; a second via hole structure 3072 passes through the interlayer insulating layer 307 and the buffer layer 305, and the second metal layer 303 is electrically connected to the power supply voltage signal line 3012 located in the first metal layer 301 through the second via hole structure 3072.

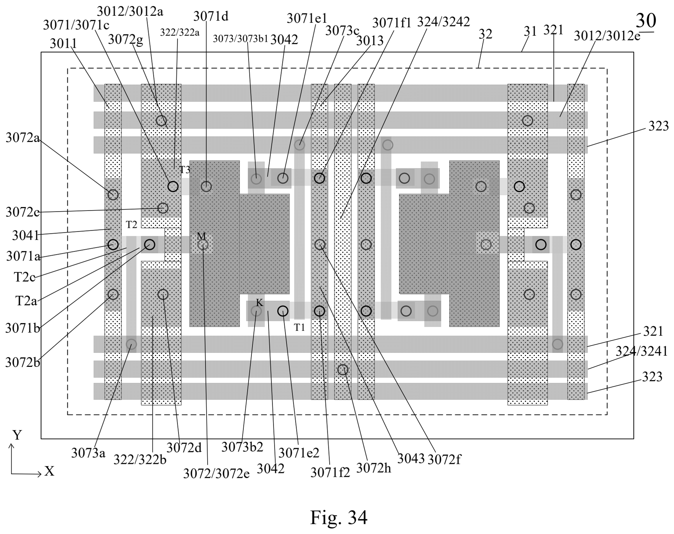

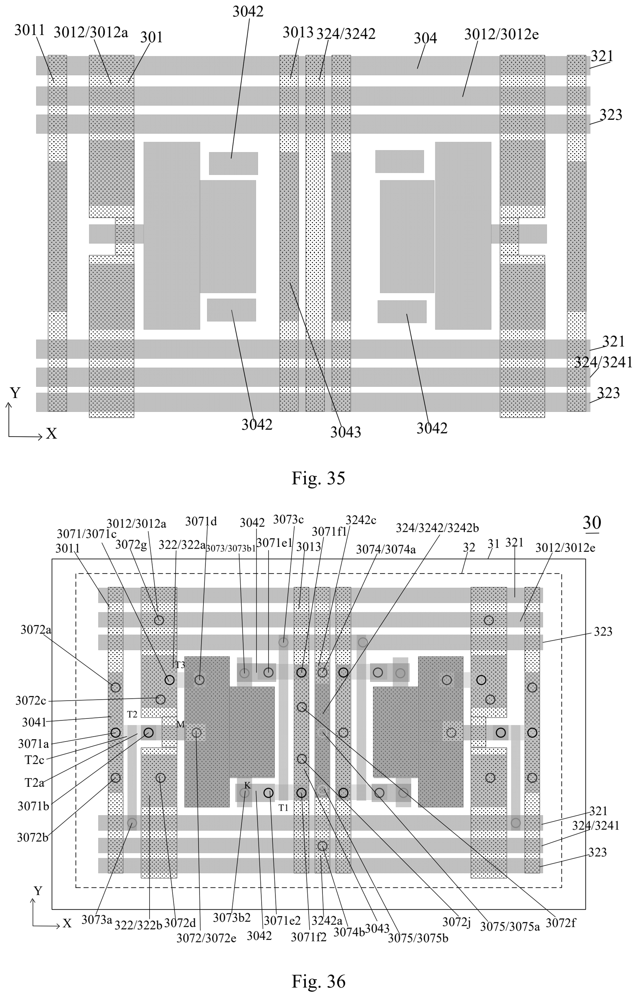

For example, Fig. 34 is a schematic planar view of a laminated layer of a first metal layer, an active layer, a second metal layer and a third metal layer provided by another display panel provided by at least one embodiment of the present disclosure, and Fig. 35 is a schematic planar view of a laminated layer of a first metal layer and a third metal layer included in the display panel in Fig. 34.

For example, in combination with Fig. 35, the display panel shown in Fig. 34 is different from the display panel shown in Fig. 14 in that the display panel shown in Fig. 34 further includes a cathode voltage trace 324, the cathode voltage trace 324 includes a first cathode voltage trace 3241 that is located between the first gate line 321 and the second gate line 323 and in the third metal layer 304, and the cathode voltage trace 324 extends in the first direction X. The cathode voltage trace 324 further includes a second cathode voltage trace 3242 which is in the first metal layer 301 and between two adjacent data lines 3013. For example, the first cathode voltage trace 3241 extending in the first direction X (transverse direction) and the second cathode voltage trace 3242 extending in the second direction Y (longitudinal direction) are intersected with each other and are electrically connected, which can reduce the voltage drop of large and medium-sized organic light-emitting diode display devices. In addition, the second cathode voltage trace 3242 is arranged between the two data lines 3013, which can also shield the crosstalk between data signals. The first cathode voltage trace 3241 is arranged between the first gate line 321 and the second gate line 323, and can also shield crosstalk between gate line signals.

For example, the display panel shown in Fig. 34 is different from the display panel shown in Fig. 14 in that the third metal layer 304 further includes a power supply voltage signal line 3012 extending in the first direction X, that is, the power supply voltage signal line 3012 further includes a second power supply voltage signal line 3012e extending in the transverse direction, and the second power supply voltage signal line 3012e intersects and is electrically connected with the first power supply voltage signal line 3012a, so that the voltage drop of the large and medium-sized organic light-emitting diode display devices can be reduced.

For example, the first via hole structures 3071, the second via hole structures 3072 and the third via hole structures 3073 are shown in Fig. 34. For example, eight first via hole structures 3071(3071a, 3071b, 3073c, 3071d, 3071e1, 3071e2, 3071f1 and 3071f2), eight second via hole structures 3072 (3072a, 3072b, 3072c, 3072d, 3072e, 3072f, 3072g and 3072h), and four third via hole structures 3073 (3073a, 3073b2, 3073b2 and 3073c) are shown in the position corresponding to one sub-pixel in Fig. 34.

For example, the display panel shown in Fig. 34 is different from the display panel shown in Fig. 14 in that two second via hole structures, namely, a second via hole structure 3072g and a second via hole structure 3072h, are added to the display panel shown in Fig. 34, and the layer structures connected by the other second via hole structures, the first via hole structures and the third via hole structures can be referred to the above-mentioned related descriptions about Fig. 14, which is not repeated here.

For example, in Fig. 34, the second power supply voltage signal line 3012e is electrically connected to the first power supply voltage signal line 3012a located in the first metal layer 301 through the second via hole structure 3072g. The first cathode voltage trace 3241 is electrically connected with the second cathode voltage trace 3242 located in the first metal layer 301 through the second via hole structure 3072h, which can further reduce the resistance between the first metal layer 301 and the third metal layer 304.

For example, the sensing transistor T2, the driving transistor T3, the switching transistor T1, the first gate line 321, the second gate line 323, the storage capacitor Cst, the first connection electrode M, the spacers 322, the second connection electrode K, the initialization signal line 3011, the power supply voltage signal line 3012, the first electrode plate Ca and the data line 3013 are shown in Fig. 35. The positional relationship of the channel region T2c of the sensing transistor T2, the channel region T3 of the driving transistor T3, the channel regions T1c of the two switching transistors T1, the gate electrode T2g of the sensing transistor T2, the gate electrode T3g of the driving transistor T3, the gate electrode T1g of the switching transistor T1 and the second electrode plate Cb, and so on can be referred to the above-mentioned descriptions about Fig. 14, which will not be repeated herein.

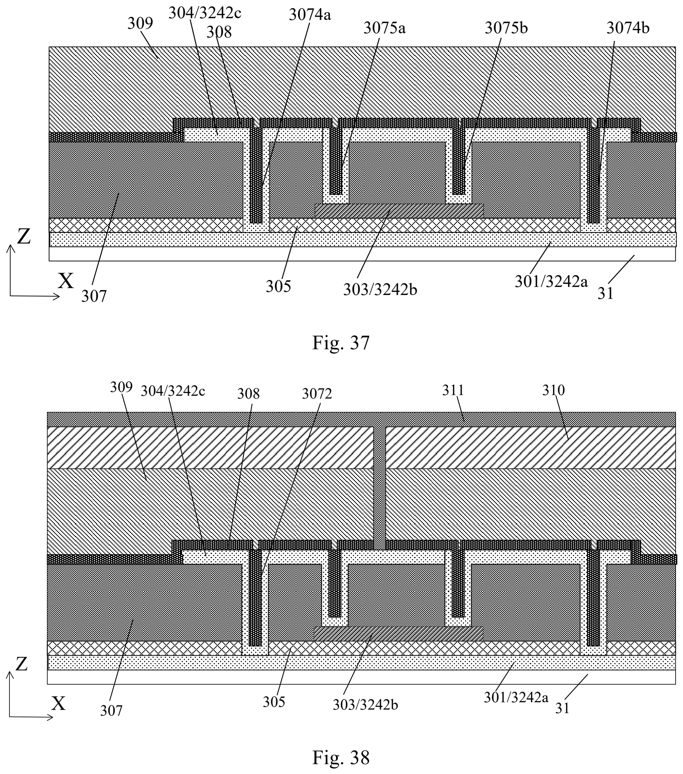

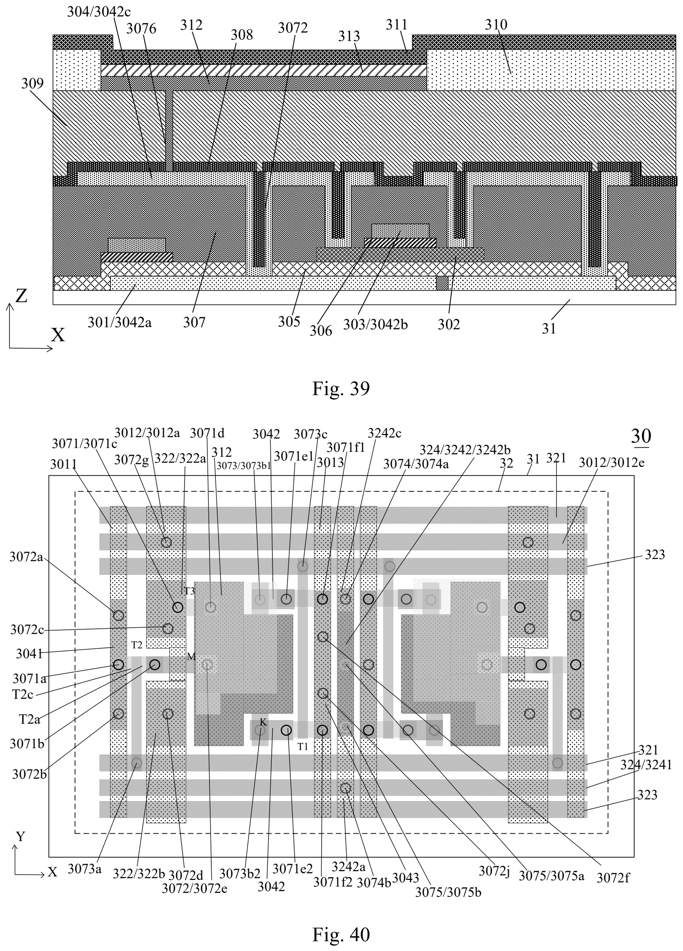

For example, Fig. 36 is a schematic planar view of a laminated layer of a first metal layer, an active layer, a second metal layer and a third metal layer included in another display panel provided by at least one embodiment of the present disclosure, Fig. 37 is a schematic cross-sectional view of the second cathode voltage trace of the display panel shown in Fig. 36 cutting along the second direction, Fig. 38 is a schematic cross-sectional view of the structure shown in Fig. 37 after adding a cathode and a pixel definition layer, Fig. 39 is a schematic cross-sectional view of the display panel shown in Fig. 36 after adding an organic light-emitting diode.

For example, the display panel shown in Fig. 36 is different from the display panel shown in Fig. 34 in that the first cathode voltage trace 3241 includes a three-layered structure. With reference to Fig. 36 and Fig. 37, the second cathode voltage trace 3242 includes a first sub-layer 3242a of the second cathode voltage trace located in the first metal layer 301, a second sub-layer 3242b of the second cathode voltage trace located in the second metal layer 303, and a third sub-layer 3242c of the second cathode voltage trace located in the third metal layer 304. The first sub-layer 3242a of the second cathode voltage trace and the third sub-layer 3242c of the second cathode voltage trace are electrically connected through the fourth via hole structure 3074, and the first sub-layer 3242a of the second cathode voltage trace and the third sub-layer 3242c of the second cathode voltage trace are electrically connected at two positions respectively through the fourth via hole structure 3074a and the fourth via hole structure 3074b. The second sub-layer 3242b of the second cathode voltage trace and the third sub-layer 3242c of the second cathode voltage trace are electrically connected through the fifth via hole structures 3075. The second sub-layer 3242b of the second cathode voltage trace and the third sub-layer 3241c of the second cathode voltage trace are electrically connected at two positions respectively through the fifth via hole structure 3075a and the fifth via hole structure 3075b, so that the resistance of the second cathode voltage trace can be reduced.

For example, the first via hole structures 3071, the second via hole structures 3072 and the third via hole structures 3073 are shown in Fig. 36. For example, eight first via hole structures 3071 (3071a, 3071b, 3071c, 3071d, 3071e1, 3071e2, 3071f1 and 3071f2), seven second via hole structures 3072 (3072a, 3074b, 3072c, 3072d, 3072e, 3072f, 3072g and 3072j), four third via hole structures 3073 (3073a, 3073b1, 3073b2 and 3073c), two fourth via structures 3074 (3074a and 3074b), two fifth via structures 3075 (3075a and 3075b) are shown at the positions corresponding to one sub-pixel in Fig. 36. Except for the fourth via hole structures 3074 and the fifth via hole structures 3075, the relationships between other via hole structures and layer structures can be found in the above-mentioned descriptions about Fig. 34, and will not be repeated herein.

For example, as shown in Fig. 39, the display panel also includes an organic light-emitting diode. For example, the organic light-emitting diode may be composed of three luminescent materials, R, G and B, deposited in the corresponding pixel region, or a luminescent material, such as blue OLED luminescent materials and devices combined with photoluminescent quantum dot materials. The organic light-emitting diode includes an anode 312, a light-emitting functional layer 313 and a cathode 311, and the light-emitting functional layer 313 is disposed in an opening region defined by the pixel definition layer 310. Any one selected from the group consisting of the first sub-layer 3242a of the second cathode voltage trace, the second sub-layer 3242b of the second cathode voltage trace and the third sub-layer 3242c of the second cathode voltage trace is electrically connected with the anode 312 through the sixth via hole structure 3076. For example, in the cross-sectional view shown in Fig. 39, the third sub-layer 3242c of the second cathode voltage trace is electrically connected with the anode 312 through the sixth via hole structure 3076, so that the anode can be reduced.

For example, as shown in Fig. 39, the display panel 30 further includes a buffer layer 305 disposed on the side of the first metal layer 301 away from the base substrate 31, and the buffer layer 305 is integrally formed on the base substrate 31, and a first sub-layer 3242a of the second cathode voltage trace is shown in the first metal layer 301. A gate insulation layer 306 is provided between the active layer 302 and the second metal layer 303, and an interlayer insulation layer 307 is provided between the second metal layer 303 and the third metal layer 304. A passivation layer 308, a planarization layer 309, and a pixel definition layer 310 are sequentially disposed on the side of the third metal layer 304 away from the base substrate 31. The interlayer insulation layer 307, the passivation layer 308 and the planarization layer 309 are all integrally formed.

For example, in Fig. 38, it is shown that the cathode 311 is directly electrically connected with the third metal layer 304, which can also reduce the step difference of the cathode.

For example, in the structure shown in Fig. 39, the material of the active layer 302 may be low-temperature polysilicon or oxide semiconductor, such as IGZO. The materials of the first metal layer 301, the second metal layer 303 and the third metal layer 304 may be metals such as copper, aluminum and molybdenum, or their alloys.

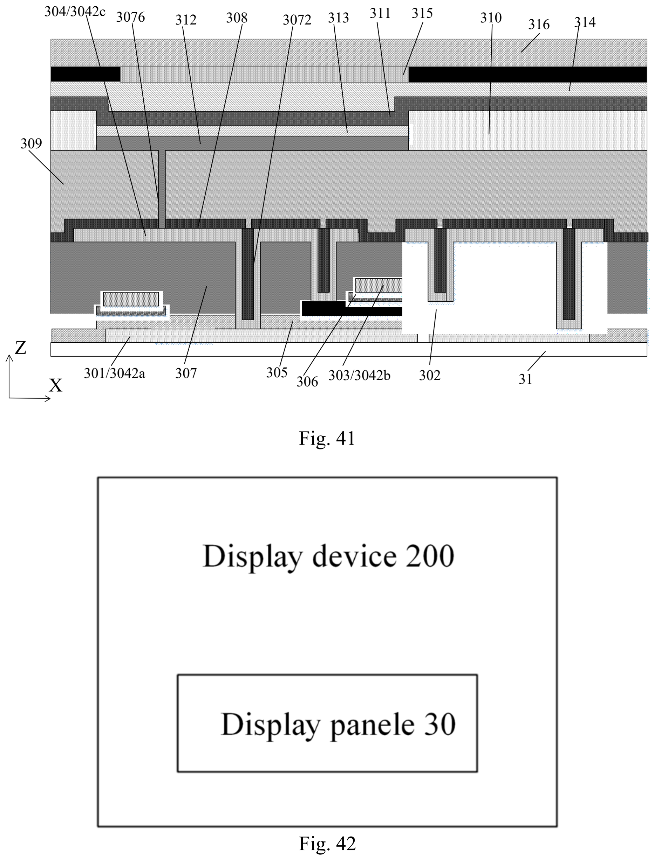

For example, Fig. 40 is a schematic planar view of a laminated layer of a first metal layer, an active layer, a second metal layer and a third metal layer included in another display panel provided by at least one embodiment of the present disclosure, and Fig. 41 is a schematic cross-sectional view of the display panel shown in Fig. 40. As shown in Fig. 40 and Fig. 41, the display panel further includes an encapsulation layer 314 disposed on an organic light-emitting diode, a quantum dot layer 315 disposed on the encapsulation layer 314, and a protection layer 316 arranged on a side of the quantum dot layer 315 away from the base substrate 31, the quantum dot layer 315 is configured to process the light emitted from the organic light-emitting diode to improve the purity of the emitted light and make the mixed light more uniform.

For example, other structures of the display panel shown in Fig. 40 can be referred to the relevant descriptions of the above embodiments, and will not be repeated here.

For example, Fig. 42 is a block diagram of a display device provided by at least one embodiment of the present disclosure. As shown in Fig. 42, the display device includes any one of the display panels described above, and the display device 200 includes the display panel 30. For example, the display panel 100 may be a display panel provided by any one of the embodiments of the present disclosure.

For example, the display device 200 may be a display device with a display function. For example, the display device 200 can be a display, an OLED display panel, an OLED TV, a liquid crystal display panel, an LCD TV, a QLED display panel, a QLED TV, electronic paper, a mobile phone, a tablet computer, a notebook computer, a digital photo frame, a navigator and any other products or components with display function and touch function.

The display panel and the display device provided by at least one embodiment of the present disclosure have at least one beneficial technical effect as follows:

(1) In the display panel provided by at least one embodiment of the present disclosure, the spacers that are located in the third metal layer are respectively between the sensing transistor and the first gate line, and between the sensing transistor and the second gate line, the first gate line and the second gate line are respectively located on two sides of the sensing transistor in the second direction, which can shield the coupling between the first source-drain electrode of the sensing transistor and the first gate line.

(2) In the display panel provided by at least one embodiment of the present disclosure, the switching transistor is implemented as two thin film transistors connected in parallel, one of which is located close to the second gate line on the upper side and the other is located close to the first gate line on the lower side, that is, respectively arranged on two sides of the first connection electrode in the second direction. Moreover, the length of a part of the first electrode plate of the storage capacitor in the second direction is reduced, and this design can increase the channel width-length ratio and the driving current of the switching transistor, therefore, the driving of the high-resolution display panel is facilitated, and the charging time is reduced.

(3) In the display panel provided by at least one embodiment of the present disclosure, a part of the first metal layer below the first source-drain electrode of the sensing transistor is removed, so that the parasitic capacitance can be reduced, that is, the power supply voltage signal line is narrowed at the positions corresponding to the first source-drain electrode and the first connection electrode of the sensing transistor, so that the overlapping area and the parasitic capacitance of the power supply voltage signal line and the first source-drain electrode of the sensing transistor can be reduced.

(4) In the display panel provided by at least one embodiment of the present disclosure, the second cathode voltage trace includes a first sub-layer of the second cathode voltage trace located in the first metal layer, a second sub-layer of the second cathode voltage trace located in the second metal layer, and a third sub-layer of the second cathode voltage trace located in the third metal layer, so that the resistance can be reduced, and any one selected from the group consisting of the first sub-layer of the second cathode voltage trace, the second sub-layer of the second cathode voltage trace and the third sub-layer of the second cathode voltage trace is electrically connected with the anode through the sixth via hole structure, thereby the step difference of the anode can be reduced.

The following points need to be explained:

(1) The drawings of the embodiment of the present disclosure only relate to the structure related to the embodiment of the present disclosure, and other structures can refer to the general design.
(2) For the sake of clarity, in the drawings used to describe the embodiments of the present disclosure, the thickness of layers or regions is enlarged or reduced, that is, these drawings are not drawn to actual scale.
(3) In the case of no conflict, the embodiments of the present disclosure and the features in the embodiments can be combined with each other to obtain a new embodiment.

The above is only the specific implementation of the present disclosure, but the scope of protection of the present disclosure is not limited thereto, and the scope of protection of the present disclosure should be subject to the scope of protection of the claims.

## Claims

1. A display panel comprising:

   a base substrate;
   a pixel circuit, arranged on the base substrate, wherein the pixel circuit comprises a sensing transistor, a driving transistor, a first gate line and a second gate line, wherein
   a first source-drain electrode of the sensing transistor and a first source-drain electrode of the driving transistor are electrically connected through a first connection electrode;
   the first gate line and the second gate line extend in a first direction, in a second direction intersecting with the first direction, and spacers are arranged between the first connection electrode and the first gate line and between the first connection electrode and the second gate line, and the first connection electrode, the first gate line, the second gate line and the spacers are arranged in a same layer.

2. The display panel according to claim 1, further comprising a switching transistor and a storage capacitor that are arranged on the base substrate, wherein a first source-drain electrode of the switching transistor and a gate electrode of the driving transistor are connected through a second connection electrode, a first electrode plate of the storage capacitor is connected with the second connection electrode, and a second electrode plate of the storage capacitor is connected with the first connection electrode.

3. The display panel according to claim 2, further comprising a first metal layer, an active layer, a second metal layer and a third metal layer that are sequentially stacked on the base substrate, wherein

   the first metal layer comprises an initialization signal line extending in the second direction, a power supply voltage signal line at least partially extending in the second direction, the first electrode plate and a data line;
   the active layer comprises a channel region of the sensing transistor, a channel region of the driving transistor and a channel region of the switching transistor;
   the second metal layer comprises a gate electrode of the sensing transistor, the gate electrode of the driving transistor, a gate electrode of the switching transistor and the second electrode plate;
   the third metal layer comprises the first connection electrode, the spacers, the second gate line and the first gate line that extend in the first direction.

4. The display panel according to claim 3, wherein the gate electrode of the sensing transistor extends in the second direction to be electrically connected with the first gate line, the gate electrode of the switching transistor extends in a direction opposite to the second direction to be electrically connected with the second gate line, and the first gate line connected with the gate electrode of the sensing transistor and the second gate line connected with the gate electrode of the switching transistor are on different sides of any one of the spacers in the second direction.

5. The display panel according to claim 3, wherein the third metal layer further comprises a first connection structure, a second connection structure and a third connection structure that extend in the second direction, an orthographic projection of the first connection structure on the base substrate is within an orthographic projection of the initialization signal line on the base substrate, an orthographic projection of the second connection structure on the base substrate is within an orthographic projection of the first electrode plate on the base substrate, and an orthographic projection of the third connection structure on the base substrate is within an orthographic projection of the data line on the base substrate.

6. The display panel according to claim 5, further comprising a buffer layer arranged on a side of the first metal layer away from the base substrate, a gate insulation layer arranged between the active layer and the second metal layer, an interlayer insulation layer arranged between the second metal layer and the third metal layer, and a passivation layer and a planarization layer that are arranged on a side of the third metal layer away from the base substrate.

7. The display panel according to claim 6, wherein a first via hole structure and a third via hole structure are arranged in the interlayer insulation layer, the third metal layer is electrically connected with the active layer through the first via hole structure, and the third metal layer is electrically connected with the second metal layer through the third via hole structure; a second via hole structure penetrates through the interlayer insulation layer and the buffer layer, and the third metal layer is electrically connected with the first metal layer through the second via hole structure.

8. The display panel according to claim 7, wherein the first connection structure is electrically connected with the initialization signal line through the second via hole structure, and is electrically connected with a second source-drain electrode of the sensing transistor through the first via hole structure; the second connection structure is electrically connected with the first source-drain electrode of the switching transistor through the first via hole structure, and is electrically connected with the second electrode plate through the third via hole structure; the third connection structure is electrically connected with the data line through the second via hole structure, and is electrically connected with a second source-drain electrode of the switching transistor through the first via hole structure.

9. The display panel according to any one of claims 4 to 8, wherein at least a part of the third metal layer overlaps with both the first metal layer and the second metal layer to form the storage capacitor between the first metal layer and the second metal layer, and form a capacitor structure between the second metal layer and the third metal layer.

10. The display panel according to claim 3, wherein an orthographic projection of the first source-drain electrode of the sensing transistor on the base substrate overlaps with an orthographic projection of the power supply voltage signal line on the base substrate.

11. The display panel according to claim 3, wherein the power supply voltage signal line comprises a first power supply voltage signal line extending in the second direction, the first power supply voltage signal line comprises a first part, a second part and a third part that extend in the second direction and are connected in sequence, and a width of the first part in the first direction and a width of the third part in the first direction are equal, a width of the second part in the first direction is smaller than a width of the first part in the first direction, and one end of the second part in the second direction is connected with an edge of the first part close to the third part and away from the initialization signal line, and other one end of the second part in the second direction is connected with an edge of the third part close to the first part and away from the initialization signal line.

12. The display panel according to claim 11, wherein an orthographic projection of the first source-drain electrode of the sensing transistor on the base substrate is spaced apart from an orthographic projection of the second part of the power voltage signal line on the base substrate.

13. The display panel according to claim 11, wherein the first electrode plate comprises a first electrode plate sub-block and a second electrode plate sub-block that are connected with each other in the first direction, and the second metal layer comprises a first extension part and a second extension part that extend from a part of the second electrode plate corresponding to the second electrode plate sub-block in the second direction, and two of the second connection electrodes are connected with the first extension part and the second extension part respectively.

14. The display panel according to claim 13, further comprising an organic light-emitting diode, wherein $\dfrac{W_g \times l_c \times THK_{ILD}}{A_{st} \times d_{gc}} \geq 0.013$ , $A_{st}$ is an area of the storage capacitor, $d_{gc}$ is a minimum spacing between the first gate line and the storage capacitor, $L_c$ is a length of an edge of the first electrode sub-block adjacent to the first gate line, $W_g$ is a width of the first gate line in the second direction, and $THK_{ILD}$ is a thickness of the interlayer insulation layer corresponding to the storage capacitor.

15. The display panel according to claim 14, wherein $\dfrac{W_g \times l_c \times THK_{ILD} \times (V_{gON} - V_{gOFF})}{A_{st} \times d_{gc}} \times \dfrac{10^\gamma}{V_{oled}} \geq 3.14$ , $V_{gON}$ is a turn-on voltage of the second gate line, $V_{gOFF}$ is a turn-off voltage of the second gate line, $V_{oled}$ is a voltage across two ends of the organic light-emitting diode, and $\gamma$ is an optical constant.

16. The display panel according to claim 15, wherein the storage capacitor is a three-layer structure formed by the first metal layer, the second metal layer and the third metal layer, $\dfrac{W_g \times l_c}{A_{st} \times d_{gc} \times \left(\frac{1}{THK_{ILD}} + \frac{1}{THK_{BUF}}\right)} \geq 0.006$ , $THK_{BUF}$ is a thickness of the buffer layer between the first metal layer and the second metal layer in the storage capacitor.

17. The display panel according to claim 16, wherein $\dfrac{W_g \times l_c \times (V_{gON} - V_{gOFF})}{A_{st} \times d_{gc} \times \left(\frac{1}{THK_{ILD}} + \frac{1}{THK_{BUF}}\right)} \times \dfrac{10^\gamma}{V_{oled}} \geq 1.5$ .

18. The display panel according to any one of claims 14 to 17, wherein $\dfrac{d_{gd} + W_{DD} + d_{sd}}{d_{gd}} \leq 8.25$ , $W_{DD}$ is a length in the second direction of the spacer between the first gate line and the first connection electrode, $d_{gd}$ is a minimum distance between the first gate line and the spacer between the first gate line and the first connection electrode, and $d_{sd}$ is a minimum distance between the first connection electrode and the spacer which is between the first gate line and the first connection electrode.

19. The display panel according to any one of claims 14 to 17, wherein $R_l = \dfrac{L_c}{L_p} \leq 0.5$ , $L_c$ is a length of an edge of the first electrode plate sub-block adjacent to the first gate line, $L_p$ is a sum of a length of the first electrode plate sub-block in the first direction and a length of the second electrode plate sub-block in the first direction, and $R_l$ is a ratio of the length of the edge of the first electrode plate sub-block adjacent to the first gate line to the sum of the length of the first electrode plate sub-block in the first direction and the length of the second electrode plate sub-block in the first direction.

20. The display panel according to any one of claims 14 to 17, wherein $\dfrac{W_c \times d_{gc}}{Pitch \times Pitch} \leq 0.005$ , $Wc$ is a width of the storage capacitor in the first direction, and *Pitch* is a width of one sub-pixel in the first direction.

21. The display panel according to claim 2, further comprising a first metal layer, an active layer and a second metal layer that are sequentially stacked on the base substrate, wherein

the first metal layer comprises an initialization signal line extending in the second direction, a power supply voltage signal line at least partially extending in the second direction, the first electrode plate and a data line;
the active layer comprises a channel region of the sensing transistor, a channel region of the driving transistor and a channel region of the switching transistor;
the second metal layer comprises a gate electrode of the sensing transistor, the gate electrode of the driving transistor, a gate electrode of the switching transistor, the second electrode plate, the first connection electrode, the spacers, the second gate line and the first gate line that extend in the first direction.

22. The display panel according to claim 21, wherein the gate electrode of the switching transistor is electrically connected with the second gate line, the gate electrode of the sensing transistor is electrically connected with the first gate line, and the second gate line connected with the gate electrode of the switching transistor and the first gate line connected with the gate electrode of the sensing transistor are located at different sides of the first electrode plate in the second direction, and in the second direction, the second connection electrode is between the first connection electrode and the second gate line connected to the gate electrode of the switching transistor.

23. The display panel according to claim 1, further comprising a switching transistor disposed on the base substrate, wherein a first source-drain electrode of the switching transistor and a gate electrode of the driving transistor are connected through a second connection electrode.

24. The display panel according to claim 23, further comprising a first metal layer, an active layer, a second metal layer and a third metal layer that are sequentially stacked on the base substrate, wherein

    the first metal layer comprises an initialization signal line, a power supply voltage signal line and a data line that extend in the second direction, and a light shielding part;
    the active layer comprises a channel region of the sensing transistor, a channel region of the driving transistor and a channel region of the switching transistor;
    the second metal layer comprises a gate electrode of the sensing transistor, a gate electrode of the driving transistor and a gate electrode of the switching transistor;
    the third metal layer comprises the first connection electrode, the spacers, the second gate line and the first gate line that extend in the first direction.

25. The display panel according to claim 24, wherein the third metal layer further comprises a first connection structure and a second connection structure that extend in the second direction, an orthographic projection of the first connection structure on the base substrate is within an orthographic projection of the initialization signal line on the base substrate, and an orthographic projection of the second connection structure on the base substrate is within an orthographic projection of the data line on the base substrate.

26. The display panel according to claim 25, further comprising a buffer layer arranged on a side of the first metal layer away from the base substrate, a gate insulation layer arranged between the active layer and the second metal layer, an interlayer insulation layer arranged between the second metal layer and the third metal layer, and a passivation layer and a planarization layer that are arranged on a side of the third metal layer away from the base substrate.

27. The display panel according to claim 26, wherein a first via hole structure is provided in the interlayer insulation layer, and the third metal layer is electrically connected with the active layer through the first via hole structure; a second via hole structure penetrates through the interlayer insulation layer and the buffer layer, and the third metal layer is electrically connected with the power supply voltage signal line through the second via hole structure.

28. The display panel according to any one of claims 25 to 27, wherein a storage capacitor is formed between the third metal layer and the second metal layer.

29. The display panel according to claim 1, further comprising a switching transistor and a storage capacitor arranged on the base substrate, wherein a first source-drain electrode of the switching transistor and a first electrode plate of the storage capacitor are connected through a second connection electrode.

30. The display panel according to claim 29, further comprising a first metal layer, an active layer and a second metal layer that are sequentially stacked on the base substrate, wherein the first metal layer comprises an initialization signal line, a power supply voltage signal line and a data line that extend in the second direction; the active layer comprises a channel region of the sensing transistor, a channel region of the driving transistor, a channel region of the switching transistor and the first electrode plate; the second metal layer includes a gate electrode of the sensing transistor, a gate electrode of the driving transistor and a gate electrode of the switching transistor, the first connection electrode, the spacers, a second electrode plate of the storage capacitor, the second gate line and the first gate line that extend in the first direction.

31. The display panel according to claim 30, wherein an edge of the first electrode plate of the storage capacitor close to the second gate line extends in the first direction to right above the power supply voltage signal line.

32. The display panel according to claim 30, wherein the second metal layer further comprises a first connection structure extending in the second direction, and an orthographic projection of the first connection structure on the base substrate is within an orthographic projection of the initialization signal line on the base substrate.

33. The display panel according to claim 32, further comprising a buffer layer arranged on a side of the first metal layer away from the base substrate, a gate insulation layer and an interlayer insulation layer that are arranged between the active layer and the second metal layer, and a passivation layer and a planarization layer that are arranged on a side of the second metal layer away from the base substrate, wherein a first via hole structure is arranged in the interlayer insulation layer, and the second metal layer is electrically connected with the active layer through the first via hole structure; a second via hole structure penetrates through the interlayer insulation layer and the buffer layer, and the second metal layer is electrically connected with the power supply voltage signal line through the second via hole structure.

34. The display panel according to claim 11, further comprising a cathode voltage trace, wherein the cathode voltage trace comprises a first cathode voltage trace extending in the first direction and a second cathode voltage trace extending in the second direction, and the first cathode voltage trace intersects the second cathode voltage trace; the power supply voltage signal line further comprises a second power supply voltage signal line extending in the first direction, and the first power supply voltage signal line intersects the second power supply voltage signal line.

35. The display panel according to claim 34, wherein the second cathode voltage trace comprises a three-layer laminated structure, and the second cathode voltage trace comprises a first sub-layer of the second cathode voltage trace located in the first metal layer, a second sub-layer of the second cathode voltage trace located in the second metal layer, and a third sub-layer of the second cathode voltage trace located in the third metal layer, the first sub-layer of the second cathode voltage trace and the third sub-layer of the second cathode voltage trace are electrically connected through a fourth via hole structure, and the second sub-layer of the second cathode voltage trace and the third sub-layer of the second cathode voltage trace are electrically connected through a fifth via hole structure.

36. The display panel according to claim 35, further comprising an organic light-emitting diode, wherein the organic light-emitting diode comprises an anode, and any one selected from a group consisting of the first sub-layer of the second cathode voltage trace, the second sub-layer of the second cathode voltage trace and the third sub-layer of the second cathode voltage trace is electrically connected with the anode through a sixth via hole structure.

37. The display panel according to claim 36, wherein the third sub-layer of the first cathode voltage trace is electrically connected with the anode through the sixth via hole structure.

38. The display panel according to claim 37, further comprising an encapsulation layer arranged on the organic light-emitting diode and a quantum dot layer arranged on the encapsulation layer, wherein the quantum dot layer is configured to process light emitted from the organic light-emitting diode.

39. A display device, comprising the display panel according to any one of claims 1 to 38.

<u>10</u>

Fig. 1

Fig. 2

G1

G2

DT

1    2

Fig. 3

G1

G2

DT

Vs

Fig. 4

G1

G2

Fig. 5

20

T3b  T1a

T3

T1

N1

T2

N3

Y
X

T2a    T3a

201

Fig. 6

3011     3012          3013     3013          3012     3011

Ca          Ca

Y
X

301

Fig. 7

$\underline{301}+\underline{302}$

3011  3012      3013   3013      3012   3011

T3c   Ca           Ca

T2c

T1c

Y
X

Fig. 8

$\underline{301}+\underline{302}+\underline{303}$

3011  3012   T3g  T1g  3013

T3c  Ca

T2c

T1c

Cb

T2g

Y
X

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

303

321
323
322/322a
T3g 3042 T1g 3043
3041
M
K
322/322b
T2g
321
323

Y
X

Fig. 22

3011
3012/3012a
3071e 322/322a 3071d 326 3073b 3042 3071e1 3073d 3013 3071f1 32 31 30
321
323
3072a
3072e
T3
3041
T2
3071a M
T2c
T2a
3071b
3072b K
3073a T1
321
323

Y
X
322/322b 3072d Cst 3073c 3042 3071e2 3071f2 3043 3072e

Fig. 23

3011

3012/3012a

3013

3014/3014b

3014/3014a

3012c

3014/3014c

3012d

301

Y

X

Fig. 24

3011

3012/3012a

3012b

T3c

3014/3014a

T1c

3013

3014/3014b

T2c

3012c

3014/3014c

3012d

T1c

301+302

Y

X

Fig. 25

Fig. 26

Fig. 27

322/322a    326    3043    304

3041

M

322/322b    321    323

Y

X    3042    321    323

Fig. 28

309    308    3071

Z

X    303    306    307    301    305    302    303    3012    304    31

306

Fig. 29

Fig. 30

Fig. 31

_303_

322/322a T3g/K 3042 T1g 3043

3041

M

322/322b

T2g

321

323

321

323

Y

X

Fig. 32

309 308 3071 3072

Z

X

307 303 305 306 303 301(3012) 31

302

Fig. 33

Fig. 34

Fig. 35

Fig. 36

309    304/3242c    3074a    3075a    3075b    3074b
       308

Z
X
   307         305    303/3242b    301/3242a    31

Fig. 37

309    304/3242c    308    3072    311    310

Z
X
   307         305    303/3242b    301/3242a    31

Fig. 38

Fig. 39

Fig. 40

Fig. 41

Display device 200

Display panele 30

Fig. 42

# EP 4 730 969 A1

## INTERNATIONAL SEARCH REPORT

| | International application No. |
|---|---|
| | **PCT/CN2024/094893** |

| A. | CLASSIFICATION OF SUBJECT MATTER |
|---|---|

H10K59/12(2023.01)i; H10K59/121(2023.01)i; H10K59/131(2023.01)i; H10K59/123(2023.01)i

According to International Patent Classification (IPC) or to both national classification and IPC

| B. | FIELDS SEARCHED |
|---|---|

Minimum documentation searched (classification system followed by classification symbols)

IPC: H10K, H01L

Documentation searched other than minimum documentation to the extent that such documents are included in the fields searched

Electronic data base consulted during the international search (name of data base and, where practicable, search terms used)

CNTXT; ENTXTC; WPABS; DWPI; CNKI; ENTXT: 显示面板, 感应, 感测, 驱动, 晶体管, 栅线, 栅极线, 源, 漏, 电极, 间隔, 隔离, 屏蔽, display panel, sens+, driv+, transistor, gate line, GL, source, drain, electrode, spac+, isolat+, shield+

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 116437727 A (BEIJING BOE TECHNOLOGY DEVELOPMENT CO., LTD. et al.) 14 July 2023 (2023-07-14)<br>claims 1-39 | 1-39 |
| A | KR 20190066205 A (LG DISPLAY CO., LTD.) 13 June 2019 (2019-06-13)<br>description, paragraphs 1-75, and figures 1-11 | 1-39 |
| A | CN 112885850 A (HEFEI BOE ZHUOYIN TECHNOLOGY CO., LTD. et al.) 01 June 2021 (2021-06-01)<br>entire document | 1-39 |
| A | CN 114127836 A (BOE TECHNOLOGY GROUP CO., LTD. et al.) 01 March 2022 (2022-03-01)<br>entire document | 1-39 |
| A | CN 115768186 A (BOE TECHNOLOGY GROUP CO., LTD.) 07 March 2023 (2023-03-07)<br>entire document | 1-39 |
| A | KR 20090100185 A (SAMSUNG ELECTRONICS CO., LTD.) 23 September 2009 (2009-09-23)<br>entire document | 1-39 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **24 July 2024** | **08 August 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/094893**

| Patent document cited in search report | | | Publication date (day/month/year) | Patent family member(s) | | | Publication date (day/month/year) |
|---|---|---|---|---|---|---|---|
| CN | 116437727 | A | 14 July 2023 | CN | 116437727 | B | 07 November 2023 |
| KR | 20190066205 | A | 13 June 2019 | KR | 102612371 | B1 | 08 December 2023 |
| CN | 112885850 | A | 01 June 2021 | CN | 112885850 | B | 05 April 2024 |
| CN | 114127836 | A | 01 March 2022 | CN | 114127836 | B | 19 March 2024 |
| CN | 115768186 | A | 07 March 2023 | | None | | |
| KR | 20090100185 | A | 23 September 2009 | KR | 101390400 | B1 | 30 April 2014 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310699370